(19) Europäisches Patentamt
European Patent Office
Office européen des brevets

(11) EP 4 597 224 A1

(12) **EUROPEAN PATENT APPLICATION**
published in accordance with Art. 153(4) EPC

(43) Date of publication:
**06.08.2025 Bulletin 2025/32**

(21) Application number: **23871958.7**

(22) Date of filing: **14.09.2023**

(51) International Patent Classification (IPC):
***G03F 7/004*** (2006.01) ***G03F 7/023*** (2006.01)
***G03F 7/027*** (2006.01) ***G03F 7/037*** (2006.01)
***G03F 7/20*** (2006.01) ***H01L 21/312*** (2006.01)

(52) Cooperative Patent Classification (CPC):
**G03F 7/004; G03F 7/023; G03F 7/027; G03F 7/037; G03F 7/20; H01L 21/31**

(86) International application number:
**PCT/JP2023/033519**

(87) International publication number:
**WO 2024/070725 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.09.2022 JP 2022154556**

(71) Applicant: **Toray Industries, Inc.**
**Tokyo 103-8666 (JP)**

(72) Inventors:
- **TANIGAKI, Yugo**
  **Otsu-shi, Shiga 520-8558 (JP)**
- **ARAKI, Hitoshi**
  **Otsu-shi, Shiga 520-8558 (JP)**
- **KANEKI, Takayuki**
  **Otsu-shi, Shiga 520-8558 (JP)**

(74) Representative: **Kador & Partner Part mbB**
**Corneliusstraße 15**
**80469 München (DE)**

# (54) PHOTOSENSITIVE COMPOSITION, CURED PRODUCT, ELECTRONIC COMPONENT, AND METHOD FOR PRODUCING CURED PRODUCT

(57) The purpose of the present invention is to provide a cured product that can suppress the presence of residues post-development and that, due to an enhanced degree of resin crosslinking and a promotion of ring-closing reactions, exhibits excellent mechanical properties even with heating at low temperatures. Another purpose of the present invention is to provide a cured product that is provided to an electronic component that exhibits an excellent migration resistance. The present invention is a photosensitive composition that satisfies the following condition (α) and contains a binder resin (A) and a photosensitizer (C) and also contains a radically polymerizable compound (B) and/or a crosslinking agent (F), wherein the binder resin (A) contains the following resin (A1) and/or resin (A2).
resin (A1): a resin that contains, in the structural units in the resin main chain, at least one selected from the group consisting of the imide structure, amide structure, oxazole structure, and siloxane structure;
resin (A2): a resin having a phenolic hydroxyl group in the structural units in the resin main chain; and
(α) a content of at least one selected from the group consisting of sulfonic acids, phosphate esters, phosphonic acid, phosphonate esters, phosphite esters, phosphinic acid, hypophosphite esters, and carboxylic acids containing the element fluorine, wherein the total of the content of these organic acids is in a prescribed range.

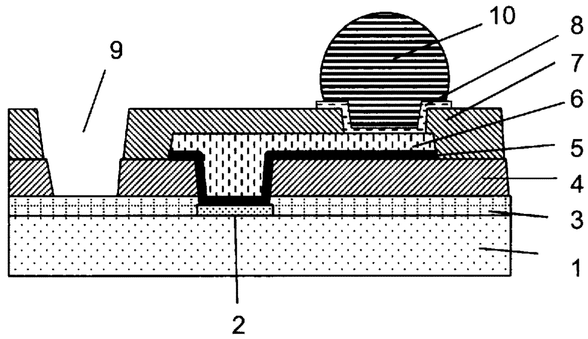


Figure 1



Processed by Luminess, 75001 PARIS (FR)

## Description

TECHNICAL FIELD

The present invention relates to a photosensitive composition, a cured product, an electronic component, and a method for producing a cured product.

BACKGROUND ART

In recent years, electronic terminal devices have become more sophisticated, smaller, thinner, and lighter. These electronic terminal devices include a semiconductor device, and examples thereof include a processor and a memory. Examples of a representative material in a surface protective layer or an interlayer insulation layer of a semiconductor device, an insulation layer of an organic electroluminescence (hereinafter, referred to as "organic EL") display, or a planarization layer of a thin film transistor (hereinafter, referred to as "TFT") substrate include resins such as polyimide, polybenzoxazole, and the like, which are excellent in heat resistance, electrical insulation property, and the like. Furthermore, in order to improve productivity, a photosensitive polyimide/polybenzoxazole material having positive-type or negative-type photosensitivity and a photosensitive polyimide precursor/polybenzoxazole precursor have also been studied.

With expansion of uses and improvement in performance of semiconductors, efforts have been made to reduce costs and increase integration by improving the efficiency of production processes, and semiconductor devices that form multilayer metal rewiring are attracting attention. A material used for an interlayer insulation layer in such multilayer metal rewiring is required to have high mechanical properties for withstanding the stress associated with multilayering. Furthermore, it is also necessary to compatibly achieve suppression of presence of development residues at the time of forming a positive-type or negative-type pattern by photolithography. In addition, due to wiring miniaturization associated with high integration of the semiconductor devices, the reliability related to electrical insulation property is required, and therefore high migration resistance is also required.

In addition, there is a restriction that a memory used in recent years, a mold resin used in preparing a semiconductor package, and the like have low heat resistance, and a high-temperature process cannot be applied. Therefore, a material used for a surface protective layer or an interlayer insulation layer of a semiconductor device is required to be curable even by heating at a low temperature of 250°C or less, more desirably 220°C or less, and to have high mechanical properties.

Examples of the material having improved mechanical properties include a composition in which a flexible polyoxyalkylene structure is introduced into the main chain of polyimide (see, for example, Patent Document 1). Examples of the material that can be cured even by heating at a low temperature include a composition containing a resin such as polyimide, polybenzoxazole, and the like and a thermal cross-linking agent (see, for example, Patent Document 2).

PRIOR ART DOCUMENTS

PATENT DOCUMENTS

Patent Document 1: Japanese Patent Laid-open Publication No. 2012-208360
Patent Document 2: Japanese Patent Laid-open Publication No. 2007-016214

SUMMARY OF THE INVENTION

PROBLEMS TO BE SOLVED BY THE INVENTION

However, the composition described in Patent Document 1 or Patent Document 2 has a problem in providing a cured product having excellent mechanical properties and migration resistance even when heated at a low temperature while suppressing presence of development residues. Therefore, the photosensitive composition has been desired to have further improved properties. An object of the present invention is to provide a cured product included in an electronic component having excellent mechanical properties and excellent migration resistance while suppressing presence of development residues. Another object of the present invention is to provide an electronic component excellent in migration resistance.

SOLUTIONS TO THE PROBLEMS

In order to solve the above-described problems, the photosensitive composition and the electronic component of the present invention include the following configurations [1] to [20] .

[1] A photosensitive composition satisfying the following condition (α) and containing a binder resin (A) and a photosensitizer (C) and further containing a radical polymerizable compound (B) and/or a cross-linking agent (F), wherein
the binder resin (A) contains the following resin (A1) and/or resin (A2):

resin (A1): a resin that contains, in structural units in a resin main chain, one or more selected from the group consisting of an imide structure, an amide structure, an oxazole structure, and a siloxane structure;
resin (A2): a resin having a phenolic hydroxyl group in the structural units in the resin main chain; and
(α) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (1x) is satisfied:
(1x) a total content of the sulfonic acids, the phosphate esters, the phosphonic acids, the phosphonate esters, the phosphite esters, the phosphinic acids, the hypophosphite esters, and the carboxylic acids containing a fluorine element in the total solid content of the photosensitive composition is 0.010 to 1,000 ppm by mass.

[2] The photosensitive composition according to [1], wherein

the sulfonic acids, and the phosphate esters, the phosphonic acids, the phosphonate esters, the phosphite esters, the phosphinic acids, and the hypophosphite esters (hereinafter, referred to as "organic acids containing a phosphorus element") have the following specific substituent a,
the carboxylic acids containing a fluorine element have the following specific substituent b, and
the condition (α) is the following condition (α2), and the following condition (α2) is satisfied:
(α2) one or more selected from the group consisting of the sulfonic acids having the following specific substituent a, the organic acids containing a phosphorus element having the following specific substituent a, and the carboxylic acids containing a fluorine element having the following specific substituent b is/are further contained, and the following condition (1y) is satisfied:

specific substituent a: one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms;
specific substituent b: one or more selected from the group consisting of a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms; and
(1y) a total content of the sulfonic acid having the specific substituent a, the organic acid containing a phosphorus element having the specific substituent a, and the carboxylic acid containing a fluorine element having the specific substituent b in the total solid content of the photosensitive composition is 0.010 to 1,000 ppm by mass.

[3] The photosensitive composition according to [2], wherein

the condition (α2) is the following condition (α3) and the condition (α3) is satisfied,
the sulfonic acid contains one or more selected from the group consisting of methanesulfonic acid, cyclohexanesulfonic acid, benzenesulfonic acid, toluenesulfonic acid, xylenesulfonic acid, trifluoromethanesulfonic acid, hexafluorocyclohexanesulfonic acid, hexafluorobenzenesulfonic acid, pentafluorotoluenesulfonic acid, tetrafluoroxylenesulfonic acid, trifluoromethylbenzenesulfonic acid, trifluoromethyltoluenesulfonic acid, and trifluoromethylxylenesulfonic acid, and
the carboxylic acid containing a fluorine element contains one or more selected from the group consisting of trifluoroacetic acid, trifluoropropionic acid, hexafluorocyclohexanecarboxylic acid, hexafluorobenzoic acid, and trifluoromethylbenzoic acid:
(α3) a sulfonic acid and/or a carboxylic acid containing a fluorine element is/are further contained, and the following condition (1z) is satisfied:

(1z) a total content of the sulfonic acid and the carboxylic acid containing a fluorine element in the total solid content of the photosensitive composition is 0.010 to 1,000 ppm by mass.

[4] The photosensitive composition according to any one of [1] to [3], further satisfying the following condition (β):
(β) one or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (2x) is satisfied:
(2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the total solid content of the photosensitive composition is 0.010 to 1,000 ppm by mass.
[5] The photosensitive composition according to any one of [1] to [4], further satisfying the following condition (γ):
(γ) one or more selected from the group consisting of benzene, toluene, xylene, and naphthalene is/are contained, and the following condition (3) is satisfied:
(3) a total content of the benzene, the toluene, the xylene, and the naphthalene in the photosensitive composition is 0.010 to 1,000 ppm by mass.
[6] The photosensitive composition according to any one of [1] to [5], wherein

the binder resin (A) contains the resin (A1), and
the resin (A1) contains one or more selected from the group consisting of the following resin (A1-1), resin (A1-2), resin (A1-3), resin (A1-4), resin (A1-5), and resin (A1-6), and a copolymer consisting of two or more of the following resin (A1-1), resin (A1-2), resin (A1-3), resin (A1-4), resin (A1-5), and resin (A1-6):

resin (A1-1): polyimide;
resin (A1-2): polyimide precursor;
resin (A1-3): polybenzoxazole;
resin (A1-4): polybenzoxazole precursor;
resin (A1-5): polyamideimide; and
resin (A1-6): polyamideimide precursor.

[7] The photosensitive composition according to any one of [1] to [6], further containing one or more selected from the group consisting of a cyclic amide compound represented by General Formula (20), an amide compound represented by General Formula (21), a cyclic urea compound represented by General Formula (22), a urea compound represented by General Formula (23), an oxazolidone compound represented by General Formula (24), and an isoxazolidone compound represented by General Formula (25), and satisfying the following condition (4):
(4) a total content of the cyclic amide compound represented by General Formula (20), the amide compound represented by General Formula (21), the cyclic urea compound represented by General Formula (22), the urea compound represented by General Formula (23), the oxazolidone compound represented by General Formula (24), and the isoxazolidone compound represented by General Formula (25) in the total solid content of the photosensitive composition is 0.010 to 5.0% by mass.

[Chemical Formula 1]

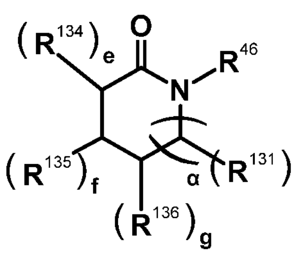
(20)

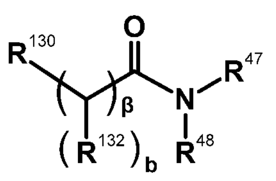
(21)

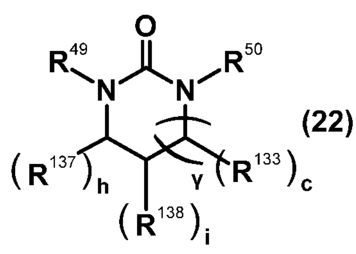
(22)

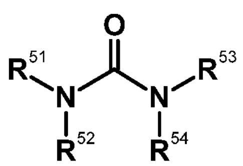
(23)

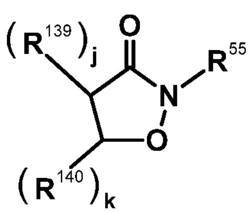
(24)

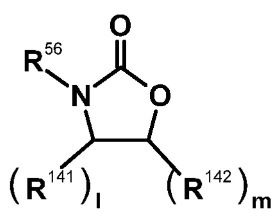
(25)

In General Formulae (20) to (25), $R^{46}$ to $R^{56}$ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms. $R^{130}$ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms. $R^{131}$ to $R^{142}$ each independently represent an alkyl group having 1 to 6 carbon atoms. $\alpha$, $\beta$, and $\gamma$ each independently represent an integer of 0 to 6. a, b, c, e, f, g, h, i, j, k, 1, and m each independently represent an integer of 0 to 2. In a case where $\alpha$ is 0, a is 0. In a case where $\beta$ is 0, b is 0. In a case where $\gamma$ is 0, c is 0.

[8] The photosensitive composition according to any one of [1] to [7], further containing: one or more selected from the group consisting of a component containing a sodium element, a component containing a potassium element, a component containing a magnesium element, a component containing a calcium element, a component containing an iron element, a component containing a copper element, and a component containing a chromium element, and satisfying the following condition (5):

(5) a total content of the sodium element, the potassium element, the magnesium element, the calcium element, the iron element, the copper element, and the chromium element in the total solid content of the photosensitive composition is 0.010 to 500 ppm by mass.

[9] The photosensitive composition according to any one of [1] to [8], wherein the photosensitizer (C) contains a photo-polymerization initiator (C1), and the photo-polymerization initiator (C1) contains an oxime ester-based compound (C1-1) and/or a phosphine oxide-based compound (C1-2).

[10] The photosensitive composition according to any one of [1] to [9], further containing one or more selected from the group consisting of acetic acid, propionic acid, cyclopentanecarboxylic acid, cyclohexanecarboxylic acid, benzoic acid, methylbenzoic acid, and trimethylbenzoic acid and satisfying the following condition (6), and/or

further containing an aldoxime compound and/or a ketoxime compound and satisfying the following condition (7):

(6) a total content of the acetic acid, the propionic acid, the cyclopentanecarboxylic acid, the cyclohexanecarboxylic acid, the benzoic acid, the methylbenzoic acid, and the trimethylbenzoic acid in the total solid content of the photosensitive composition is 0.010 to 500 ppm by mass; and

(7) a total content of the aldoxime compound and the ketoxime compound in the total solid content of the photosensitive composition is 0.010 to 500 ppm by mass.

[11] The photosensitive composition according to any one of [1] to [10], further containing one or more selected from the group consisting of a component containing a chlorine element, a component containing a bromine element, and a component containing a sulfur element and satisfying the following condition (8) and/or condition (9), and/or

further containing water and satisfying the following condition (10):

(8) a total content of the chlorine element and the bromine element in the total solid content of the photosensitive composition is 0.010 to 500 ppm by mass;

(9) a content of the sulfur element in the total solid content of the photosensitive composition is 0.010 to 500 ppm by mass; and

(10) a content of the water in the photosensitive composition is 0.010 to 3.0% by mass.

[12] The photosensitive composition according to any one of [1] to [11], further satisfying the following condition ($1\alpha$):

($1\alpha$) a content of the fluorine element in the total solid content of the photosensitive composition is 1,000 ppm by mass or less.

[13] The photosensitive composition according to any one of [1] to [12], further satisfying at least one of the following conditions ($\delta$), ($\varepsilon$), and ($\zeta$):

($\delta$) the radical polymerizable compound (B) contains the following first polymerizable compound (B1) and second polymerizable compound (B2);

($\varepsilon$) the radical polymerizable compound (B) contains the following third polymerizable compound (B3) and fourth polymerizable compound (B4);

($\zeta$) the radical polymerizable compound (B) contains the following first polymerizable compound (B1) or second polymerizable compound (B2), and further contains the following third polymerizable compound (B3) or fourth polymerizable compound (B4):

first polymerizable compound (B1): a compound having the following structure (I-b1) and further having at least two radical polymerizable groups:

structure (I-b1): a structure including an alicyclic structure and/or a structure including a heteroalicyclic structure;
second polymerizable compound (B2): a compound having the following structure (I-b2) and structure (II-b2) and further having at least two radical polymerizable groups:

structure (I-b2): a structure including an aromatic structure;
structure (II-b2): a structure including an aliphatic structure;
third polymerizable compound (B3): a compound having at least two (meth)acryloyl groups and further having the following structure (I-b3):

structure (I-b3): a structure that has at least two (meth)acryloyl groups linked with a minimum number of atoms of 4 to 10 and includes an aliphatic structure; and
fourth polymerizable compound (B4): a compound having at least two (meth)acryloyl groups and further having the following structure (I-b4):
structure (I-b4): a structure that has at least two (meth)acryloyl groups linked with a minimum number of atoms of 11 to 45 and includes an aliphatic structure.

[14] The photosensitive composition according to any one of claims [1] to [13], further containing inorganic particles (G),
the inorganic particles (G) containing one or more selected from the group consisting of silica particles, alumina particles, titania particles, vanadium oxide particles, chromium oxide particles, ferric oxide particles, cobalt oxide particles, copper oxide particles, zinc oxide particles, zirconium oxide particles, niobium oxide particles, tin oxide particles, and cerium oxide particles.
[15] A photosensitive composition satisfying one or more selected from the group consisting of the following conditions (α), (β), and (γ) and containing a binder resin (A) and a photosensitizer (C) and further containing a radical polymerizable compound (B) and/or a cross-linking agent (F), wherein
the binder resin (A) contains the following resin (A1) and/or resin (A2):

resin (A1): a resin that contains, in structural units in a resin main chain, one or more selected from the group consisting of an imide structure, an amide structure, an oxazole structure, and a siloxane structure;
resin (A2): a resin having a phenolic hydroxyl group in the structural units in the resin main chain;
(α) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (1x) is satisfied:

(1x) a total content of the sulfonic acids, the phosphate esters, the phosphonic acids, the phosphonate esters, the phosphite esters, the phosphinic acids, the hypophosphite esters, and the carboxylic acids containing a fluorine element in the total solid content of the photosensitive composition is 0.010 to 1,000 ppm by mass;
(β) one or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (2x) is satisfied:

(2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the total solid content of the photosensitive composition is 0.010 to 1,000 ppm by mass; and
(γ) one or more selected from the group consisting of benzene, toluene, xylene, and naphthalene is/are contained, and the following condition (3) is satisfied:
(3) a total content of the benzene, the toluene, the xylene, and the naphthalene in the photosensitive composition is 0.010 to 1,000 ppm by mass.

[16] A photosensitive composition film having a photosensitive composition coating and a support on which the photosensitive composition according to any one of [1] to [15] is formed.
[17] A cured product obtained by curing the photosensitive composition according to any one of [1] to [15].
[18] An electronic component including the cured product according to [17].
[19] A method for producing a cured product, comprising:

(1) a step of forming a coating film of the photosensitive composition according to any one of [1] to [15] on a substrate;
(2) a step of irradiating the coating film of the photosensitive composition with a chemical active ray via a photomask;
(3) a step of performing development with a developer so that a pattern of the photosensitive composition is formed;

and
(4) a step of heating the pattern so that a cured pattern of the photosensitive composition is obtained.

[20] An electronic component including a cured product, wherein the cured product contains the following resin (XA1) and/or resin (XA2) and satisfies the following condition (Xα) :

resin (XA1): a resin that contains, in structural units in a resin main chain, one or more selected from the group consisting of an imide structure, an amide structure, an oxazole structure, and a siloxane structure;
resin (XA2): a resin having a phenolic hydroxyl group in the structural units in the resin main chain; and
(Xα) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (X1x) is satisfied:
(X1x) a total content of the sulfonic acids, the phosphate esters, the phosphonic acids, the phosphonate esters, the phosphite esters, the phosphinic acids, the hypophosphite esters, and the carboxylic acids containing a fluorine element in the cured product is 0.010 to 1,000 ppm by mass.

## EFFECTS OF THE INVENTION

The photosensitive composition of the present invention can provide a cured product that can suppress presence of residues post-development and that exhibits, due to an enhanced degree of resin cross-linking and a promotion of ring-closing reactions, excellent mechanical properties even in heating at a low temperature. In addition, the photosensitive composition of the present invention can provide a cured product that is provided to an electronic component that exhibits excellent migration resistance. The electronic component of the present invention can also provide an electronic component excellent in migration resistance.

## BRIEF DESCRIPTION OF THE DRAWING

Fig. 1 is a schematic sectional view illustrating an enlarged section of a pad portion of a semiconductor device having a bump.

## EMBODIMENTS OF THE INVENTION

Hereinafter, reference will be made to a photosensitive composition corresponding to a first aspect of the present invention and a photosensitive composition corresponding to a second aspect of the present invention. When "the photosensitive composition of the present invention" is described, the description relates to the photosensitive compositions corresponding to the first aspect and the second aspect of the present invention. On the other hand, when reference to the photosensitive composition according to a specific aspect is made, there is described "the photosensitive composition corresponding to the first aspect of the present invention" and the like. However, the present invention is not limited to the following embodiments, and obviously, various modifications can be made without departing from the scope of the invention as long as the object of the invention can be achieved. Note that the resin main chain refers to a chain having the longest chain length among the chains constituting the resin including structural units. The resin side chain refers to a chain branched from the main chain or bonded to the main chain and having a chain length shorter than that of the main chain among chains constituting the resin including the structural units. The resin end refers to a structure that seals the main chain, and is, for example, a structure derived from an endcapping agent or the like. In addition, the hydrocarbon group or alkylene group including "*** bond" or "*** group" refers to a hydrocarbon group or alkylene group to which "*** bond" or "*** group" is bonded, or at least two hydrocarbon groups or at least two alkylene groups linked by "*** bond" or "*** group".

### <Photosensitive composition>

The photosensitive composition corresponding to the first aspect of the present invention has the configuration of [1]. The photosensitive composition corresponding to the second aspect of the present invention has the configuration of [15]. Hereinafter, sulfonic acids, phosphate esters, phosphonic acids, phosphonate esters, phosphite esters, phosphinic acids, hypophosphite esters, and carboxylic acids containing a fluorine element will be collectively referred to as "specific organic acids" in some cases. Hereinafter, a chloride ion, a bromide ion, a sulfate ion, a sulfite ion, a nitrate ion, a nitrite ion, a phosphate ion, a phosphite ion, a hypophosphite ion, a formate ion, and a fluoride ion will be collectively referred to as "specific anions" in some cases. Hereinafter, benzene, toluene, xylene, and naphthalene will be collectively referred to as "specific aromatic compounds" in some cases.

With the above configurations, the photosensitive composition of the present invention can provide a cured product that can suppress presence of residues post-development and that exhibits, due to an enhanced degree of resin cross-linking and a promotion of ring-closing reactions, excellent mechanical properties even in heating at a low temperature. In addition, the photosensitive composition of the present invention can provide a cured product that is provided to an electronic component that exhibits excellent migration resistance. It is presumed that, by containing a small amount of the specific aromatic compound, the specific anion, or the specific organic acid in the photosensitive composition, the wiring surface corresponding to the opening is surface-modified by the specific aromatic compound, the specific anion, or the specific organic acid when a pattern of the photosensitive composition is formed on the wiring. Therefore, it is considered that the effect of suppressing presence of residues post-development is achieved by preventing the residue from adhering to the wiring surface.

It is presumed that these resins are in a state of being locally oriented due to a $\pi$-electron interaction between the specific aromatic compound described above and a resin having an aromatic ring such as polyimide, polybenzoxazole, a precursor thereof, and the like, or a coordination bond by a $\pi$-electron with a resin containing a silicon atom having a 3d orbital which is an empty atomic orbital such as polysiloxane. As a result, the cross-linking reaction between resins and the ring-closing reaction of the resins efficiently proceed, and thus it is considered that excellent mechanical properties are achieved even in heating at a low temperature. On the other hand, the specific anion or specific organic acid described above is considered to function as a catalyst that promotes a cross-linking reaction on an aromatic ring, a ring-closing reaction of a resin, or a cross-linking reaction in a resin having a silanol group, such as polysiloxane, in a resin having an aromatic ring, such as polyimide, polybenzoxazole, or a precursor thereof. As a result, since the cross-linking reaction and the ring-closing reaction efficiently proceed, it is considered that excellent mechanical properties are achieved even in heating at a low temperature.

It is considered that the polarization structure and charge balance in the cured product of the photosensitive composition are controlled by intentionally containing a small amount of these specific aromatic compound, specific anion, or specific organic acid. In addition, aromatic rings in a resin such as polyimide, polybenzoxazole, and precursors thereof, and silanol groups in a resin such as polysiloxane are also considered to contribute to control of the polarization structure and charge balance. Accordingly, it is presumed that the effect of excellent migration resistance is achieved by suppressing ion migration and electromigration caused by metal impurities and ion impurities that adversely affect electrical insulation property. It is also presumed that, by suppressing migration and aggregation of the metal in the wiring, the effect of high reliability in the electronic component, the semiconductor device, the display device, and the metal-clad laminate is achieved.

<Binder resin (A)>

The photosensitive composition of the present invention contains a binder resin (A). The binder resin (A) is a resin having heat resistance in which at least a part remains in a cured product obtained by curing the composition. The binder resin (A) is preferably a resin in which a cross-linked structure is formed and cured by a reaction. The reaction is not particularly limited, and is caused, for example, by heating, irradiation with an energy ray, or the like, and the cross-linked structure may be formed by a cross-linking agent (F) described later. The binder resin (A) is preferably a thermosetting resin.

The binder resin (A) is preferably an alkali-soluble resin or an organic solvent-soluble resin. The alkali-soluble resin refers to a resin having an acidic group and solubility in an alkaline developer. The organic solvent-soluble resin refers to a resin having an organic solvent-soluble structure and solubility of an organic solvent in a developer. As the alkali-soluble resin and the organic solvent-soluble resin in the photosensitive composition of the present invention, a resin is preferred which has positive-type or negative-type photosensitivity imparted to the composition by a photosensitizer (C) described later, and has solubility capable of forming a positive-type or negative-type pattern by development with an alkaline developer or an organic solvent. The binder resin (A) more preferably has an acidic group in the structural units of the resin. The acidic group of the binder resin (A) is preferably a phenolic hydroxyl group, a hydroxyimide group, a hydroxyamide group, a silanol group, a 1,1-bis(trifluoromethyl)methylol group, a mercapto group, a carboxy group, a carboxylic anhydride group, or a sulfonic acid group. When the binder resin (A) satisfies a condition (P1a) and/or condition (P2a) described later, or when the photosensitive composition of the present invention satisfies a condition ($1\alpha$) described later, the acidic group of the binder resin (A) is preferably a phenolic hydroxyl group, a hydroxyimide group, a hydroxyamide group, a silanol group, a mercapto group, a carboxy group, a carboxylic anhydride group, or a sulfonic acid group.

The binder resin (A) preferably has a radical polymerizable group, and more preferably has a radical polymerizable group in the structural units of the resin. The radical polymerizable group preferably has an ethylenically unsaturated double bond group, and more preferably has a photoreactive group, an alkenyl group having 2 to 5 carbon atoms, or an alkynyl group having 2 to 5 carbon atoms. The photoreactive group is preferably a styryl group, a cinnamoyl group, a maleimide group, a nadiimide group, or a (meth)acryloyl group, and more preferably a (meth)acryloyl group from the viewpoint of improving the sensitivity for exposure and promoting radical polymerization in heating at a low

temperature. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group from the viewpoint of improving the sensitivity for exposure and promoting radical polymerization in heating at a low temperature.

<Resin (A1), resin (A2), and resin (A3)>

In the photosensitive composition of the present invention, the binder resin (A) contains a resin (A1) and/or resin (A2) described below. In the photosensitive composition of the present invention, the binder resin (A) preferably further contains a resin (A3) described below.

Resin (A1): A resin that contains, in structural units in a resin main chain, one or more selected from the group consisting of an imide structure, an amide structure, an oxazole structure, and a siloxane structure
Resin (A2): A resin having a phenolic hydroxyl group in the structural units in the resin main chain
Resin (A3): A resin having a radical polymerizable group

The resin (A1) is a resin containing one or more selected from the group consisting of an imide structure, an amide structure, an oxazole structure, and a siloxane structure in structural units in the resin main chain, such as polyimide, polybenzoxazole, a precursor thereof, and a copolymer consisting of two or more thereof. The resin (A3) is a resin having a radical polymerizable group such as a (meth)acryloyl group on at least one of a resin main chain, a resin side chain, and a resin end. Examples and preferred descriptions concerning the radical polymerizable group are as described in Binder resin (A) above.

When each of the resin (A1), the resin (A2), and the resin (A3) has a structure or a group constituting another resin among these resins, the resins are classified into any of the following rules. When a certain resin can correspond to two or more of the resin (A1), the resin (A2), and the resin (A3), which resin corresponds to the resin is determined as follows. That is, when a resin containing one or more selected from the group consisting of an imide structure, an amide structure, an oxazole structure, and a siloxane structure (hereinafter, referred to as "imide structure and the like") in the structural units in the resin main chain has a phenolic hydroxyl group in the structural units in the resin main chain, the resin corresponds to the resin (A1). When the resin having structural units including an imide structure or the like has a radical polymerizable group, the resin corresponds to the resin (A1). When the resin having a phenolic hydroxyl group in the structural units in the resin main chain has a radical polymerizable group, the resin corresponds to the resin (A2). When the resin having structural units including an imide structure or the like has a phenolic hydroxyl group in the structural units in the resin main chain and further has a radical polymerizable group, the resin corresponds to the resin (A1).

The photosensitive composition of the present invention preferably contains the resin (A1) from the viewpoint of improving mechanical properties in heating at a low temperature and improving migration resistance, and more preferably contains the resin (A1) and the resin (A2) from the viewpoint of suppressing presence of residues post-development and improving mechanical properties in heating at a low temperature. From the viewpoint of improving the sensitivity for exposure and improving the mechanical properties in heating at a low temperature, the photosensitive composition of the present invention preferably contains the resin (A1) and/or the resin (A2) and further contains the resin (A3). From these viewpoints, the photosensitive composition of the present invention further preferably contains the resin (A1), the resin (A2), and the resin (A3).

<Resin (A1)>

From the viewpoint of improving mechanical properties in heating at a low temperature and improving migration resistance, the resin (A1) preferably contains one or more selected from the group consisting of the resin (A1-1), resin (A1-2), resin (A1-3), resin (A1-4), resin (A1-5), resin (A1-6), resin (A1-7), and resin (A1-8) described below, a maleimide resin, a maleimide-styrene resin, a maleimide-triazine resin, a maleimide-oxazine resin, and a copolymer consisting of two or more thereof, more preferably contains one or more selected from the group consisting of the resin (A1-1), the resin (A1-2), the resin (A1-3), the resin (A1-4), the resin (A1-5), the resin (A1-6), the resin (A1-7), the resin (A1-8), and a copolymer consisting of two or more thereof, and still more preferably contains one or more selected from the group consisting of the resin (A1-1), the resin (A1-2), the resin (A1-3), the resin (A1-4), the resin (A1-5), the resin (A1-6), and the resin (A1-7), and a copolymer consisting of two or more thereof (hereinafter, referred to as "polyimide-based resin"). The resin (A1) may be either a single resin or a copolymer thereof.

Resin (A1-1): Polyimide
Resin (A1-2): Polyimide precursor

Resin (A1-3): Polybenzoxazole
Resin (A1-4): Polybenzoxazole precursor
Resin (A1-5): Polyamideimide
Resin (A1-6): Polyamideimide precursor
Resin (A1-7): Polyamide
Resin (A1-8): Polysiloxane

The resin (A1) as described above has an imide structure, an amide structure, an oxazole structure, or a siloxane structure in the structural units in the resin main chain, thereby obtaining an effect of improving the mechanical properties. In addition, it is presumed that these structures trap metal impurities, ion impurities, and the like that adversely affect electrical insulation property and thus ion migration and electromigration are suppressed to improve the migration resistance.

The binder resin (A) preferably contains the resin (A1), and from the viewpoint of improving the mechanical properties in heating at a low temperature and improving the migration resistance, the resin (A1) preferably contains one or more selected from the group consisting of the resin (A1-1), the resin (A1-2), the resin (A1-3), the resin (A1-4), the resin (A1-5), and the resin (A1-6), and a copolymer consisting of two or more thereof, and more preferably contains one or more selected from the group consisting of the resin (A1-1), the resin (A1-2), the resin (A1-3), and the resin (A1-4), and a copolymer consisting of two or more thereof. From the viewpoint of improving mechanical properties in heating at a low temperature, the resin (A1) still more preferably contains the resin (A1-1) and the resin (A1-3), and a copolymer consisting of two or more thereof. On the other hand, from the viewpoint of improving the sensitivity for exposure, the resin (A1) more preferably contains the resin (A1-2) and the resin (A1-4), and a copolymer consisting of two or more thereof.

The binder resin (A) preferably contains the resin (A1), and the resin (A1) preferably has a radical polymerizable group from the viewpoint of improving the sensitivity for exposure and improving the mechanical properties in heating at a low temperature. Examples and preferred descriptions concerning the radical polymerizable group are as described in Binder resin (A) above.

The resin (A1-1), the resin (A1-2), the resin (A1-3), the resin (A1-4), the resin (A1-5), and the resin (A1-6), and a copolymer consisting of two or more thereof preferably have a radical polymerizable group from the viewpoint of improving the sensitivity for exposure and improving the mechanical properties in heating at a low temperature. Examples and preferred descriptions concerning the radical polymerizable group are as described in Binder resin (A) above.

The radical polymerizable group is preferably one or more selected from the group consisting of General Formulae (51), (52), (53), (54), and (55).

[Chemical Formula 2]

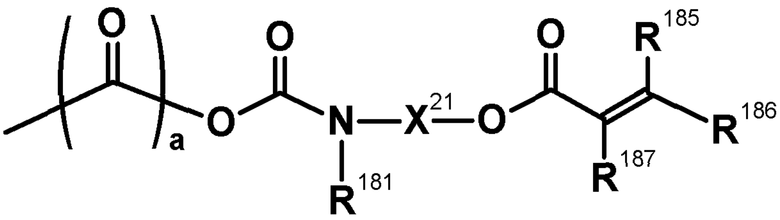

(51)

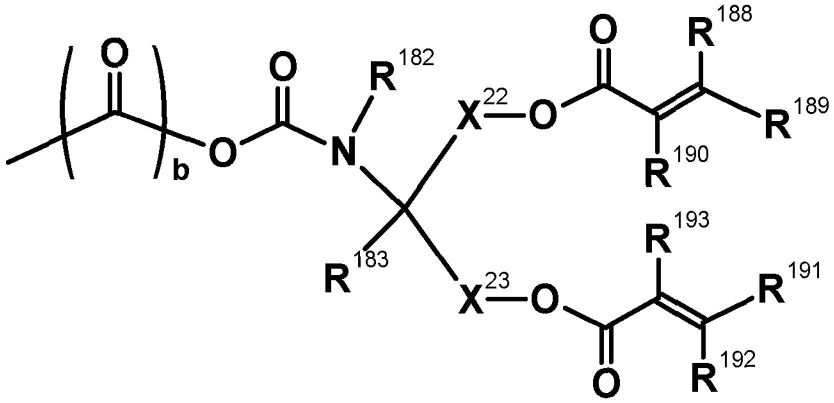

(52)

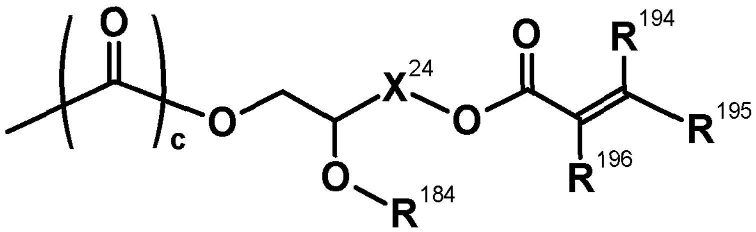

(53)

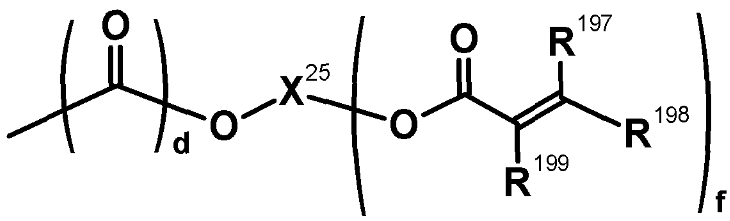

(54)

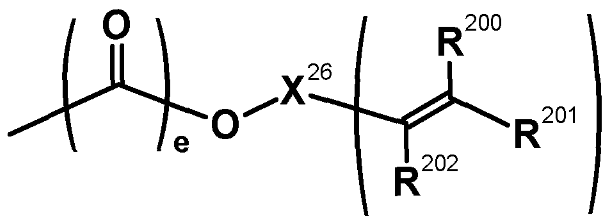

(55)

In General Formulae (51) to (55), $X^{21}$ to $X^{24}$ each independently represent an alkylene group having 1 to 10 carbon atoms, a cycloalkylene group having 4 to 10 carbon atoms, or an arylene group having 6 to 15 carbon atoms. $X^{25}$ represents a 2 to 6 valent organic group. $X^{26}$ represents a direct bond or a 2 to 6 valent organic group. $R^{181}$ to $R^{202}$ each independently represent a hydrogen atom, an alkyl group having 1 to 10 carbon atoms, or an aryl group having 6 to 15 carbon atoms. a, b, c, d, and e each independently represent 0 or 1. f and g each independently represent an integer of 1 to 5.

In General Formulae (51) to (55), $X^{25}$ is preferably a 2 to 6 valent aliphatic group, and more preferably a 2 to 6 valent alkylene group having 1 to 10 carbon atoms. $X^{26}$ is preferably a direct bond or a 2 to 6 valent aliphatic group, and more preferably a 2 to 6 valent alkylene group having 1 to 10 carbon atoms. The alkyl group, aryl group, alkylene group,

cycloalkylene group, and arylene group described above may have a heteroatom, and may be either unsubstituted or substituted.

The radical polymerizable group is preferably obtained by reacting a part of the phenolic hydroxyl group and/or carboxy group of the resin with a compound having a radical polymerizable group. Examples of the compound having a radical polymerizable group include an isocyanate compound, an epoxy compound, an aldehyde compound, a ketone compound, an acetate compound, a carboxylic acid compound, a carboxylic acid derivative, an alkyl halide compound, an alkyl azide compound, a sulfonate alkyl compound, an alkyl cyanide compound, or an alcohol compound. It is also preferable that these compounds have a urea bond or a urethane bond.

Examples of the alcohol compound having a radical polymerizable group include 2-hydroxyethyl (meth)acrylate, 4-hydroxybutyl (meth)acrylate, 4-hydroxyhexyl (meth)acrylate, glycerol di(meth)acrylate, trimethylolpropane di(meth) acrylate, ditrimethylolpropane tri(meth)acrylate, pentaerythritol tri(meth)acrylate, dipentaerythritol penta(meth)acrylate, and trispentaerythritol hepta(meth)acrylate.

The binder resin (A) preferably contains the resin (A1), and the resin (A1) preferably contains the resin (A1) having no radical polymerizable group and the resin (A1) having a radical polymerizable group from the viewpoint of improving the sensitivity for exposure, suppressing presence of residues post-development, improving the mechanical properties in heating at a low temperature, and improving the migration resistance.

With the above configuration, it is considered that the resin (A1) having no radical polymerizable group exhibits suppression of presence of residues post-development by an acidic group or an organic solvent-soluble structure, the ability to trap metal impurities and ion impurities, and the like, and the resin (A1) having a radical polymerizable group exhibits improvement in sensitivity for exposure, promotion of radical polymerization in heating at a low temperature, and the like. It is presumed that the effect of improving a plurality of characteristics becomes remarkable by such function separation in the resin (A1).

The acid equivalent of the resin (A1) is preferably 200 g/mol or more, more preferably 250 g/mol or more, and still more preferably 300 g/mol or more, from the viewpoint of improving the sensitivity for exposure. On the other hand, the acid equivalent of the resin (A1) is preferably 600 g/mol or less, more preferably 500 g/mol or less, and still more preferably 450 g/mol or more, from the viewpoint of suppressing presence of residues post-development. The exposure herein refers to irradiation with chemical active rays (radiant rays), and examples thereof include irradiation with visible light, ultraviolet rays, electron beams, X-rays or the like. Hereinafter, exposure refers to irradiation with chemical active rays (radiant rays).

From the viewpoint of suppressing presence of residues post-development, the double bond equivalent of the resin (A1) is preferably 200 g/mol or more, more preferably 400 g/mol or more, still more preferably 500 g/mol or more, even more preferably 700 g/mol or more, and particularly preferably 1,000 g/mol or more. On the other hand, from the viewpoint of improving the sensitivity for exposure, the double bond equivalent of the resin (A1) is preferably 3,000 g/mol or less, more preferably 2,000 g/mol or less, and still more preferably 1,500 g/mol or less.

<Resin (A1); polyimide-based resin>

As the polyimide precursor, for example, polyamic acid, polyamic acid ester, polyamic acid amide, or polyisoimide can be cited. Examples of the polyimide include a resin obtained by dehydrating and cyclizing a polyimide precursor by heating or a reaction using a catalyst. The polyimide preferably has a structural unit represented by General Formula (1). The polyimide precursor preferably has a structural unit represented by General Formula (2).

[Chemical Formula 3]

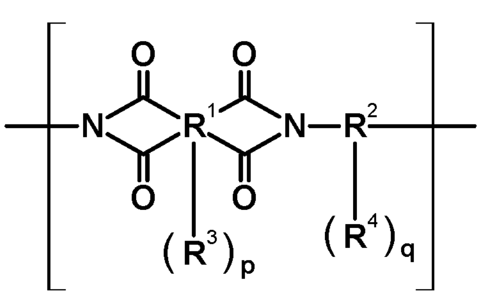 (1) 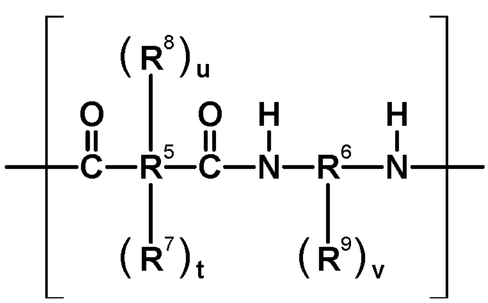 (2)

In General Formulae (1) and (2), $R^1$ and $R^5$ each independently represent a 4 to 10 valent organic group. $R^2$ and $R^6$ each independently represent a 2 to 10 valent organic group. $R^3$, $R^4$, and $R^9$ each independently represent a phenolic hydroxyl group, a sulfonic acid group, a mercapto group, or a substituent represented by General Formula (7) or (8). $R^7$ represents a substituent represented by General Formula (7) or (8). $R^8$ represents a phenolic hydroxyl group, a sulfonic

acid group, or a mercapto group. p represents an integer of 0 to 6. q represents an integer of 0 to 8. t represents an integer of 2 to 8, u represents an integer of 0 to 6, and $2 \leq t + u \leq 8$ is satisfied. v represents an integer of 0 to 8. However, when $R^3$ or $R^4$ represents a phenolic hydroxyl group, $R^1$ or $R^2$ bonded to the phenolic hydroxyl group contains an aromatic structure in its structure. When $R^8$ or $R^9$ represents a phenolic hydroxyl group, $R^5$ or $R^6$ bonded to the phenolic hydroxyl group contains an aromatic structure in its structure.

In General Formulae (1) and (2), it is preferable that $R^1$, $R^5$, $R^2$, and $R^6$ each independently have an aliphatic structure having 2 to 20 carbon atoms, an alicyclic structure having 4 to 20 carbon atoms, or an aromatic structure having 6 to 30 carbon atoms. q is preferably an integer of 1 to 8. v is preferably an integer of 1 to 8. $R^1$ and $R^5$ each independently represent a carboxylic acid residue. $R^2$ and $R^6$ each independently represent an amine residue. The above-described aliphatic structure, alicyclic structure, and aromatic structure may have a heteroatom, and may be either unsubstituted or substituted.

[Chemical Formula 4]

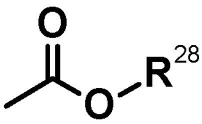
(7)
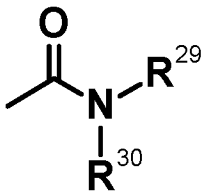
(8)

In General Formulae (7) and (8), $R^{28}$ to $R^{30}$ each independently represent a hydrogen atom, an alkyl group having 1 to 10 carbon atoms, an acyl group having 2 to 6 carbon atoms, or an aryl group having 6 to 15 carbon atoms. In General Formulae (7) and (8), $R^{28}$ to $R^{30}$ each independently preferably represent a hydrogen atom, an alkyl group having 1 to 6 carbon atoms, an acyl group having 2 to 4 carbon atoms, or an aryl group having 6 to 10 carbon atoms. The above-described alkyl group, acyl group, and aryl group may have a heteroatom, and may be either unsubstituted or substituted.

As the polyimide precursor, in a case where $R^7$ in the structural unit represented by General Formula (2) represents a substituent represented by General Formula (7), the structural unit where $R^{28}$ represents hydrogen atom is referred to as an amide acid structural unit. In a case where $R^7$ in the structural unit represented by General Formula (2) represents a substituent represented by General Formula (7), the structural unit where $R^{28}$ represents an alkyl group having 1 to 10 carbon atoms, an acyl group having 2 to 6 carbon atoms, or an aryl group having 6 to 15 carbon atoms is referred to as an amide acid ester structural unit. In a case where $R^7$ in the structural unit represented by General Formula (2) represents a substituent represented by General Formula (8), the structural unit is referred to as an amide acid amide structural unit. The polyimide precursor preferably has an amide acid ester structural unit and/or an amide acid amide structural unit from the viewpoint of improving mechanical properties in heating at a low temperature. The polyimide precursor may have an amide acid structural unit, an amide acid ester structural unit, or an imide ring-closed structural unit in which a part of the amide acid amide structural unit is imide ring-closed.

Examples of the polybenzoxazole precursor include polyhydroxyamide. Examples of the polybenzoxazole include a resin obtained by dehydrating and cyclizing a polybenzoxazole precursor by heating or a reaction using a catalyst. The polybenzoxazole preferably has a structural unit represented by General Formula (3). The polybenzoxazole precursor preferably has a structural unit represented by General Formula (4).

[Chemical Formula 5]

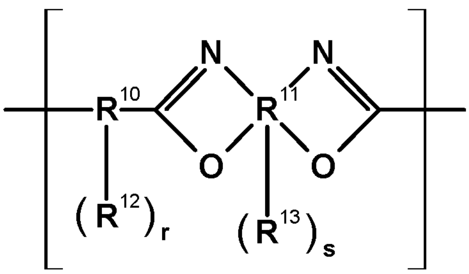
(3)
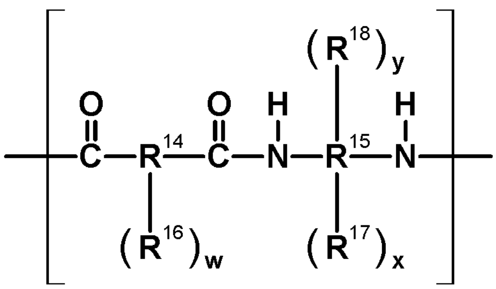
(4)

In General Formulae (3) and (4), $R^{10}$ and $R^{14}$ each independently represent a 2 to 10 valent organic group. $R^{11}$ and $R^{15}$ each independently represent a 4 to 10 valent organic group having an aromatic structure. $R^{12}$, $R^{13}$, and $R^{16}$ each independently represent a phenolic hydroxyl group, a sulfonic acid group, a mercapto group, or a substituent represented

by General Formula (7) or General Formula (8) described above. $R^{17}$ represents a phenolic hydroxyl group. $R^{18}$ represents a sulfonic acid group, a mercapto group, or a substituent represented by General Formula (7) or General Formula (8) described above. r represents an integer of 0 to 8. s represents an integer of 0 to 6. w represents an integer of 0 to 8. x represents an integer of 2 to 8, y represents an integer of 0 to 6, and $2 \leq x + y \leq 8$ is satisfied. However, when $R^{12}$ or $R^{13}$ represents a phenolic hydroxyl group, $R^{10}$ or $R^{11}$ bonded to the phenolic hydroxyl group contains an aromatic structure in its structure. When $R^{16}$ represents a phenolic hydroxyl group, $R^{14}$ bonded to the phenolic hydroxyl group contains an aromatic structure in its structure. In addition, $R^{15}$ bonded to $R^{17}$ contains an aromatic structure in its structure.

In General Formulae (3) and (4), it is preferable that $R^{10}$, $R^{14}$, $R^{11}$, and $R^{15}$ each independently have an aliphatic structure having 2 to 20 carbon atoms, an alicyclic structure having 4 to 20 carbon atoms, or an aromatic structure having 6 to 30 carbon atoms. s is preferably an integer of 1 to 6. $R^{10}$ and $R^{14}$ each independently represent a carboxylic acid residue. $R^{11}$ and $R^{15}$ each independently represent an amine residue. The above-described aliphatic structure, alicyclic structure, and aromatic structure may have a heteroatom, and may be either unsubstituted or substituted.

Examples of the polyamideimide precursor include a resin obtained by reacting a tricarboxylic anhydride with a diamine or the like. Examples of the polyamideimide include a resin obtained by dehydrating and cyclizing a polyamideimide precursor by heating or a reaction using a catalyst. The polyamideimide preferably has a structural unit represented by General Formula (5). The polyamideimide precursor preferably has a structural unit represented by General Formula (6).

[Chemical Formula 6]

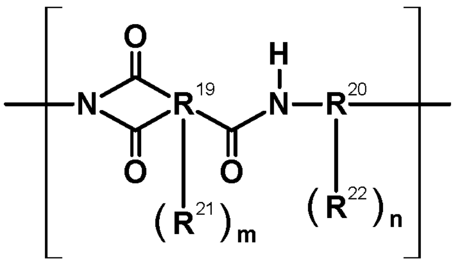
(5)

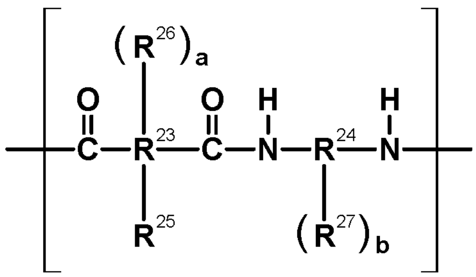
(6)

In General Formulae (5) and (6), $R^{19}$ and $R^{23}$ each independently represent a 3 to 10 valent organic group. $R^{20}$ and $R^{24}$ each independently represent a 2 to 10 valent organic group. $R^{21}$, $R^{22}$, and $R^{27}$ each independently represent a phenolic hydroxyl group, a sulfonic acid group, a mercapto group, or a substituent represented by General Formula (7) or General Formula (8) described above. $R^{25}$ represents a substituent represented by General Formula (7) or General Formula (8). $R^{26}$ represents a phenolic hydroxyl group, a sulfonic acid group, or a mercapto group. m represents an integer 0 to 7. n represents an integer of 0 to 8. a represents an integer of 0 to 7. b represents an integer of 0 to 8. However, when $R^{21}$ or $R^{22}$ represents a phenolic hydroxyl group, $R^{19}$ or $R^{20}$ bonded to the phenolic hydroxyl group contains an aromatic structure in its structure. When $R^{26}$ or $R^{27}$ represents a phenolic hydroxyl group, $R^{23}$ or $R^{24}$ bonded to the phenolic hydroxyl group contains an aromatic structure in its structure.

In General Formulae (5) and (6), it is preferable that $R^{19}$, $R^{23}$, $R^{20}$, and $R^{24}$ each independently have an aliphatic structure having 2 to 20 carbon atoms, an alicyclic structure having 4 to 20 carbon atoms, or an aromatic structure having 6 to 30 carbon atoms. n is preferably an integer of 1 to 8. b is preferably an integer of 1 to 8. $R^{19}$ and $R^{23}$ each independently represent a carboxylic acid residue. $R^{20}$ and $R^{24}$ each independently represent an amine residue. The above-described aliphatic structure, alicyclic structure, and aromatic structure may have a heteroatom, and may be either unsubstituted or substituted.

Examples of the polyamide include a resin obtained by reacting a dicarboxylic acid, a corresponding dicarboxylic acid active diester, or the like with a diamine, a diisocyanate compound, or the like. Note that the polyimide, the polyimide precursor, the polybenzoxazole, the polybenzoxazole precursor, the polyamideimide, and the polyamideimide precursor may be a copolymer with a polyamide.

The polyimide-based resin preferably has a carboxylic acid residue having a fluorine atom and/or an amine residue having a fluorine atom from the viewpoint of improving the sensitivity for exposure. The total content ratio of the carboxylic acid residues having a fluorine atom and the amine residues having a fluorine atom to all the carboxylic acid residues and all the amine residues in each resin is preferably 10 to 100 mol%, more preferably 30 to 100 mol%, and still more preferably 50 to 100 mol%. The total content ratio of the amine residues having a fluorine atom to all the amine residues in each resin is preferably 10 to 100 mol%, more preferably 30 to 100 mol%, and still more preferably 50 to 100 mol%. The total content ratio of the carboxylic acid residues having a fluorine atom to all the carboxylic acid residues in each resin is preferably 10 to 100 mol%, more preferably 30 to 100 mol%, and still more preferably 50 to 100 mol%.

From the viewpoint of improving storage stability, the polyimide-based resin preferably has a structure sealed

with a monoamine, a dicarboxylic acid anhydride, or a monocarboxylic acid derivative at the resin end. From the viewpoint of improving the sensitivity for exposure and improving the mechanical properties in heating at a low temperature, the polyimide-based resin preferably has, at the resin end, a cross-linking group or a radical polymerizable group capable of reacting with the resin or the like, and more preferably has a maleimide group or a nadiimide group. The maleimide group and the nadiimide group at the resin end are preferably amine residues and/or carboxylic acid residues. Examples of such an acid monomer include maleic anhydride and nadic anhydride.

<Content of fluorine element in structure of binder resin (A)>

The binder resin (A) also preferably satisfies a condition (P1a) described below from the viewpoint of suppressing presence of residues post-development and improving migration resistance. The binder resin (A) more preferably further satisfies a condition (P2a) described below. Similarly, when the binder resin (A) is a polyimide-based resin, from the viewpoint of suppressing presence of residues post-development and improving migration resistance, the binder resin (A) preferably satisfies the following condition (P1a), and more preferably further satisfies the following condition (P2a).
(P1a) A content of the fluorine element in the structure of the binder resin (A) is 10,000 ppm by mass or less.
(P2a) A content of the fluoride ion in the structure of the binder resin (A) is 10,000 ppm by mass or less.
From the viewpoint of the effects of the invention described above, the content of the fluorine element in the structure of the binder resin (A) is preferably 0 ppm by mass or more, more preferably 0.010 ppm by mass or more, still more preferably 0.030 ppm by mass or more, even more preferably 0.050 ppm by mass or more, particularly preferably 0.070 ppm by mass or more, and most preferably 0.10 ppm by mass or more. On the other hand, from the viewpoint of the effects of the invention described above, the content of the fluorine element is preferably 10,000 ppm by mass or less, more preferably 5,000 ppm by mass or less, still more preferably 1,000 ppm by mass or less, even more preferably 500 ppm by mass or less, particularly preferably 300 ppm by mass or less, and most preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.
The preferred ranges of the content of the fluoride ion in the structure of the binder resin (A) is also the same as the preferred ranges of the content of the fluorine element in the structure of the binder resin (A) described above.
The content of the fluorine element in the structure of the binder resin (A) may be 0 ppm by mass. The content of the fluoride ion in the structure of the binder resin (A) may also be 0 ppm by mass.
By containing the binder resin (A) in which the content of the fluorine element is the specific value or less in the photosensitive composition, the content of the fluorine element and fluoride ions in these resins or the anion containing the fluorine element derived from these resins becomes the specific value or less, and therefore it is presumed that protons in the photosensitive composition are locally activated by an interaction such as hydrogen bonding or the like of each component in the photosensitive composition. Therefore, it is considered that the effect of suppressing presence of residues post-development becomes remarkable by the dissolution promoting action on the developer. It is considered that by intentionally setting the contents of the above-described components in the resin to a specific value or less, the contents of the above-described components in the cured product of the photosensitive composition are also reduced, and the polarization structure and charge balance in the cured product are controlled. As a result, ion migration and electromigration caused by metal impurities and ion impurities that adversely affect electrical insulation property is suppressed, and thus the migration resistance is presumed to be improved.

<Resin (A1); other resins>

Examples of the polysiloxane include a resin obtained by hydrolysis and dehydration condensation of one or more selected from the group consisting of trifunctional organosilane, a tetrafunctional organosilane, a bifunctional organosilane, and a monofunctional organosilane. The polysiloxane preferably has the trifunctional organosilane unit represented by General Formula (9) and/or the tetrafunctional organosilane unit represented by General Formula (10).

[Chemical Formula 7]

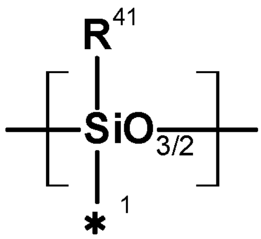 (9) 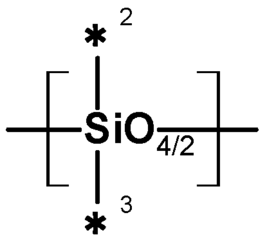 (10)

In General Formula (9) and General Formula (10), $R^{41}$ represents a hydrogen atom or a monovalent organic group. $*^1$ to $*^3$ each independently represent a bonding point in the resin. $R^{41}$ is preferably a hydrogen atom, an alkyl group having 1 to 10 carbon atoms, a cycloalkyl group having 4 to 10 carbon atoms, an aryl group having 6 to 15 carbon atoms, a halogenated alkyl group having 1 to 10 carbon atoms, a halogenated cycloalkyl group having 4 to 10 carbon atoms, or a halogenated aryl group having 6 to 15 carbon atoms. The alkyl group, cycloalkyl group, aryl group, halogenated alkyl group, halogenated cycloalkyl group, and halogenated aryl group described above may have a heteroatom, and may be either unsubstituted or substituted.

The maleimide resin is a resin having at least two maleimide groups on at least one of the resin main chain, the resin side chain, and the resin end. Note that the maleimide resin is a resin different from the polyimide-based resin.

Examples of the maleimide-styrene resin include a resin obtained by further radically copolymerizing a styrene derivative with the maleimide resin described above. Examples thereof also include a resin obtained by radically copolymerizing a maleimide compound and a styrene derivative with other copolymerization components such as a (meth)acrylic acid derivative.

Examples of the maleimide-triazine resin include a resin obtained by further reacting the maleimide resin described above with a compound having a triazine structure and/or an aromatic cyanate ester compound. Examples thereof also include a resin obtained by reacting a maleimide compound with a compound having a triazine structure and/or an aromatic cyanate ester compound.

Examples of the maleimide-oxazine resin include a resin obtained by further reacting the maleimide resin described above with a compound having a benzoxazine structure. Examples thereof also include a resin obtained by reacting a maleimide compound with a compound having a benzoxazine structure.

<Resin (A2)>

The binder resin (A) preferably contains the resin (A2), and
the resin (A2) preferably contains one or more selected from the group consisting of a phenol resin, polyhydroxystyrene, a phenol group-containing epoxy resin, and a phenol group-containing acrylic resin. The resin (A2) may be a single resin or a copolymer thereof.

Examples of the phenol resin include a resin obtained by reacting a phenol compound or the like with one or more selected from the group consisting of an aldehyde compound, a ketone compound, an alkoxymethyl compound, and a methylol compound. The phenol resin preferably contains a novolac resin, a resol resin, or a phenol aralkyl resin.

The phenol resin preferably contains one or more structural units selected from the group consisting of General Formulae (31), (32), (33), (34), (35), (38), (39) and (40).

[Chemical Formula 8]

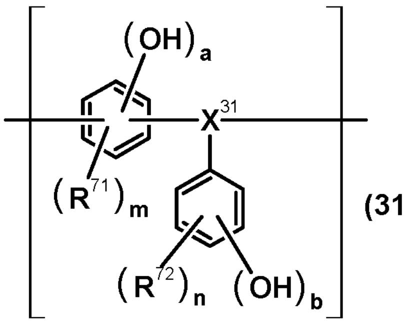
(31)

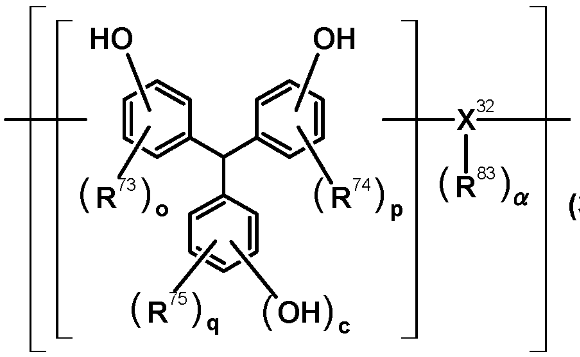
(32)

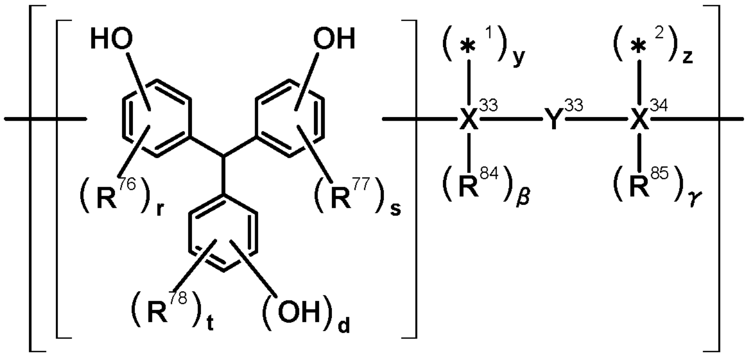
(33)

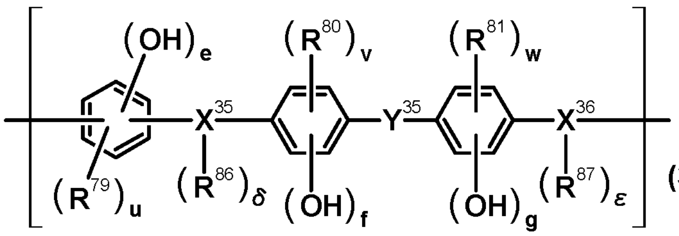
(34)

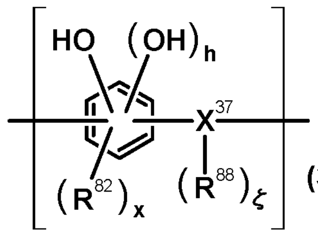
(35)

In General Formulae (31) to (35), $X^{31}$ to $X^{37}$ each independently represent an aliphatic structure having 1 to 2 carbon atoms. $Y^{33}$ represents an alkylene group having 1 to 10 carbon atoms. $Y^{35}$ represents a direct bond, an alkylene group having 1 to 6 carbon atoms, an alkylidene group having 1 to 6 carbon atoms, a halogenated alkylene group having 1 to 6 carbon atoms, a halogenated alkylidene group having 1 to 6 carbon atoms, an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. $R^{71}$ to $R^{82}$ each independently represent a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. $R^{83}$ to $R^{88}$ each independently represent an alkyl group having 1 to 10 carbon atoms, a cycloalkyl group having 4 to 10 carbon atoms, an aryl group having 6 to 15 carbon atoms, or a hydroxy group. a represents an integer of 1 to 4. b represents an integer of 1 to 5. m represents an integer 0 to 3. n represents an integer of 0 to 4. c represents an integer of 1 to 4. o and p each independently represent an integer of 0 to 3. q represents an integer of 0 to 4. d represents an integer of 1 to 4. r and s each independently represent an integer of 0 to 3. t represents an integer of 0 to 4. e represents an integer of 1 to 4. f, g, v, and w each independently represent an integer of 0 to 4. u represents an integer of 0 to 3. h represents an integer of 1 to 3. x represents an integer of 0 to 2. y and z each independently represent 0 or 1. $\alpha$, $\beta$, $\gamma$, $\delta$, $\varepsilon$, and $\zeta$ each independently represent an integer of 0 to 4. $*^1$ and $*^2$ each independently represent a bonding point in the resin.

[Chemical Formula 9]

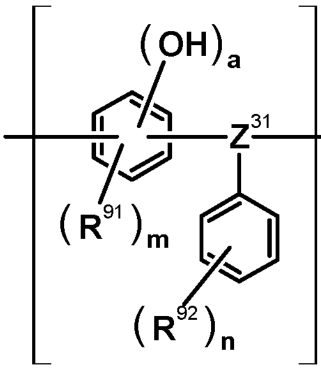

(38)

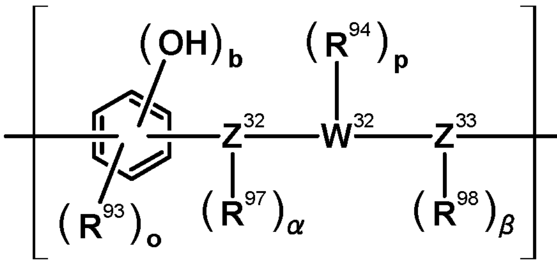

(39)

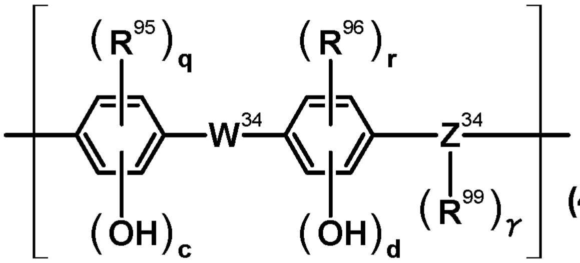

(40)

In General Formulae (38) to (40), $Z^{31}$ to $Z^{34}$ each independently represent an aliphatic structure having 1 to 2 carbon atoms. $W^{32}$ represents an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. $W^{34}$ represents a direct bond, an alkylene group having 1 to 6 carbon atoms, an alkylidene group having 1 to 6 carbon atoms, a halogenated alkylene group having 1 to 6 carbon atoms, a halogenated alkylidene group having 1 to 6 carbon atoms, an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. $R^{91}$ to $R^{96}$ each independently represent a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. $R^{97}$ to $R^{99}$ each independently represent an alkyl group having 1 to 10 carbon atoms, a cycloalkyl group having 4 to 10 carbon atoms, an aryl group having 6 to 15 carbon atoms, or a hydroxy group. a represents an integer of 1 to 4. m represents an integer 0 to 3. n represents an integer of 0 to 5. b represents an integer of 1 to 4. o represents an integer 0 to 3. p represents an integer of 0 to 10. However, when the valence of $W^{32}$ is X, $0 \leq p \leq (X - 2)$ is satisfied. c and d each independently represent an integer of 1 to 4. q and r each independently represent an integer of 0 to 3. $\alpha$, $\beta$, and $\gamma$ each independently represent an integer of 0 to 4.

The phenol resin may preferably have a structural unit represented by General Formula (36).

[Chemical Formula 10]

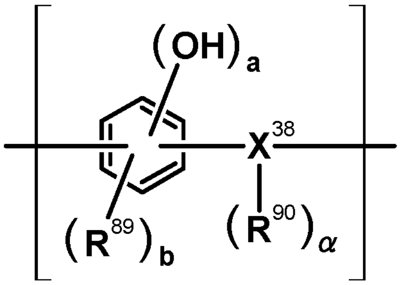

(36)

In General Formula (36), $X^{38}$ represents an aliphatic structure having 1 to 6 carbon atoms. $R^{89}$ represents a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring

linked by a group forming the ring represents a monocyclic or condensed polycyclic hydrocarbon ring. $R^{90}$ represents an alkyl group having 1 to 10 carbon atoms, a cycloalkyl group having 4 to 10 carbon atoms, or an aryl group having 6 to 15 carbon atoms. a represents an integer of 1 to 4. b represents an integer of 0 to 3. $\alpha$ represents an integer of 0 to 4.

In General Formulae (31) to (36) and (38) to (40), the aliphatic structure, the alkyl group, the cycloalkyl group, the aryl group, the alkenyl group, the alkoxy group, the alkenyloxy group, the acyl group, the ring-forming group, the alkylene group, the alkylidene group, the aromatic group, the condensed polycyclic structure, the condensed polycyclic heterocyclic structure, the aromatic ring skeleton, and the alicyclic skeleton described above may have a heteroatom, and may be either unsubstituted or substituted. The condensed polycyclic hydrocarbon ring formed by the ring-forming group is preferably a naphthalene ring, an anthracene ring, a pyrene ring, an indane ring, an indene ring, a tetrahydronaphthalene ring, a fluorene ring, a xanthene ring, or an isoindolinone ring.

Examples of the polyhydroxystyrene include a resin obtained by radically copolymerizing a hydroxystyrene derivative or the like with a styrene derivative and/or other copolymerization components. Examples of other copolymerization components include (meth)acrylic acid derivatives and (meth)acrylic acid ester derivatives.

Examples of the phenol group-containing epoxy resin include a resin obtained by reacting a polyfunctional epoxy compound or the like with a phenol compound having an epoxy-reactive group. The phenol group-containing epoxy resin preferably has a fluorene structure, a xanthene structure, an isoindolinone structure, a naphthalene structure, a tricyclo $[5.2.1.0^{2,6}]$ decane structure, or a biphenyl structure.

Examples of the phenol group-containing acrylic resin include resins obtained by the following (a) to (e).

(a) A resin obtained by further reacting a phenol compound having an addition reactive group with an acrylic resin described later

(b) A resin obtained by further reacting a polyfunctional carboxylic dianhydride or a polyfunctional carboxylic acid compound with the resin obtained by (a) above

(c) A resin obtained by radically copolymerizing a copolymerization component having a phenolic hydroxyl group with other copolymerization components such as a (meth)acrylic acid derivative

(d) A resin obtained by further reacting a phenol compound having an addition reactive group with the resin obtained by (c) above

(e) A resin obtained by further reacting a polyfunctional carboxylic dianhydride or a polyfunctional carboxylic acid compound with the resin obtained by (d) above

Note that the phenol group-containing acrylic resin is a resin different from polyhydroxystyrene. The phenol group-containing acrylic resin preferably has a unit derived from a (meth)acrylic acid ester derivative having a condensed polycyclic structure, a condensed polycyclic heterocyclic structure, or an aromatic structure, or a unit derived from a styrene derivative.

<Resin (A3)>

The binder resin (A) preferably further contains the resin (A3), and

the resin (A3) preferably contains one or more selected from the group consisting of a polycyclic side chain-containing resin, an acid-modified epoxy resin, and an acrylic resin. The resin (A3) may be either a single resin or a copolymer thereof.

Examples of the polycyclic side chain-containing resin include a resin obtained by reacting a polyfunctional carboxylic dianhydride with a compound obtained by reacting a polyfunctional epoxy compound and a carboxylic acid compound having a radical polymerizable group. Examples thereof also include a resin obtained by reacting an epoxy compound having a radical polymerizable group with a compound obtained by reacting a polyfunctional phenol compound and a polyfunctional carboxylic dianhydride. The polycyclic side chain-containing resin is preferably a cardo-based resin having a fluorene structure, a xanthene structure, or an isoindolinone structure.

Examples of the acid-modified epoxy resin include a resin obtained by reacting a polyfunctional carboxylic dianhydride with a compound obtained by reacting a polyfunctional epoxy compound and a carboxylic acid compound having a radical polymerizable group. The acid-modified epoxy resin is preferably an epoxy (meth)acrylate resin having a naphthalene structure, a tricyclo $[5.2.1.0^{2,6}]$ decane structure, or a biphenyl structure.

Examples of the acrylic resin include resins obtained by radical copolymerization of one or more selected from the group consisting of (meth)acrylic acid derivatives, (meth)acrylic acid ester derivatives, styrene derivatives, and other copolymerization components.

From the viewpoint of improving the mechanical properties in heating at a low temperature and improving the migration resistance, the total content ratio of the resins (A1) to the total 100% by mass of the binder resin (A) is preferably 10% by mass or more, more preferably 30% by mass or more, still more preferably 50% by mass or more, and particularly preferably 70% by mass or more. On the other hand, from the viewpoint of improving the mechanical properties in heating at a low temperature, the total content ratio of the resins (A1) is preferably 100% by mass or less, more preferably 90% by

mass or less, and still more preferably 80% by mass or less.

From the viewpoint of suppressing presence of residues post-development and improving the mechanical properties in heating at a low temperature, the total content ratio of the resins (A2) to the total 100% by mass of the binder resin (A) is preferably 5.0% by mass or more, more preferably 10% by mass or more, still more preferably 20% by mass or more, and particularly preferably 30% by mass or more. On the other hand, from the viewpoint of improving the mechanical properties in heating at a low temperature, the total content ratio of the resins (A2) is preferably 70% by mass or less, more preferably 60% by mass or less, and still more preferably 50% by mass or less.

From the viewpoint of improving the sensitivity for exposure and improving the mechanical properties in heating at a low temperature, the total content ratio of the resins (A3) to the total 100% by mass of the binder resin (A) is preferably 5.0% by mass or more, more preferably 10% by mass or more, still more preferably 20% by mass or more, and particularly preferably 30% by mass or more. On the other hand, from the viewpoint of improving the mechanical properties in heating at a low temperature, the total content ratio of the resins (A3) is preferably 70% by mass or less, more preferably 60% by mass or less, and still more preferably 50% by mass or less.

From the viewpoint of improving the mechanical properties in heating at a low temperature and improving the migration resistance, the content ratio of the binder resin (A) to the total solid content of the photosensitive composition of the present invention is preferably 10% by mass or more, more preferably 20% by mass or more, and still more preferably 25% by mass or more. On the other hand, from the viewpoint of improving the mechanical properties in heating at a low temperature, the content ratio of the binder resin (A) is preferably 75% by mass or less, more preferably 65% by mass or less, and still more preferably 55% by mass or less. Note that the total solid content of the composition refers to the total mass of all components except the solvent in the composition. In addition, the solid content concentration can be calculated as a solid content concentration calculated from the mass before and after heating by heating 1 g of the composition at 150°C for 30 minutes to evaporate to dryness and measuring the mass remaining after heating.

<Radical polymerizable compound (B)>

The photosensitive composition of the present invention contains a radical polymerizable compound (B) (hereinafter, referred to as "compound (B)") and/or a cross-linking agent (F). The compound (B) refers to a compound having a radical polymerizable group, and a compound having at least two radical polymerizable groups is preferable. Examples and preferred descriptions concerning the radical polymerizable group are as described in Binder resin (A) above.

It is preferable that the photosensitive composition of the present invention contains a photosensitizer (C) described later and further contains the compound (B) and/or the cross-linking agent (F). From the viewpoint of promoting photoreaction, it is more preferable that the photosensitive composition contains a photo-polymerization initiator (C1) described later and further contains the compound (B). When the composition has negative-type photosensitivity, the effect of improving the sensitivity for exposure becomes remarkable by containing the compound (B). On the other hand, when the composition has positive-type photosensitivity, the effect of pattern shape control after thermal curing becomes remarkable by containing the compound (B).

The radical polymerizable group in the compound (B) preferably has an ethylenically unsaturated double bond group, and more preferably has a (meth)acryloyl group from the viewpoint of improving the sensitivity for exposure and promoting radical polymerization in heating at a low temperature. The number of radical polymerizable groups in the compound (B) is preferably 2 or more, more preferably 3 or more, and still more preferably 4 or more, from the viewpoint of improving the sensitivity for exposure and improving the mechanical properties in heating at a low temperature. On the other hand, from the viewpoint of improving the mechanical properties in heating at a low temperature and improving migration resistance, the number of radical polymerizable groups is preferably 12 or less, more preferably 10 or less, still more preferably 8 or less, and particularly preferably 6 or less.

When the photosensitive composition of the present invention contains the binder resin (A) and the compound (B), the content of the binder resin (A) is, in a case where the total of the binder resin (A) and the compound (B) is 100 parts by mass, preferably 25 parts by mass or more, more preferably 35 parts by mass or more, and still more preferably 45 parts by mass or more from the viewpoint of improving the mechanical properties in heating at a low temperature and improving the migration resistance. On the other hand, from the viewpoint of improving the sensitivity for exposure and improving the mechanical properties in heating at a low temperature, the content of the binder resin (A) is preferably 85 parts by mass or less, more preferably 80 parts by mass or less, and still more preferably 75 parts by mass or less.

<Compounds (B1) to (B5)>

From the viewpoint of improving the sensitivity for exposure and improving the mechanical properties in heating at a low temperature, the photosensitive composition of the present invention preferably further satisfies at least one of the following conditions (δ), (ε), and (ζ).

(δ) The compound (B) contains a first polymerizable compound (B1) (hereinafter, referred to as "compound (B1)") and a second polymerizable compound (B2) (hereinafter, referred to as "compound (B2)") described below.
(ε) The compound (B) contains a third polymerizable compound (B3) (hereinafter, referred to as "compound (B3)") and a fourth polymerizable compound (B4) (hereinafter, referred to as "compound (B4)") described below.
(ζ) The compound (B) contains the following compound (B1) or compound (B2), and further contains the following compound (B3) or compound (B4):
compound (B1): a compound having the following structure (I-b1) and further having at least two radical polymerizable groups:

structure (I-b1): a structure including an alicyclic structure and/or a structure including a heteroalicyclic structure;
compound (B2): a compound having the following structure (I-b2) and structure (II-b2) and further having at least two radical polymerizable groups:

structure (I-b2): a structure including an aromatic structure;
structure (II-b2): a structure including an aliphatic structure;
compound (B3): a compound having at least two (meth)acryloyl groups and further having the following structure (I-b3):

structure (I-b3): a structure that has at least two (meth)acryloyl groups linked with a minimum number of atoms of 4 to 10 and includes an aliphatic structure; and
compound (B4): a compound having at least two (meth)acryloyl groups and further having the following structure (I-b4):
structure (I-b4): a structure that has at least two (meth)acryloyl groups linked with a minimum number of atoms of 11 to 45 and includes an aliphatic structure.

The alicyclic structure in the structure (I-b1) in the compound (B1) is preferably a condensed polycyclic alicyclic structure, and more preferably a tricyclo [5.2.1.0$^{2,6}$] decane structure, from the viewpoint of improving the mechanical properties in heating at a low temperature. From the viewpoint of improving the mechanical properties in heating at a low temperature and improving migration resistance, the heteroalicyclic structure in the structure (I-b1) is preferably a nitrogen-containing cyclic structure, more preferably a cyclic structure having at least two nitrogen atoms, and still more preferably an isocyanuric acid structure and/or a triazine structure. The number of nitrogen atoms of the heteroalicyclic structure in the structure (I-b1) in the compound (B1) is preferably 1 or more, more preferably 2 or more, and still more preferably 3 or more. On the other hand, the number of nitrogen atoms is preferably 6 or less, and more preferably 4 or less.
The compound (B1) preferably further has the following structure (II-b1):
structure (II-b1): a structure including an aliphatic structure.
From the viewpoint of improving the sensitivity for exposure and improving the migration resistance, the aliphatic structure in the structure (II-b1) in the compound (B1) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group.
The aromatic structure in the structure (I-b2) in the compound (B2) is preferably a benzene structure or a biphenyl structure from the viewpoint of improving the mechanical properties in heating at a low temperature. From the same viewpoint, the aromatic structure in the above structure (I-b2) is preferably a condensed polycyclic structure, and more preferably a fluorene structure, an indane structure, or a naphthalene structure. From the same viewpoint, the aromatic structure in the above structure (I-b2) is preferably a condensed polycyclic heterocyclic structure, and more preferably a xanthene structure, an indolinone structure, or an isoindolinone structure.
The aliphatic structure in the structure (II-b2) in the compound (B2) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group from the viewpoint of improving the sensitivity for exposure and improving the migration resistance.
When the compound (B3) or the compound (B4) has two (meth)acryloyl groups, the minimum number of atoms in the structure (I-b3) or the structure (I-b4) refers to the minimum number of atoms including a carbon atom and a heteroatom between carbonyl carbons of the two (meth)acryloyl groups. The carbon atom between the carbonyl carbons and the atom bonded to the heteroatom are not included in the calculation of the minimum number of atoms. For example, when an oxygen atom, a propylene group, and an oxygen atom exist between carbonyl carbons, the minimum number of atoms is 5. When the compound (B3) or the compound (B4) has three or more (meth)acryloyl groups, the minimum number of atoms refers to the minimum number of atoms including a carbon atom linking the carbonyl carbons of all (meth)acryloyl groups and a heteroatom. Similarly, the carbon atom linking the carbonyl carbons and the atom linked to the heteroatom are not included in the calculation of the minimum number of atoms.

In the compound (B3), when the minimum number of atoms in the structure (I-b3) is in a specific range, the low molecular weight derived from the compound (B) in the cured product can be further reduced, and the effect of improving the migration resistance becomes remarkable. The minimum number of atoms in the structure (I-b3) is preferably 5 or more, and more preferably 6 or more. On the other hand, the minimum number of atoms in the structure (I-b3) is preferably 9 or less, and more preferably 8 or less. On the other hand, in the compound (B4), when the minimum number of atoms in the structure (I-b4) is in a specific range, the collision probability between (meth)acryloyl groups or between a (meth) acryloyl group and another radical polymerizable group is improved by improving the molecular mobility, and the effect of improving the sensitivity for exposure becomes remarkable. The minimum number of atoms in the structure (I-b4) is preferably 13 or more, more preferably 15 or more, still more preferably 17 or more, and particularly preferably 20 or more. On the other hand, the minimum number of atoms in the structure (I-b4) is preferably 40 or less, more preferably 35 or less, still more preferably 30 or less, and particularly preferably 25 or less.

From the viewpoint of improving the sensitivity for exposure and improving the migration resistance, the aliphatic structure in the structure (I-b3) and the structure (I-b4) in the compound (B3) and the compound (B4) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group. In addition, the aliphatic structure in the structure (I-b3) and the structure (I-b4) is preferably a structure derived from an aliphatic polyfunctional alcohol. Note that the compound (B3) and the compound (B4) are compounds different from the compound (B1) and the compound (B2) described above, and do not have a structure including an alicyclic structure, a structure including a heteroalicyclic structure, and a structure including an aromatic structure.

In the compound (B) as described above, the effect of improving the degree of cross-linking of the cured product is obtained by radical generation at the time of exposure and radical generation in heating at a low temperature, and in addition, the effect of improving the degree of cross-linking by reaction with the radical polymerizable group on the resin side chain or the resin end is obtained, and therefore it is presumed that the mechanical properties in heating at a low temperature are improved. It is presumed that the compound (B) having an aliphatic structure in the structure (II-b1), the structure (II-b2), the structure (I-b3), or the structure (I-b4) suppresses ion migration and electromigration due to the reduction of a low molecular weight component derived from the compound (B) in the cured product to improve the migration resistance.

The compound (B) also preferably further contains a compound (B5) described below from the viewpoint of improving the mechanical properties in heating at a low temperature. Note that the compound (B5) is a compound different from the compound (B2), and does not have the structure (II-b2) described above.

Compound (B5): A compound having a structure including a condensed polycyclic structure and/or a structure including a condensed polycyclic heterocyclic structure, and further having at least two radical polymerizable groups

In the compound (B5), the condensed polycyclic structure is preferably a fluorene structure, an indane structure, or a naphthalene structure. In the compound (B5), the condensed polycyclic heterocyclic structure described above is preferably a xanthene structure, an indolinone structure, or an isoindolinone structure.

The compound (B) also preferably contains one or more selected from the group consisting of the compound (B1), the compound (B2), the compound (B3), the compound (B4), and the compound (B5). The compound (B) also preferably contains two or more selected from the group consisting of the compound (B1), compound (B2), compound (B3), and compound (B4) described above, and also more preferably further contains the compound (B5) described above. The preferred contents of these compounds (B) are also the same as those described above.

Note that the total content of the compound (B1), the compound (B2), the compound (B3), the compound (B4), and the compound (B5) is preferably 15 parts by mass or more, more preferably 20 parts by mass or more, and still more preferably 25 parts by mass or more. On the other hand, the total content of the compound (B1), the compound (B2), the compound (B3), the compound (B4), and the compound (B5) is preferably 75 parts by mass or less, more preferably 65 parts by mass or less, and still more preferably 55 parts by mass or less.

<Photosensitizer (C)>

The photosensitive composition of the present invention contains a photosensitizer (C). The photosensitizer (C) refers to a compound that gives positive-type or negative-type photosensitivity to a composition by bond cleavage, reaction, or structural change upon exposure to generate another compound.

The photosensitizer (C) preferably contains one or more selected from the group consisting of a photo-polymerization initiator (C1), a naphthoquinone diazide compound (C2), a photo-acid generator (C3), and a photobase generator (C4). When negative-type photosensitivity is given to the composition, the photosensitizer (C) preferably contains the photo-polymerization initiator (C1), more preferably further contains one or more selected from the group consisting of the naphthoquinone diazide compound (C2), the photo-acid generator (C3), and the photobase generator (C4). When positive-type photosensitivity is given to the composition, the photosensitizer (C) preferably contains the naphthoquinone diazide compound (C2), more preferably further contains one or more selected from the group consisting

of the photo-polymerization initiator (C1), the photo-acid generator (C3), and the photobase generator (C4).

The content of the photosensitizer (C) is, in a case where the total of the binder resin (A) and the compound (B) is 100 parts by mass, preferably 1.0 parts by mass or more, more preferably 3.0 parts by mass or more, and still more preferably 5.0 parts by mass or more from the viewpoint of improving the sensitivity for exposure. On the other hand, from the viewpoint of suppressing presence of residues post-development, the content of the photosensitizer (C) is preferably 30 parts by mass or less, more preferably 25 parts by mass or less, and still more preferably 20 parts by mass or less.

<Photo-polymerization initiator (C1)>

The photo-polymerization initiator (C1) refers to a compound that generates radicals through bond cleavage and/or reaction upon exposure. Containing the photo-polymerization initiator (C1) is suitable for negative-type pattern formation, and the effect of improving the sensitivity for exposure becomes remarkable. The photo-polymerization initiator (C1) is preferably an α-hydroxyketone-based compound, an α-aminoketone-based compound, a biimidazole-based compound, a phosphine oxide-based compound, or an oxime ester-based compound. The preferred contents of these photosensitizers (C) are also the same as those described above.

The photosensitizer (C) preferably contains the photo-polymerization initiator (C1) from the viewpoint of improving the sensitivity for exposure and improving the mechanical properties in heating at a low temperature, and the photo-polymerization initiator (C1) preferably contains an oxime ester-based compound (C1-1) (hereinafter, referred to as "compound (C1-1)") and/or a phosphine oxide-based compound (C1-2) (hereinafter, referred to as "compound (C1-2)"), and more preferably contains the compound (C1-1). The compound (C1-1) refers to a compound having an oxime ester structure as a structure that undergoes bond cleavage and/or reaction upon exposure in a molecule to generate a radical. The compound (C1-2) refers to a compound having a phosphine oxide structure in the molecule and an acyl group as a structure for generating a radical by bond cleavage and/or reaction upon exposure. The preferred contents of these photosensitizers (C) are also the same as those described above.

From the viewpoint of improving the sensitivity for exposure and improving the mechanical properties in heating at a low temperature, the compound (C1-1) preferably has one or more selected from the group consisting of the following (I) and (II).

(I) A structure in which at least one oxime ester structure is bonded to a condensed polycyclic structure, a condensed polycyclic heterocyclic structure, a diphenyl sulfide structure, or a benzene structure (α-oxime structure) or a structure in which at least one oxime ester carbonyl structure is bonded thereto (β-oxime structure).

(II) One or more selected from the group consisting of a nitro group, a group substituted with a halogen atom, a naphthylcarbonyl structure, a trimethylbenzoyl structure, a thiophenylcarbonyl structure, a furylcarbonyl structure, at least two oxime ester structures, and a structure in which at least two oxime ester carbonyl structures are bonded (hereinafter, referred to as "specific substituent").

The condensed polycyclic structure is preferably a fluorene structure, a benzofluorene structure, a dibenzofluorene structure, an indene structure, an indane structure, a benzoindene structure, or a benzoindane structure. The condensed polycyclic heterocyclic structure is preferably a carbazole structure, a dibenzofuran structure, a dibenzothiophene structure, a benzocarbazole structure, an indole structure, an indoline structure, a benzoindole structure, a benzoindoline structure, a phenothiazine structure, or a phenothiazine oxide structure. The compound (C1-1) more preferably has a structure in which a specific substituent is bonded to a condensed polycyclic structure, a condensed polycyclic heterocyclic structure, a diphenyl sulfide structure, or a benzene structure.

From the viewpoint of improving the sensitivity for exposure and improving the mechanical properties in heating at a low temperature, the compound (C1-1) preferably has a group substituted with a halogen atom, and more preferably has a group substituted with a fluorine atom. The group substituted with a halogen atom is preferably a trifluoromethyl group, a trifluoropropyl group, a trichloropropyl group, a tetrafluoropropyl group, a fluorocyclopentyl group, a fluorophenyl group, or a pentafluorophenyl group. Presumably, this is because, when the polyimide-based resin has a carboxylic acid residue having a fluorine atom and/or an amine residue having a fluorine atom, the compound (C1-1) as described above improves compatibility with the binder resin (A), and promotes radical polymerization from the film surface to the deep part of the film.

From the viewpoint of having a photobleaching property, the compound (C1-1) preferably has a fluorene structure, a benzofluorene structure, a dibenzofluorene structure, an indole structure, a benzoindole structure, a phenothiazine structure, a phenothiazine oxide structure, or a diphenyl sulfide structure, and also preferably has a structure in which at least one oxime ester carbonyl structure is bonded to a condensed polycyclic structure, a condensed polycyclic heterocyclic structure, a diphenyl sulfide structure, or a benzene structure. When the compound (C1-1) has the photobleaching property, the effects of improving the sensitivity for exposure and improving the patternability in a thick film are remarkable. It is presumed that ion migration and electromigration are suppressed and the migration resistance is

improved by reducing the low molecular weight component derived from the compound (C1-1) in the cured product. Note that the photobleaching property refers to reduction in absorbance at a wavelength in an ultraviolet region (for example, 400 nm or less) and/or absorbance at a wavelength of visible light (380 to 780 nm) due to bond cleavage and/or reaction upon exposure.

It is presumed that the compound (C1-1) as described above has an effect of improving the degree of cross-linking of the cured product and promoting the ring-closing reaction of the resin due to radical generation in heating at a low temperature and interaction due to an oxime ester structure, and thus has improved mechanical properties in heating at a low temperature.

Examples of the compound (C1-2) include 2,4,6-trimethyl benzoyl-diphenyl phosphine oxide, bis(2,4,6-trimethyl benzoyl)-phenyl phosphine oxide, or bis(2,6-dimethoxy benzoyl)-(2,4,4-trimethylpentyl)phosphine oxide.

It is presumed that the compound (C1-2) as described above has an effect of improving the degree of cross-linking of the cured product and promoting the ring-closing reaction of the resin due to radical generation in heating at a low temperature and interaction due to a phosphine oxide structure, and thus has improved mechanical properties in heating at a low temperature.

<Naphthoquinone diazide compound (C2)>

The naphthoquinone diazide compound (C2) refers to a compound whose structure is changed by exposure to generate indene carboxylic acid and/or sulfoindene carboxylic acid. Containing the naphthoquinone diazide compound (C2) is suitable for positive-type pattern formation. The naphthoquinone diazide compound (C2) is preferably a 1,2-naphthoquinone diazide-5-sulfonic acid ester form or a 1,2-naphthoquinone diazide-4-sulfonic acid ester form of a compound having a phenolic hydroxyl group. The preferred contents of these photosensitizers (C) are also the same as those described above.

<Photo-acid generator (C3)>

The photo-acid generator (C3) refers to a compound that undergoes bond cleavage and/or reaction upon exposure to generate an acid. Containing the photo-acid generator (C3) is suitable for negative-type pattern formation from the viewpoint of promoting cationic polymerization and the like. On the other hand, when the resin or the like has an acidic group protected by an acid-dissociable group, it is suitable for positive-type pattern formation from the viewpoint of releasing the acidic group by exposure. Examples of the photo-acid generator (C3) include an ionic compound and a non-ionic compound. The ionic compound is preferably a triorganosulfonium salt-based compound. Preferable examples of the non-ionic compound include halogen-containing compounds, diazomethane compounds, sulfone compounds, sulfonate ester compounds, carboxylic acid ester compounds, sulfonimide compounds, phosphate ester compounds, and sulfone benzotriazoles compounds. The preferred contents of these photosensitizers (C) are also the same as those described above.

<Photobase generator (C4)>

The photobase generator (C4) refers to a compound that undergoes bond cleavage and/or reaction upon exposure to generate a base. Containing the photobase generator (C4) is suitable for negative-type pattern formation from the viewpoint of promoting anion polymerization and the like. On the other hand, when the resin or the like has an acidic group protected by base-dissociability, it is suitable for positive-type pattern formation from the viewpoint of releasing the acidic group by exposure. Examples of the photobase generator (C4) include an ionic compound and a non-ionic compound. The ionic compound is preferably a diazabicycloalkene salt-based compound, a triazabicycloalkene salt-based compound, an $\alpha$-keto quaternary ammonium salt-based compound, a benzyl quaternary ammonium salt-based compound, a guanidine salt-based compound, or a biguanide salt-based compound. The ionic compound preferably has a ketoprofen structure, an oxoxoxanthene structure, a benzofuran structure, or a naphthalene structure. The non-ionic compound is preferably a nitrobenzyl carbamate compound, an anthracenyl carbamate compound, a benzoin-based carbamate compound, an anthraquinone-based carbamate compound, a hydroxycinnamamide-based compound, or a coumarin amide-based compound. The preferred contents of these photosensitizers (C) are also the same as those described above.

<Colorant (D)>

The photosensitive composition of the present invention also preferably further contains a colorant (D). The colorant (D) refers to a compound that creates a color by absorbing light having a wavelength of visible light (380 to 780 nm). Containing the colorant (D) makes it possible to adjust the chromaticity of transmitted light or reflected light of the film

of the composition and impart a light-shielding property to the film of the composition. The colorant (D) is preferably a pigment or a dye. The colorant (D) preferably contains a blacking agent from the viewpoint of improving the light-shielding property.

The black color in the colorant (D) refers to a color with Colour Index Generic Name (hereinafter, referred to as a "C.I. number") including "BLACK" therein. When containing the color assigned with no C.I. number, it refers to a black color in the case of the composition as a cured film. The black color in the case of the composition as a cured film means that in the transmission spectrum of the cured film of the composition containing the colorant (D), based on the Lambert Beer formula, the transmittance per 1.0 μm of the film thickness at a wavelength of 550 nm is converted with the film thickness within the range of 0.10 to 1.5 μm such that the transmittance at a wavelength of 550 nm is 10%, the transmittance at a wavelength of 450 to 650 nm in the converted transmission spectrum is 25% or less. The transmission spectrum of the cured film can be determined on the basis of the method disclosed in paragraph [0285] of International Publication No. 2019/087985.

The content ratio of the colorant (D) in the total solid content of the photosensitive composition of the present invention is preferably 5.0 % by mass or more, more preferably 10% by mass or more, still more preferably 15% by mass or more, even more preferably 20% parts by mass or more, and particularly preferably 30% by mass or more from the viewpoint of improving the light-shielding property and improving the reliability. On the other hand, from the viewpoint of improving the sensitivity for exposure and suppressing presence of residues post-development, the content ratio of the colorant (D) is preferably 70% by mass or less, and more preferably 50% by mass or less.

The colorant (D) preferably contains a black pigment, and more preferably contains an organic black pigment and/or an inorganic black pigment. The organic black pigment is preferably a benzofuranone-based black pigment, a perylene-based black pigment, an azomethine-based black pigment, an anthraquinone-based black pigment, an aniline-based black pigment, an azo-based black pigment, or carbon black. The inorganic black pigment is preferably fine particles, oxides, composite oxides, sulfides, sulfates, nitrates, carbonates, nitrides, carbides, or oxynitrides of metal elements. The metal elements are preferably Ti, Zr, V, Cr, Mn, Co, Ni, Y, Nb, Hf, Ta, W, Re, Fe, Cu, Zn, or Ag. The inorganic black pigment preferably contains an element different from these metal elements, and more preferably contains B, Al, Si, Mn, Co, Ni, Fe, Cu, Zn, or Ag. The colorant (D) also preferably contains a black dye. The black dye preferably contains a black dye containing a chromium element and/or an azo-based black dye. The preferred content ratios of these colorants (D) are also the same as those described above.

The benzofuranone-based black pigment preferably contains a compound having at least two benzofuran-2(3H)-one structures that may share a benzene ring or at least two benzofuran-3(2H)-one structures that may share a benzene ring, a geometric isomer thereof, a salt thereof, or a salt of a geometric isomer thereof. The perylene-based black pigment preferably contains a compound having a 3,4,9,10-perylenetetracarboxylic acid bisbenzimidazole structure, a geometric isomer thereof, a salt thereof, or a salt of a geometric isomer thereof. The azomethine-based black pigment preferably contains a compound having an azomethine structure and a carbazole structure or a salt thereof.

The colorant (D) preferably contains a colorant mixture of two or more colors, and more preferably contains (I) blue, red, and yellow, (II) blue, red, and orange, (III) blue, purple, and orange, or (IV) purple and yellow. The colorant mixture is more preferably a coloring pigment mixture and/or a coloring dye mixture. The coloring pigment is preferably an anthraquinone-based pigment, a diketopyrrolopyrrole-based pigment, a perylene-based pigment, an isoindoline-based pigment, an isoindolinone-based pigment, an imidazolone-based pigment, a quinacridone-based pigment, a pyranthrone-based pigment, a phthalocyanine-based pigment, an indantrone-based pigment, or a dioxazine-based pigment. The coloring dye is preferably a squarylium-based dye, a xanthene-based dye, a triarylmethane-based dye, or a phthalocyanine-based dye. The preferred content ratios of these colorants (D) are also the same as those described above.

In the photosensitive composition of the present invention, the pigment also preferably has a covering layer. The covering layer refers to a layer covering a pigment surface, examples of which include a layer formed by a surface treatment with a silane coupling agent, a surface treatment with a silicate, a surface treatment with a metal alkoxide, or a covering treatment with a resin, for example. The covering layer preferably contains one or more selected from the group consisting of a silica covering layer, a metal oxide covering layer, and a metal hydroxide covering layer.

<Dispersant (E)>

The photosensitive composition of the present invention preferably further contains a dispersant (E). The dispersant (E) refers to a compound having a surface affinity structure that interacts with a pigment surface and a dispersion stabilizing structure that inhibits approach of pigments to each other. From the viewpoint of improving the dispersion stability of the pigment, the photosensitive composition of the present invention more preferably contains a pigment and further contains the dispersant (E).

The dispersant (E) is preferably a dispersant having a basic group, a dispersant having a basic group and an acidic group, or a dispersant having a salt structure of a basic group. Note that a dispersant having an acidic group, a dispersant having a salt structure of an acidic group, or a dispersant having neither a basic group nor an acidic group may

be contained.

The basic group of the dispersant (E) is preferably a tertiary amino group or a nitrogen-containing ring structure. The acidic group of the dispersant (E) is preferably a carboxy group, a sulfonic acid group, or a phosphoric acid group. The salt structure of the basic group of the dispersant (E) is preferably a quaternary ammonium salt structure or a salt structure of a nitrogen-containing ring structure. The counter anion in the salt structure of the basic group is preferably a carboxylate anion, a sulfonate anion, a sulfate anion, a nitrate anion, a phosphate anion, or a halogen anion. The polymer chain of the dispersant (E) is preferably fluororesin, silicone, acrylic resin, a polyoxyalkylene ether, polyester, polyurethane, polyol, polyalkyleneamine, polyethyleneimine, or polyallylamine.

When the photosensitive composition of the present invention contains a pigment, the content of the dispersant (E) is, in a case where the pigment is 100 parts by mass, preferably 5.0 parts by mass or more, more preferably 10 parts by mass or more, and still more preferably 15 parts by mass or more, from the viewpoint of improving the dispersion stability of the pigment. On the other hand, the content of the dispersant (E) is preferably 50 parts by mass or less, and more preferably 40 parts by mass or less from the viewpoint of improving the sensitivity for exposure.

<Cross-linking agent (F)>

The photosensitive composition of the present invention contains the compound (B) and/or the cross-linking agent (F). The cross-linking agent (F) refers to a compound having a cross-linking group capable of reacting with a resin or the like, a cationically polymerizable group, or an anionically polymerizable group.

It is preferable that the photosensitive composition of the present invention contains the photosensitizer (C) described above and further contains the compound (B) and/or the cross-linking agent (F), and, from the viewpoint of promoting photoreaction, it is more preferable that the photosensitive composition of the present invention contains the photo-acid generator (C3) or photobase generator (C4) described above and further contains the cross-linking agent (F). On the other hand, from the viewpoint of improving the degree of cross-linking of a resin or the like, it is also preferable that the photosensitive composition of the present invention contains the naphthoquinone diazide compound (C2) described above and further contains the cross-linking agent (F).

From the viewpoint of improving the sensitivity for exposure and improving the mechanical properties in heating at a low temperature, the cross-linking agent (F) is preferably a compound having one or more groups selected from the group consisting of an alkoxyalkyl group, a hydroxyalkyl group, an epoxy group, an oxetanyl group, and a blocked isocyanate group (hereinafter, referred to as "specific cross-linking group"). The alkoxyalkyl group is preferably an alkoxymethyl group or an alkoxyethyl group, and more preferably a methoxymethyl group or a methoxyethyl group. The hydroxyalkyl group is preferably a methylol group or an ethylol group. From the viewpoint of improving the sensitivity for exposure and improving the mechanical properties in heating at a low temperature, the number of specific cross-linking groups of the cross-linking agent (F) is preferably 2 or more, more preferably 3 or more, still more preferably 4 or more, and particularly preferably 6 or more. On the other hand, from the viewpoint of improving the mechanical properties in heating at a low temperature, the number of specific cross-linking groups is preferably 12 or less, more preferably 10 or less, and still more preferably 8 or less.

The content of the cross-linking agent (F) is, in a case where the total of the binder resin (A) and the compound (B) is 100 parts by mass, preferably 1.0 parts by mass or more, more preferably 3.0 parts by mass or more, and still more preferably 5.0 parts by mass or more from the viewpoint of improving the sensitivity for exposure and improving the mechanical properties in heating at a low temperature. On the other hand, the content of the cross-linking agent (F) is preferably 30 parts by mass or less, and more preferably 20 parts by mass or less from the viewpoint of suppressing presence of residues post-development and improving the mechanical properties in heating at a low temperature.

<Compound (F1) and compound (F2)>

The cross-linking agent (F) preferably contains the following compound (F1) and/or compound (F2) from the viewpoint of suppressing presence of residues post-development and improving the mechanical properties in heating at a low temperature. The preferred contents of these cross-linking agents (F) are also the same as those described above.

Compound (F1): A compound having at least two phenolic hydroxyl groups and at least two specific cross-linking groups

Compound (F2): A compound having a structure including a heteroalicyclic structure and at least two specific cross-linking groups

The compound (F1) preferably has at least two structures in which a phenolic hydroxyl group and a specific cross-linking group are bonded to one aromatic structure. In addition, the compound (F1) more preferably has at least two structures in which a phenolic hydroxyl group and at least two specific cross-linking groups are bonded to one aromatic

structure.

The heteroalicyclic structure in the compound (F2) is preferably a nitrogen-containing cyclic structure, and more preferably a cyclic structure having at least two nitrogen atoms. In addition, the cyclic structure having at least two nitrogen atoms is preferably one or more selected from the group consisting of an isocyanuric acid structure, a triazine structure, a glycoluril structure, an imidazolidone structure, a pyrazole structure, an imidazole structure, a triazole structure, a tetrazole structure, and a purine structure, and more preferably an isocyanuric acid structure and/or a triazine structure. The number of nitrogen atoms of the heteroalicyclic structure in the compound (F2) is preferably 1 or more, more preferably 2 or more, and still more preferably 3 or more. On the other hand, the number of nitrogen atoms is preferably 6 or less, and more preferably 4 or less.

<Inorganic particles (G)>

The photosensitive composition of the present invention preferably further contains inorganic particles (G) from the viewpoint of improving the migration resistance. The inorganic particles (G) refer to particles containing an element selected from the group consisting of a metal element, a metalloid element, and a semiconductor element as a main component. Note that the main component refers to a component that is most contained in the constituent components on a mass basis. The inorganic particles (G) preferably have a hydroxy group and/or a silanol group on the particle surface from the viewpoint of improving the migration resistance.

The photosensitive composition of the present invention preferably further contains, from the viewpoint of improving the migration resistance, inorganic particles (G), and the inorganic particles (G) preferably contain one or more selected from the group consisting of silica particles, alumina particles, titania particles, vanadium oxide particles, chromium oxide particles, ferric oxide particles, cobalt oxide particles, copper oxide particles, zinc oxide particles, zirconium oxide particles, niobium oxide particles, tin oxide particles, and cerium oxide particles, and more preferably contain silica particles from the viewpoint of improving the migration resistance and suppressing external light reflection.

The silica particles preferably have a functional group on the surface from the viewpoint of improving the migration resistance. The functional group of the silica particles on the surface is preferably a radical polymerizable group, a thermally reactive group, a hydroxy group, a silanol group, an alkoxysilyl group, an alkylsilyl group, a dialkylsilyl group, a trialkylsilyl group, a phenylsilyl group, or a diphenylsilyl group. The radical polymerizable group or the thermally reactive group is also preferably a reaction residue of a surface-modifying group containing a radical polymerizable group or a reaction residue of a surface-modifying group containing a thermally reactive group. The silica particles more preferably have a radical polymerizable group and/or a thermally reactive group on the surface. Examples and preferred descriptions concerning the radical polymerizable group are as described in Binder resin (A) above.

From the viewpoint of improving the migration resistance, the average primary particle size of the silica particles is preferably 5.0 nm or more, more preferably 7.0 nm or more, and still more preferably 10 nm or more. On the other hand, from the viewpoint of suppressing presence of residues post-development and suppressing external light reflection, the average primary particle size of the silica particles is preferably 200 nm or less, more preferably 100 nm or less, still more preferably 70 nm or less, even more preferably 50 nm or less, particularly preferably 30 nm or less, and most preferably 20 nm or less.

In addition, from the viewpoint of increasing the elastic modulus and decreasing the thermal expansion coefficient, the average primary particle size of the silica particles preferably exceeds 0.20 μm, and is more preferably 0.30 μm or more, and still more preferably 0.50 μm or more. On the other hand, from the viewpoint of suppressing presence of residues post-development, the average primary particle size of the silica particles is preferably 100 μm or less, more preferably 50 μm or less, still more preferably 30 μm or less, even more preferably 10 μm or less, particularly preferably 5.0 μm or less, and most preferably 3.0 μm or less.

The primary particle size of the silica particles refers to the major axis size of the primary particles of the silica particles. The average primary particle size of the silica particles in the film can be calculated as an average value obtained by imaging and analyzing a cross section of the film using a transmission electron microscope (hereinafter, referred to as "TEM") and measuring 30 primary particles of the silica particles. The average primary particle size of the silica particles in the silica particle dispersion liquid is obtained by measuring a particle size distribution by a dynamic light scattering method or a laser diffraction/scattering method. Examples of the measuring instrument include SZ-100 manufactured by HORIBA, Ltd. as a dynamic light scattering method, and SLD 3100 manufactured by Shimadzu Corporation, LA-920 manufactured by HORIBA, Ltd. or its equivalent as the laser diffraction/scattering method.

It is considered that the silica particles as described above trap metal impurities, ion impurities, and the like that adversely affect electrical insulation property due to the acidity and negative charge of the hydroxy group and/or silanol group on the particle surface. In addition, it is presumed that the migration resistance is improved because the robust structure of the particles keeps the trapped impurities even when a heat treatment or voltage application is performed. In addition, it is considered that the silica particles unevenly distributed on the surface of the cured product reduce reflection and scattering of incident external light.

The silica particles preferably contain silica particles containing a sodium element from the viewpoint of improving the migration resistance. Examples of the existence form of the sodium element include an ion ($Na^+$) or a salt with a silanol group (Si-ONa). The content of the sodium element in the silica particles is preferably 1.0 ppm by mass or more, more preferably 5.0 ppm by mass or more, still more preferably 10 ppm by mass or more, even more preferably 50 ppm by mass or more, and particularly preferably 100 ppm by mass or more. On the other hand, the content of the sodium element in the silica particles is preferably 10,000 ppm by mass or less, more preferably 5,000 ppm by mass or less, and still more preferably 1,000 ppm by mass or less. The sodium element contained in the silica particles can be detected by imaging and analyzing the cross section of the film using transmission electron microscope-energy dispersive X-ray spectroscopy (hereinafter, referred to as "TEM-EDX"). It is considered that the polarization structure and charge balance in the cured product are controlled by intentionally containing a small amount of sodium element in the silica particles. As a result, metal impurities, ion impurities, and the like that adversely affect electrical insulation property are efficiently trapped, and therefore the migration resistance is presumed to be improved.
From the viewpoint of improving the migration resistance, the content ratio of the inorganic particles (G) in the total solid content of the photosensitive composition of the present invention is preferably 5.0% by mass or more, more preferably 10% by mass or more, still more preferably 15% by mass or more, and particularly preferably 20% by mass or more. On the other hand, from the viewpoint of suppressing presence of residues post-development, the content ratio of the inorganic particles (G) is preferably 90% by mass or less, more preferably 70% by mass or less, and still more preferably 50% by mass or less.

<Other additives>

The photosensitive composition of the present invention preferably further contains one or more selected from the group consisting of a thermal coloring agent, an oxidation coloring agent, a dissolution accelerator, an ink repellent, a sensitizer, a chain transfer agent, a polymerization terminator, a silane coupling agent, and a surfactant. As these additives, known additives may be used.

<Solvent>

It is also preferable that the photosensitive composition of the present invention further contain a solvent. From the viewpoint of the solubility of various resins and various additives, the solvent is preferably a compound having an alcoholic hydroxyl group, a carbonyl group, an ester bond, an amide bond, or at least three ether bonds.
When the photosensitive composition of the present invention contains a pigment and further contains a dispersant, the solvent is preferably a compound having a carbonyl group, an ester bond, or an amide bond, more preferably a compound having an alkylcarbonyl group, a dialkylcarbonyl group, a formyl group, a carboxy group, a carboxylate bond, a carbonate bond, a formate bond, an amide group, an imide group, a urea bond, or a urethane bond, and still more preferably a compound having an acetate bond, a propionate bond, or a butyrate bond.

<Contents of specific aromatic compound, specific anion, and specific organic acid>

The photosensitive composition corresponding to the first aspect of the present invention satisfies the following condition ($\alpha$). The photosensitive composition corresponding to the second aspect of the present invention satisfies one or more selected from the group consisting of the following conditions ($\alpha$), ($\beta$), and ($\gamma$):
($\alpha$) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (1x) is satisfied:

(1x) a total content of the sulfonic acids, the phosphate esters, the phosphonic acids, the phosphonate esters, the phosphite esters, the phosphinic acids, the hypophosphite esters, and the carboxylic acids containing a fluorine element in the total solid content of the photosensitive composition is 0.010 to 1,000 ppm by mass;
($\beta$) one or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (2x) is satisfied:

(2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the total solid content of the photosensitive composition is 0.010 to 1,000 ppm by mass; and
($\gamma$) one or more selected from the group consisting of benzene, toluene, xylene, and naphthalene is/are contained, and the following condition (3) is satisfied:

(3) a total content of the benzene, the toluene, the xylene, and the naphthalene in the photosensitive composition is 0.010 to 1,000 ppm by mass.

The sulfonic acid is an organic compound having at least one sulfonic acid group. The sulfonic acid is preferably a compound having a substituent containing a carbon element and having a sulfonic acid group. The phosphate esters, the phosphonic acid, the phosphonate esters, the phosphite esters, the phosphinic acids, and the hypophosphite esters are preferably compounds having a substituent containing a carbon element and having an acidic group containing a phosphorus element. The carboxylic acid containing a fluorine element is preferably a compound having a substituent containing a fluorine element and a carbon element and having a carboxy group.

When the condition (β) is satisfied, the photosensitive composition of the present invention preferably further contains a compound containing a specific anion. When the photosensitive composition of the present invention contains a compound containing a specific anion, the photosensitive composition preferably further contains an ammonium ion, a primary ammonium ion, a secondary ammonium ion, a tertiary ammonium ion, or a quaternary ammonium ion as a cationic species.

The above-described phosphate ester, phosphonic acid, phosphonate ester, phosphite ester, phosphinic acid, and hypophosphite ester are preferably phosphate monoester, phosphate diester, phosphonic acid, phosphonate monoester, phosphite monoester, phosphite diester, phosphonic acid, or hypophosphite monoester.

The specific organic acids described above preferably have one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms.

The photosensitive composition corresponding to the second aspect of the present invention preferably satisfies two or more selected from the group consisting of the condition (α), the condition (β), and the condition (γ) from the viewpoint of suppressing presence of residues post-development, improving the mechanical properties in heating at a low temperature, and improving the migration resistance. From the viewpoint of the effects of the present invention, it is more preferable that the photosensitive composition of the present invention satisfies the condition (α) and further satisfies the condition (β) and/or the condition (γ).

It is preferable that the photosensitive composition of the present invention satisfies the condition (α) and further satisfies the condition (β) from the viewpoint of suppressing presence of residues post-development, improving the mechanical properties in heating at a low temperature, and improving the migration resistance. From the viewpoint of the effects of the present invention described above, it is preferable that the photosensitive composition of the present invention satisfies the condition (α) and further satisfies the condition (γ).

It is preferable that the photosensitive composition of the present invention satisfies the condition (γ) and further satisfies the condition (α) and/or the condition (β) from the viewpoint of suppressing presence of residues post-development, improving the mechanical properties in heating at a low temperature, and improving the migration resistance.

On the other hand, when the storage stability of the photosensitive composition is poor, for example, foreign matter generation after storage at room temperature may be a problem. When foreign matter is generated during storage of the photosensitive composition, the foreign matter remains in the cured product or pattern openings during formation of a cured product of the photosensitive composition, such as a cured product in the electronic component of the present invention. Such foreign matter causes a decrease in reliability of light-emitting elements in the display device and a decrease in migration resistance in the electronic component. In the photosensitive composition of the present invention, when the content of a specific aromatic compound, the content of a specific anion, or the content of a specific organic acid is within an appropriate range, the effect of improving the storage stability becomes remarkable.

The total content of the specific aromatic compounds in the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific aromatic compounds is preferably 500 ppm by mass or less, more preferably 300 ppm by mass or less, and still more preferably 100 ppm by mass or less. Furthermore, from the viewpoint of suppressing presence of residues post-development, improving the mechanical properties in heating at a low temperature, and improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The total content of the specific anions in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific anions is preferably 500 ppm by mass or less, more preferably 300 ppm by mass or less, and still more preferably 100 ppm by mass

or less. Furthermore, from the viewpoint of suppressing presence of residues post-development, improving the mechanical properties in heating at a low temperature, and improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The total content of the specific organic acids in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific organic acids is preferably 500 ppm by mass or less, more preferably 300 ppm by mass or less, and still more preferably 100 ppm by mass or less. Furthermore, from the viewpoint of suppressing presence of residues post-development, improving the mechanical properties in heating at a low temperature, and improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

When the above condition ($\alpha$) is satisfied, the photosensitive composition of the present invention preferably contains a sulfonic acid and/or a carboxylic acid containing a fluorine element, and more preferably contains a sulfonic acid. The total content ratio of the sulfonic acid and/or the carboxylic acid containing a fluorine element to the total of the specific organic acids is preferably 50% by mass or more, and more preferably 60% by mass or more. On the other hand, the total content ratio of the sulfonic acid and/or the carboxylic acid containing a fluorine element is preferably 100% by mass or less, more preferably 90% by mass or less, and still more preferably 80% by mass or less. In addition, the content ratios of the sulfonic acids are more preferably the content ratios described above.

When the condition ($\beta$) is satisfied, the photosensitive composition of the present invention preferably contains one or more selected from the group consisting of a phosphate ion, a phosphite ion, a hypophosphite ion, a formate ion, and a fluoride ion, and more preferably contains one or more selected from the group consisting of a phosphate ion, a phosphite ion, and a hypophosphite ion. The total content ratio of the phosphate ion, the phosphite ion, the hypophosphite ion, the formate ion, and the fluoride ion in the total of the specific anions is preferably 50% by mass or more, and more preferably 60% by mass or more. On the other hand, the total content ratio of the phosphate ion, the phosphite ion, the hypophosphite ion, the formate ion, and the fluoride ion is preferably 100% by mass or less, more preferably 90% by mass or less, and still more preferably 80% by mass or less. In addition, the total content ratios of the phosphate ion, the phosphite ion, and the hypophosphite ion are more preferably the content ratios described above.

When the condition ($\gamma$) is satisfied, the photosensitive composition of the present invention preferably contains one or more selected from the group consisting of benzene, toluene, and xylene, and more preferably contains benzene and/or toluene. The total content ratio of the benzene, the toluene, and the xylene in the total of the specific aromatic compounds is preferably 50% by mass or more, more preferably 60% by mass or more. On the other hand, the total content ratio of the benzene, the toluene, and the xylene is preferably 100% by mass or less, more preferably 90% by mass or less, and still more preferably 80% by mass or less. In addition, the total content ratios of the benzene and the toluene are more preferably the content ratios described above.

When the photosensitive composition of the present invention has negative-type photosensitivity, the photosensitive composition of the present invention preferably satisfies the condition ($\gamma$) from the viewpoint of suppressing presence of residues post-development. In addition, when the photosensitive composition of the present invention has negative-type photosensitivity and contains the photo-polymerization initiator (C1) and the compound (B), the photosensitive composition of the present invention preferably satisfies the condition ($\gamma$) from the viewpoint of suppressing presence of residues post-development.

It is considered that the above-described specific aromatic compound interacts with an active radical and an active species in cationic polymerization or anionic polymerization to be stabilized by a $\pi$ electron on an aromatic ring, thereby obtaining an effect of suppressing presence of residues post-development. In particular, it is presumed that the specific aromatic compound traps the active radicals derived from the photo-polymerization initiator (C1) and the compound (B), so that the effect of suppressing presence of residues post-development by radical polymerization control at the time of exposure becomes remarkable.

In the photosensitive composition of the present invention, from the viewpoint of suppressing presence of residues post-development, improving the mechanical properties in heating at a low temperature, and improving the migration resistance, it is preferable that the condition ($\beta$) is a condition ($\beta$2) described below, and the condition ($\alpha$) and/or the following condition ($\beta$2) are/is satisfied:

($\beta$2) one or more selected from the group consisting of a phosphate ion, a phosphite ion, a hypophosphite ion, a formate ion, and a fluoride ion is/are contained, and the following condition (2y) is satisfied:

(2y) a total content of the phosphate ion, the phosphite ion, the hypophosphite ion, the formate ion, and the fluoride ion in the total solid content of the photosensitive composition is 0.010 to 1,000 ppm by mass.

Preferred ranges of the total contents of the phosphate ion, the phosphite ion, the hypophosphite ion, the formate

ion, and the fluoride ion in the total solid content of the photosensitive composition are also the same as the contents of the specific anions described above.

From the viewpoint of suppressing presence of residues post-development, improving the mechanical properties in heating at a low temperature, and improving the migration resistance, in the photosensitive composition of the present invention, the sulfonic acid, and the phosphate ester, the phosphonic acid, the phosphonate ester, the phosphite ester, the phosphinic acid, and the hypophosphite ester (hereinafter, referred to as "organic acids containing a phosphorus element") have the following specific substituent a,

the carboxylic acid containing a fluorine element has the following specific substituent b, and
the condition ($\alpha$) is the following condition ($\alpha$2), and the following condition ($\alpha$2) and/or the condition ($\beta$) are/is preferably satisfied, and the following condition ($\alpha$2) is more preferably satisfied:
($\alpha$2) one or more selected from the group consisting of the sulfonic acids having the following specific substituent a, the organic acids containing a phosphorus element having the following specific substituent a, and the carboxylic acids containing a fluorine element having the following specific substituent b is/are further contained, and the following condition (1y) is satisfied:

specific substituent a: one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms;
specific substituent b: one or more selected from the group consisting of a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms; and
(1y) a total content of the sulfonic acid having the specific substituent a, the organic acid containing a phosphorus element having the specific substituent a, and the carboxylic acid containing a fluorine element having the specific substituent b in the total solid content of the photosensitive composition is 0.010 to 1,000 ppm by mass.

Preferred ranges of the total contents of the sulfonic acid having the specific substituent a, the organic acid containing a phosphorus element having the specific substituent a, and the carboxylic acid containing a fluorine element having the specific substituent b in the total solid content of the photosensitive composition are the same as the contents of the specific organic acids described above.

In the photosensitive composition of the present invention, from the viewpoint of suppressing presence of residues post-development, improving the mechanical properties in heating at a low temperature, and improving the migration resistance, it is preferable that the condition ($\alpha$2) is the following condition ($\alpha$3) and the condition ($\alpha$3) is satisfied,

the sulfonic acid preferably contains one or more selected from the group consisting of methanesulfonic acid, propanesulfonic acid, cyclohexanesulfonic acid, benzenesulfonic acid, toluenesulfonic acid, xylenesulfonic acid, trifluoromethanesulfonic acid, hexafluorocyclohexanesulfonic acid, hexafluorobenzenesulfonic acid, pentafluorotoluenesulfonic acid, tetrafluoroxylenesulfonic acid, trifluoromethylbenzenesulfonic acid, trifluoromethyltoluenesulfonic acid, and trifluoromethylxylenesulfonic acid, and
the carboxylic acid containing a fluorine element preferably contains one or more selected from the group consisting of trifluoroacetic acid, trifluoropropionic acid, hexafluorocyclohexanecarboxylic acid, hexafluorobenzoic acid, and trifluoromethylbenzoic acid from the viewpoint of suppressing presence of residues post-development, improving the mechanical properties in heating at a low temperature, and improving the migration resistance:
($\alpha$3) a sulfonic acid and/or a carboxylic acid containing a fluorine element is/are further contained, and the following condition (1z) is satisfied:
(1z) a total content of the sulfonic acid and the carboxylic acid containing a fluorine element in the total solid content of the photosensitive composition is 0.010 to 1,000 ppm by mass.

Preferred ranges of the total contents of the sulfonic acid and the carboxylic acid containing a fluorine element in the total solid content of the photosensitive composition are also the same as the contents of the specific organic acids described above.

<Content of specific nitrogen-containing compound>

From the viewpoint of improving the migration resistance, it is preferable that the photosensitive composition of the present invention further contains one or more selected from the group consisting of a cyclic amide compound

represented by General Formula (20), an amide compound represented by General Formula (21), a cyclic urea compound represented by General Formula (22), a urea compound represented by General Formula (23), an oxazolidone compound represented by General Formula (24), and an isoxazolidone compound represented by General Formula (25) and satisfies the following condition (4):

(4) a total content of the cyclic amide compound represented by General Formula (20), the amide compound represented by General Formula (21), the cyclic urea compound represented by General Formula (22), the urea compound represented by General Formula (23), the oxazolidone compound represented by General Formula (24), and the isoxazolidone compound represented by General Formula (25) (hereinafter, referred to as "specific nitrogen-containing compound") in the total solid content of the photosensitive composition is 0.010 to 5.0% by mass.

When the binder resin (A) contains the resin (A1), and the resin (A1) contains one or more selected from the group consisting of the resin (A1-1), the resin (A1-2), the resin (A1-3), the resin (A1-4), the resin (A1-5), the resin (A1-6), and a copolymer consisting of two or more thereof,

it is more preferable, from the viewpoint of improving the migration resistance, that the photosensitive composition of the present invention further contains one or more selected from the group consisting of the specific nitrogen-containing compounds and satisfies the condition (4).

[Chemical Formula 11]

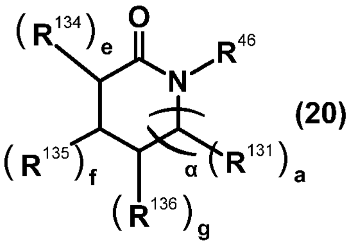 (20) 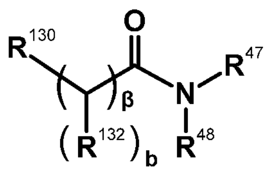 (21) 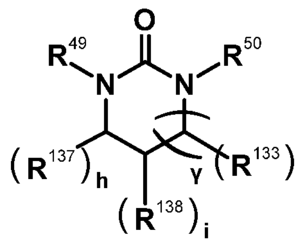 (22)

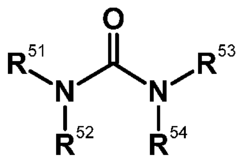 (23) 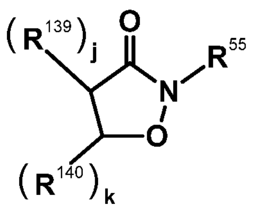 (24) 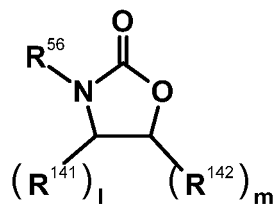 (25)

In General Formulae (20) to (25), $R^{46}$ to $R^{56}$ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms. $R^{130}$ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms. $R^{131}$ to $R^{142}$ each independently represent an alkyl group having 1 to 6 carbon atoms. $\alpha$, $\beta$, and $\gamma$ each independently represent an integer of 0 to 6. a, b, c, e, f, g, h, i, j, k, 1, and m each independently represent an integer of 0 to 2. In a case where $\alpha$ is 0, a is 0. In a case where $\beta$ is 0, b is 0. In a case where $\gamma$ is 0, c is 0. The above-described substituent and structure may have a heteroatom, and may be either unsubstituted or substituted.

Examples of the specific nitrogen-containing compound include N-methyl-2-pyrrolidone, N-ethyl-2-pyrrolidone, N-butyl-2-pyrrolidone, N-cyclohexyl-2-pyrrolidone, N-vinyl-2-pyrrolidone, N,N-dimethylformamide, N,N-diethylformamide, N,N-dimethylacetamide, N,N-dimethylpropionamide, N,N-dimethylisobutyramide, N,N-dimethyl-3-methoxypropionamide, N,N-dimethyl-3-butoxypropionamide, 1,3-dimethyl-2-imidazolidinone, 1,3-diethyl-2-imidazolidinone, N,N'-dimethylpropyleneurea, 1,1,3,3-tetramethylurea, and 1,1,3,3-tetraethylurea.

The total content of the specific nitrogen-containing compounds in the total solid content of the photosensitive composition is preferably 0.030% by mass or more, more preferably 0.050% by mass or more, still more preferably 0.070% by mass or more, and particularly preferably 0.10% by mass or more. On the other hand, the total content of the specific nitrogen-containing compounds is preferably 4.0% by mass or less, more preferably 3.5% by mass or less, and still more preferably 3.0% by mass or less. Furthermore, from the viewpoint of improving the migration resistance, the total content thereof is preferably 2.5% by mass or less, more preferably 2.0% by mass or less, still more preferably 1.5% by mass or less, even more preferably 1.0% by mass or less, particularly preferably 0.70% by mass or less, and most preferably 0.50% by mass or less.

Since the specific nitrogen-containing compound traps metal impurities, ion impurities, and the like that

adversely affect electrical insulation property due to the nitrogen-containing structure having the unshared electron pairs, it is presumed that ion migration and electromigration are suppressed to improve the migration resistance.

<Content of specific metal element>

From the viewpoint of improving the mechanical properties in heating at a low temperature and improving the migration resistance, it is preferable that the photosensitive composition of the present invention further contains one or more selected from the group consisting of a component containing a sodium element, a component containing a potassium element, a component containing a magnesium element, a component containing a calcium element, a component containing an iron element, a component containing a copper element, and a component containing a chromium element (hereinafter, referred to as "component containing a specific metal element") and satisfies the following condition (5).

(5) A total content of the sodium element, the potassium element, the magnesium element, the calcium element, the iron element, the copper element, and the chromium element (hereinafter, referred to as "specific metal element") in the total solid content of the photosensitive composition is 0.010 ppm by mass to 500 ppm by mass.

When the photosensitive composition of the present invention contains one or more selected from the group consisting of the specific nitrogen-containing compounds and satisfies the condition (4), it is more preferable, from the viewpoint of improving the mechanical properties in heating at a low temperature and improving the migration resistance, that the photosensitive composition of the present invention further contains one or more selected from the group consisting of the components containing a specific metal element and satisfies the condition (5).

The components containing a specific metal element is preferably a halide, an oxide, a nitride, a hydroxide, a sulfide, a carbide, an oxynitride, a carboxylate, a phosphate, a carbonate, a sulfate, a nitrate, or a metasilicate of the specific metal elements.

The total content of the specific metal elements in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific metal elements is preferably 300 ppm by mass or less, more preferably 200 ppm by mass or less, and still more preferably 100 ppm by mass or less. Further, the total content is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less, from the viewpoint of improving the mechanical properties in heating at a low temperature and improving the migration resistance.

Since the specific metal element described above traps metal impurities, ion impurities, and the like that adversely affect electrical insulation property due to positive charges of the metal element, it is presumed that ion migration and electromigration are suppressed to improve the migration resistance. In the photosensitive composition of the present invention, it is presumed that a metal complex is formed by intentionally containing a small amount of a specific metal element in the presence of a specific nitrogen-containing compound. The formed metal complex is considered to function as a catalyst that promotes a cross-linking reaction on an aromatic ring, a ring-closing reaction of a resin, or a cross-linking reaction in a resin having a silanol group, such as polysiloxane, in a resin having an aromatic ring, such as polyimide, polybenzoxazole, or a precursor thereof. As a result, since the cross-linking reaction and the ring-closing reaction efficiently proceed, it is considered that excellent mechanical properties are achieved even in heating at a low temperature. In addition, the formed metal complex efficiently traps metal impurities, ion impurities, and the like that adversely affect electrical insulation property due to positive charges of metal elements and a nitrogen-containing structure, and thus the migration resistance is presumed to be improved.

<Content of specific carboxylic acid>

From the viewpoint of improving the migration resistance, it is preferable that the photosensitive composition of the present invention contains one or more selected from the group consisting of acetic acid, propionic acid, cyclopentanecarboxylic acid, cyclohexanecarboxylic acid, benzoic acid, methylbenzoic acid, and trimethylbenzoic acid and satisfies a condition (6) described below, and/or contains an aldoxime compound and/or ketoxime compound described below and satisfies a condition (7) described later.

(6) A total content of acetic acid, propionic acid, cyclopentanecarboxylic acid, cyclohexanecarboxylic acid, benzoic acid, methylbenzoic acid, and trimethylbenzoic acid (hereinafter, referred to as "specific carboxylic acid") in the total solid content of the photosensitive composition is 0.010 to 500 ppm by mass.

As described above, it is preferable that the photosensitive composition of the present invention further contains one or more selected from the group consisting of the specific carboxylic acids and satisfies the condition (6). When the photosensitizer (C) contains the oxime ester-based compound (C1-1) and/or the phosphine oxide-based compound (C1-2), it is preferable, from the viewpoint of improving the migration resistance, that the photosensitive composition of the

present invention further contains one or more selected from the group consisting of the specific carboxylic acids and satisfies the condition (6).

The total content of the specific carboxylic acids in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific carboxylic acids is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

It is considered that the specific carboxylic acid traps metal impurities, ion impurities, and the like that adversely affect electrical insulation property due to the acidity or negative charge of the carboxy group. In addition, since a specific carboxylic acid traps moisture in the cured product, it is presumed that ion migration and electromigration are suppressed and the migration resistance is improved. In the photosensitive composition of the present invention, it is considered that the polarization structure and charge balance in the cured product are controlled by controlling the content of a specific carboxylic acid within a specific range in the presence of the oxime ester-based compound (C1-1) and/or the phosphine oxide-based compound (C1-2). As a result, metal impurities, ion impurities, and the like that adversely affect electrical insulation property are efficiently trapped, and therefore the migration resistance is presumed to be improved. Such an effect is more remarkable when the photosensitive composition of the present invention contains the oxime ester-based compound (C1-1).

<Content of specific oxime compound>

As described above, from the viewpoint of improving the migration resistance, it is preferable that the photosensitive composition of the present invention further contains an aldoxime compound and/or a ketoxime compound and satisfies the following condition (7):

(7) a total content of the aldoxime compound and the ketoxime compound (hereinafter, referred to as "specific oxime compound") in the total solid content of the photosensitive composition is 0.010 to 500 ppm by mass.

When the photosensitizer (C) contains the oxime ester-based compound (C1-1) and/or the phosphine oxide-based compound (C1-2), it is preferable, from the viewpoint of improving the migration resistance, that the photosensitive composition of the present invention further contains the aldoxime compound and/or the ketoxime compound and satisfies the condition (7).

The total content of the specific oxime compounds in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific oxime compounds is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

It is considered that the specific oxime compound traps metal impurities, ion impurities, and the like that adversely affect electrical insulation property due to the acidity or negative charge of the oxime group. In addition, since a specific oxime compound traps moisture in the cured product, it is presumed that ion migration and electromigration are suppressed and the migration resistance is improved. In the photosensitive composition of the present invention, it is considered that the polarization structure and charge balance in the cured product are controlled by controlling the content of a specific oxime compound within a specific range in the presence of the oxime ester-based compound (C1-1) and/or the phosphine oxide-based compound (C1-2). As a result, metal impurities, ion impurities, and the like that adversely affect electrical insulation property are efficiently trapped, and therefore the migration resistance is presumed to be improved. Such an effect is more remarkable when the photosensitive composition of the present invention contains the oxime ester-based compound (C1-1).

<Content of chlorine element, bromine element, and sulfur element>

From the viewpoint of improving the migration resistance, it is preferable that the photosensitive composition of the present invention further contains one or more selected from the group consisting of a component containing a chlorine element, a component containing a bromine element, and a component containing a sulfur element and satisfies a condition (8) and/or condition (9) described below, and/or further contains water and satisfies a condition (10) described later.

(8) A total content of the chlorine element and the bromine element in the total solid content of the photosensitive composition is 0.010 to 500 ppm by mass.

(9) A content of the sulfur element in the total solid content of the photosensitive composition is 0.010 to 500 ppm by mass.

As described above, it is preferable that the photosensitive composition of the present invention further contains one or more selected from the group consisting of a component containing a chlorine element, a component containing a bromine element, and a component containing a sulfur element and satisfies the condition (8) and/or the condition (9). When the photosensitive composition of the present invention contains one or more selected from the group consisting of specific carboxylic acids and satisfies the condition (6), or when the photosensitive composition of the present invention contains one or more selected from the group consisting of specific oxime compounds and satisfies the condition (7), it is more preferable, from the viewpoint of improving the migration resistance, that the photosensitive composition of the present invention further contains one or more selected from the group consisting of a component containing a chlorine element, a component containing a bromine element, and a component containing a sulfur element and satisfies the condition (8) and/or the condition (9).

The component containing a chlorine element and the component containing a bromine element are preferably an alkyl chloride compound, a cycloalkyl chloride compound, an aryl chloride compound, an alkyl bromide compound, a cycloalkyl bromide compound, or an aryl bromide compound. The component containing a sulfur element is preferably a thiol compound, a sulfide compound, a disulfide compound, a sulfoxide compound, a sulfone compound, a sultone compound, or a thiophene compound.

The total content of the chlorine element and the bromine element in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the chlorine element and the bromine element is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The content of the sulfur element in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the content of the sulfur element is preferably 300 ppm by mass or less, more preferably 200 ppm by mass or less, and still more preferably 100 ppm by mass or less. Furthermore, from the viewpoint of improving the migration resistance, the content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

It is presumed that the chlorine element, the bromine element, and the sulfur element trap metal impurities, ion impurities, and the like that adversely affect electrical insulation property due to unshared electron pairs or a 3d orbital that is an empty atomic orbital and thus ion migration and electromigration are suppressed to improve the migration resistance. In the photosensitive composition of the present invention, it is considered that the polarization structure and charge balance in the cured product are controlled by intentionally containing a small amount of these elements in the presence of a small amount of a specific carboxylic acid and/or a small amount of a specific oxime compound. In addition, containing a small amount of these elements improves the storage stability of the oxime ester-based compound (C1-1) and/or the phosphine oxide-based compound (C1-2), and thus it is suitable for controlling the content of the specific carboxylic acid and the content of the specific oxime compound. These effects allow metal impurities, ion impurities, and the like that adversely affect electrical insulation property to be efficiently trapped, and thus it is presumed that the migration resistance is improved.

As an example, when the total content of the specific organic acids in the total solid content of the photosensitive composition is 100 ppm by mass and the content of the sulfur element in the total solid content of the photosensitive composition is 100 ppm by mass, the conditions (1x) and (9) are satisfied.

As another example, when the total content of the specific organic acids in the total solid content of the photosensitive composition is 600 ppm by mass and the content of the sulfur element in the total solid content of the photosensitive composition is 600 ppm by mass, the condition (1x) is satisfied.

As another example, when the total content of the specific organic acids in the total solid content of the photosensitive composition is 100 ppm by mass and the content of the sulfur element in the total solid content of the photosensitive composition is 50 ppm by mass, the conditions (1x) and (9) are satisfied.

<Content of water>

As described above, from the viewpoint of improving the migration resistance, it is preferable that the photosensitive composition of the present invention further contains water and satisfies the following condition (10):
(10) a content of water in the photosensitive composition is 0.010 to 3.0% by mass.

When the photosensitive composition of the present invention contains one or more selected from the group consisting of specific carboxylic acids and satisfies the condition (6), or when the photosensitive composition of the present invention contains one or more selected from the group consisting of specific oxime compounds and satisfies the condition (7), it is more preferable, from the viewpoint of improving the migration resistance, that the photosensitive composition of the present invention further contains water and satisfies the condition (10):
(10) a content of water in the photosensitive composition is 0.010 to 3.0% by mass.

The content of water in the photosensitive composition is preferably 0.030% by mass or more, more preferably 0.050% by mass or more, still more preferably 0.070% by mass or more, and particularly preferably 0.10% by mass or more. On the other hand, the content of water is preferably 2.5% by mass or less, more preferably 2.2% by mass or less, and still more preferably 2.0% by mass or less. Furthermore, from the viewpoint of improving the migration resistance, the content thereof is preferably 1.7% by mass or less, more preferably 1.5% by mass or less, still more preferably 1.2% by mass or less, even more preferably 1.0% by mass or less, particularly preferably 0.70% by mass or less, and most preferably 0.50% by mass or less.

Since the water traps metal impurities, ion impurities, and the like that adversely affect electrical insulation property due to an interaction such as a dipole moment of water molecules, hydrogen bonding, and the like, it is presumed that ion migration and electromigration are suppressed to improve the migration resistance. In the photosensitive composition of the present invention, it is considered that the polarization structure and charge balance in the cured product are controlled by setting the content of water within a specific range in the presence of a small amount of a specific carboxylic acid and/or a small amount of a specific oxime compound. In addition, setting the content of water within a specific range improves the storage stability of the oxime ester-based compound (C1-1) and/or the phosphine oxide-based compound (C1-2), and thus it is suitable for controlling the content of the specific carboxylic acid and the content of the specific oxime compound. These effects allow metal impurities, ion impurities, and the like that adversely affect electrical insulation property to be efficiently trapped, and thus it is presumed that the migration resistance is improved.

<Content of fluorine element>

From the viewpoint of suppressing presence of residues post-development and improving the migration resistance, the photosensitive composition of the present invention preferably further satisfies the following condition (1$\alpha$):
(1$\alpha$) a content of the fluorine element in the total solid content of the photosensitive composition is 1,000 ppm by mass or less.

From the viewpoint of the effects of the invention described above, the content of the fluorine element in the total solid content of the photosensitive composition is preferably 0 ppm by mass or more, more preferably 0.010 ppm by mass or more, still more preferably 0.030 ppm by mass or more, even more preferably 0.050 ppm by mass or more, particularly preferably 0.070 ppm by mass or more, and most preferably 0.10 ppm by mass or more. On the other hand, from the viewpoint of the effects of the invention described above, the content of the fluorine element is preferably 1,000 ppm by mass or less, more preferably 500 ppm by mass or less, still more preferably 300 ppm by mass or less, and particularly preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.

When the photosensitive composition of the present invention satisfies the condition ($\alpha$) and the specific organic acid contains a fluorine atom in the structure, from the viewpoint of the effects of the invention described above, it is preferable that the condition (1$\alpha$) is further satisfied. When the photosensitive composition of the present invention satisfies the condition ($\beta$) and the compound containing a specific anion contains a fluoride ion, from the viewpoint of the effects of the invention described above, it is preferable that the condition (1$\alpha$) is further satisfied.

The content of the fluorine element in the total solid content of the photosensitive composition may be 0 ppm by mass. When the content of the fluorine element in the total solid content of the photosensitive composition is more than 0 ppm by mass, it is preferable, in the photosensitive composition of the present invention, that the binder resin (A), the photosensitizer (C), the compound (B), or the cross-linking agent (F) has a fluorine atom in the structure, or a component containing a fluorine element is further contained.

The component containing a fluorine element is preferably a phenol compound having a substituent containing an alkyl fluoride group, an alkyl fluoride compound, a cycloalkyl fluoride compound, or an aryl fluoride compound. Note that the components containing a fluorine element are compounds different from the specific organic acids described above and the compounds containing the specific anion described above.

When the content of the compound containing a fluorine atom or the component containing a fluorine element in the structure of the photosensitive composition is set to a specific value or less, the content of the fluorine element in these components or the anion containing the fluorine element derived from these components is the specific value or less, and therefore it is presumed that protons in the photosensitive composition are locally activated by an interaction such as hydrogen bonding or the like of each component in the photosensitive composition. Therefore, it is considered that the effect of suppressing presence of residues post-development becomes remarkable by the dissolution promoting action on the developer. It is considered that the polarization structure and charge balance in the cured product are controlled by intentionally setting the content of the above-described components to a specific value or less. As a result, ion migration and electromigration caused by metal impurities and ion impurities that adversely affect electrical insulation property is suppressed, and thus the migration resistance is presumed to be improved.

<Photosensitive composition coating and photosensitive composition film of the present invention>

The photosensitive composition coating of the present invention is in a semi-cured state (stage B) on which a film of the photosensitive composition of the present invention is formed. The semi-cured state refers to a state in which a cross-linked structure is not formed, or a cross-linked structure is formed by a partial reaction, but the film has fluidity, or a state thereof. Examples thereof include a state in which a coating film is applied to a substrate or the like and then dried under reduced pressure to distill off a solvent, and a state in which a coating film is heated at 40°C to 150°C and dried, and this state refers to a state in which the coating film is soluble in an alkaline solution or an organic solvent. The photosensitive composition film of the present invention preferably has a photosensitive composition coating and a support on which the film of the photosensitive composition of the present invention is formed. Such a configuration is suitable from the viewpoint of handleability. The photosensitive composition film has positive-type or negative-type photosensitivity. The photosensitive composition film is also preferably capable of forming a self-standing film as a single film. The photosensitive composition film preferably has adhesion property, and is also preferably joined with a plurality of members. The phrase "capable of forming a self-standing film as a single film" means that a film having a width of 1.5 cm or more, a length of 5.0 cm or more, and a thickness of 5.0 μm or more can be formed without a support. That is, the photosensitive composition film is also preferably a photosensitive composition coating capable of forming a self-standing film as a single film.

Since the photosensitive composition film of the present invention has positive-type or negative-type photosensitivity, a positive-type or negative-type pattern can be formed by performing development with an alkaline developer or an organic solvent after patterning exposure. The photosensitive composition film of the present invention is suitable for pattern formation on a substrate having an irregularity structure, formation of a hollow structure, or a dry film resist.

The support is preferably a flexible substrate from the viewpoint of improvement in adhesion property to the photosensitive film of the present invention, flexibility, and handleability. The flexible substrate is preferably a polyimide substrate, a polyphenylene sulfide substrate, a silicone substrate, an acrylic resin substrate, an epoxy resin substrate, a polyethylene terephthalate substrate, a polybutylene terephthalate substrate, a polyethylene naphthalate substrate, or a polycarbonate substrate. The support may be a rigid substrate. Examples of the rigid substrate include a glass substrate, a quartz substrate, a crystal substrate, and a sapphire substrate. The surface of the support on the photosensitive film side of the present invention may be subjected to a surface treatment with a silane coupling agent or the like from the viewpoint of improving adhesion property to the film and improving peelability. The thickness of the support is preferably 10 to 200 μm from the viewpoint of handleability.

<Cured product of photosensitive composition of the present invention>

The cured product of the present invention is an object obtained by curing the photosensitive composition of the present invention. Curing means that a cross-linked structure is formed by a reaction, and the fluidity of the film is lost, or a state thereof. The reaction is not particularly limited, and is caused, for example, by heating, irradiation with an energy ray, or the like, but is preferably caused by heating. A state in which a cross-linked structure is formed by heating and the fluidity of the film is lost is referred to as thermal curing.

The heating condition is, for example, a condition of heating at 150°C to 500°C for 5.0 to 300 minutes. Examples of the heating method include a method for heating using an oven, a hot plate, infrared rays, a flash annealing device, or a laser annealing device. Examples of the treatment atmosphere include an air, oxygen, nitrogen, helium, neon, argon, krypton, or xenon atmosphere, a gas atmosphere containing less than 1.0 to 10,000 ppm by mass (0.00010 to 1.0% by mass) of oxygen, a gas atmosphere containing 10,000 ppm by mass (1.0% by mass) or more of oxygen, and a vacuum atmosphere.

The cured product of the present invention may be an object obtained by curing the photosensitive film of the present invention. Curing means that a cross-linked structure is formed by a reaction, and the fluidity of the film is lost, or a state thereof. Here, the reaction is as described above. Examples and preferred descriptions concerning the heating

conditions are as described above.

From the viewpoint of improving the light-shielding property and reliability, the optical density per 1 μm of film thickness of the cured product of the present invention at a wavelength of visible light (380 to 780 nm) is preferably 0.20 or more, more preferably 0.30 or more, still more preferably 0.50 or more, and particularly preferably 1.0 or more. On the other hand, from the viewpoint of improving the sensitivity for exposure and reliability, the optical density is preferably 3.0 or less, more preferably 2.0 or less, still more preferably 1.7 or less, and even more preferably 1.5 or less. The optical density is preferably an optical density in a cured product obtained by heating and curing the composition. When the optical density is in the above ranges, incident external light can be shielded, so that the effect of suppressing external light reflection becomes remarkable. In addition, photodegradation of the cured product itself and the layer on the inner side thereof is suppressed, so that the effect of improving reliability becomes remarkable.

From the viewpoint of improving reliability, the dielectric loss tangent of the cured product of the present invention at a frequency of 1 GHz is preferably 0.00010 or more, more preferably 0.00030 or more, and still more preferably 0.00050 or more. On the other hand, from the viewpoint of low transmission loss, the dielectric loss tangent is preferably 0.0100 or less, more preferably 0.0050 or less, still more preferably 0.0030 or less, and particularly preferably 0.0010 or less. The preferred ranges of the dielectric loss tangent of the cured product of the present invention at frequencies of 10 GHz, 30 GHz, and 70 GHz are also the same as those described above. Note that the dielectric loss tangent is a value measured by a resonator method using a split-post dielectric resonator (SPDR).

It is preferable that a dielectric constant at a frequency of 1 GHz of the cured product of the present invention is 3.5 or less and/or a water absorption of the cured product of the present invention is 1.5% by mass or less.

The dielectric constant is preferably 2.0 or more, more preferably 2.3 or more, and still more preferably 2.5 or more. On the other hand, the dielectric constant is preferably 3.5 or less, more preferably 3.0 or less, still more preferably 2.9 or less, and particularly preferably 2.7 or less. The preferred ranges of the dielectric constants of the cured product of the present invention at frequencies of 10 GHz, 30 GHz, and 70 GHz are also the same as those described above.

The water absorption is preferably 0.10% by mass or more, and more preferably 0.30% by mass or more. On the other hand, the water absorption is preferably 2.0% by mass or less, more preferably 1.5% by mass or less, still more preferably 1.0% by mass or less, even more preferably 0.70% by mass or less, and particularly preferably 0.50% by mass or less.

<Element and article including cured product>

The element of the present invention includes the cured product of the present invention. In addition, the article of the present invention includes the cured product of the present invention. Examples of the article include an electronic component, an electronic device, a moving body, a building, and a window. Examples of the electronic component include a semiconductor device, an antenna, a display device, a metal-clad laminate, a wiring board, a semiconductor package, an active component including a semiconductor device, and a passive component including a semiconductor device. Examples of the semiconductor device include a transistor, a diode, an integrated circuit, a processor, and a memory. Examples of the passive component include a resistor, a capacitor, and an inductor. Examples of the electronic device include an industrial device, a medical device, and a building device. Examples of the moving body include a vehicle, a railway, an airplane, and a heavy machine. Examples of the building include a house, a store, an office, a building, and a factory. Examples of the window include an electronic device window, a moving body window, and a building window.

The photosensitive composition of the present invention is preferably used for formation of an electronic component. The photosensitive composition of the present invention is also preferably used for formation of one or more selected from the group consisting of a semiconductor device, an antenna, a display device, and a metal-clad laminate.

Examples of the semiconductor device include a semiconductor device having a fan-out wafer level package structure, a fan-out panel level package structure, or an antenna-in-package structure. Examples of the antenna include a microstrip line antenna, a strip line antenna, a coplanar line antenna, and a grounded coplanar line (Conductor Back Coplanar; CBC) antenna, a substrate integrated waveguide (SIW) antenna, a post wall waveguide (PWW) antenna, a parallel bilinear line (Coplanar Strip; CPS) antenna or a slot line antenna. Examples of the display device include an organic EL display, a quantum dot display, a micro light emitting diode (hereinafter, referred to as "LED") display, a mini LED display, and a liquid crystal display. Examples of the metal-clad laminate include a printed circuit board.

The electronic component of the present invention includes the cured product of the present invention. The cured product of the present invention can have both excellent mechanical properties even in heating at a low temperature and high migration resistance. Therefore, the photosensitive composition of the present invention is preferably used for forming an insulation layer of a metal wiring, a protective layer of a metal wiring, or an interlayer insulation layer of a metal wiring in an electronic component.

A semiconductor device, an antenna, a display device, and a metal-clad laminate in the present invention include the cured product of the present invention. For the same reason as described above, the photosensitive composition of the

present invention is also preferably used for forming an interlayer insulation layer of rewiring in a semiconductor device, is also preferably used for forming an insulation layer of metal wiring in an antenna, a protective layer of metal wiring, or an interlayer insulation layer of metal wiring and ground wiring, is also preferably used for forming a pixel defining layer, a planarization layer of TFT, a protective layer of TFT, an interlayer insulation layer of TFT, or a gate insulation layer in an organic EL display, a quantum dot display, or a microLED display, and is also preferably used for forming an insulation layer of metal wiring in a metal-clad laminate, a protective layer of metal wiring, or a solder resist layer of metal wiring.

Application Example in which the cured product of the present invention is used to a semiconductor device having a bump will be described with reference to the drawing. Fig. 1 is a schematic sectional view illustrating an enlarged section of a pad portion of a semiconductor device having a bump. On an Al pad 2 for input and output formed on a Si wafer 1, a passivation layer 3 is formed, and a via hole is formed in the passivation layer 3. On the passivation layer 3, an insulation layer 4 which is a patterned cured product of the present invention is formed, a metal layer 5 made of Cr, Ti or the like is formed so as to be connected to the Al pad 2, and a metal wiring 6 made of Al, Cu, or the like is formed by electrolytic plating or the like. By etching the metal layer 5 around a solder bump 10, insulation is established between the pads. A barrier metal layer 8 and the solder bump 10 are formed for the insulated pad. The insulation layer 7 is a cured product of a patterned photosensitive composition, and is preferably the cured product of the present invention. The photosensitive composition for forming the insulation layer 7 can form a pattern with a thick film in formation of a scribe line 9. When the insulation layer 4 and/or the insulation layer 7 is the cured product of the present invention, since the mechanical properties are excellent in heating at a low temperature, warpage of the wafer is suppressed, and the effect of improving the accuracy of processes such as exposure and conveyance of the wafer becomes remarkable. In addition, since the stress of the sealing resin at the time of mounting the semiconductor can be alleviated, the damage of a low-k layer is suppressed, and the effect of improving the reliability of the semiconductor device becomes remarkable.

<Hollow structure>

A hollow structure of the present invention includes the cured product of the present invention. The electronic component of the present invention preferably has the hollow structure of the present invention. The hollow structure of the present invention includes a hollow structure support member and a hollow structure roof member. The hollow structure support member and the hollow structure roof member are preferably the cured product of the present invention. The hollow structure support member and the hollow structure roof member preferably contain the polyimide-based resin from the viewpoint of improving the heat resistance and the reliability. The film thickness of the hollow structure support member is preferably 5 to 20 $\mu$m. The film thickness of the hollow structure roof member is preferably 10 to 50 $\mu$m.

The photosensitive composition of the present invention is preferably used for forming a hollow structure, and more preferably used for forming a hollow structure support member and/or a hollow structure roof member. The photosensitive film of the present invention is more suitable for forming a hollow structure, further suitable for forming a hollow structure support member and/or a hollow structure roof member, and particularly suitable for forming a hollow structure roof member. Examples of the electronic component having a hollow structure include micro electro mechanical systems (MEMS). Examples of the MEMS include a sensor, a noise filter, a surface acoustic wave (SAW) filter, and a bulk acoustic wave (BAW) filter.

<Electronic component>

Hereinafter, the electronic component of the present invention will be described. However, the present invention is not limited to the following embodiments, and obviously, various modifications can be made without departing from the scope of the invention as long as the object of the invention can be achieved.

The electronic component of the present invention has the configuration of [20] above. With the above configuration, the present invention can provide an electronic component excellent in migration resistance. It is considered that the polarization structure and charge balance in the cured product of the photosensitive composition are controlled by intentionally containing a small amount of these specific aromatic compound, specific anion, or specific organic acid in the cured product of the photosensitive composition. In addition, aromatic rings in a resin such as polyimide, polybenzoxazole, and precursors thereof, and silanol groups in a resin such as polysiloxane are also considered to contribute to control of the polarization structure and charge balance. Accordingly, it is presumed that the effect of excellent migration resistance is achieved by suppressing ion migration and electromigration caused by metal impurities and ion impurities that adversely affect electrical insulation property. It is also presumed that, by suppressing migration and aggregation of the metal in the wiring, the effect of high reliability in the electronic component, the semiconductor device, the display device, and the metal-clad laminate is achieved.

<Resin and compound in cured product>

The electronic component of the present invention includes the cured product. The cured product in the electronic component of the present invention is preferably a cured product of a photosensitive composition, more preferably a cured product of a photosensitive composition containing a binder resin and a photosensitizer, and still more preferably a cured product of a photosensitive composition containing a binder resin and a photosensitizer and further containing a radical polymerizable compound and/or a cross-linking agent. The binder resin is preferably the binder resin (A) described above. The photosensitizer is preferably the photosensitizer (C) described above, and more preferably the photopolymerization initiator (C1) described above. The radical polymerizable compound is preferably the compound (B) described above. The cross-linking agent is preferably the cross-linking agent (F) described above. Examples and preferred descriptions regarding the binder resin (A), the photosensitizer (C), the compound (B), and the cross-linking agent (F) are as described above.

The cured product in the electronic component of the present invention is also preferably a cured product of a photosensitive composition containing one or more selected from the group consisting of a colorant, a dispersant, and inorganic particles. The colorant is preferably the colorant (D) described above. The dispersant is preferably the dispersant (E) described above. The inorganic particles are preferably the inorganic particles (G) described above. Examples and preferred descriptions concerning the colorant (D), the dispersant (E), and the inorganic particles (G) are as described above.

The cured product in the electronic component of the present invention contains a resin (XA1) and/or resin (XA2) described below. In addition, the cured product in the electronic component of the present invention preferably further contains a resin (XA3) described below.

Resin (XA1): A resin that contains, in structural units in a resin main chain, one or more selected from the group consisting of an imide structure, an amide structure, an oxazole structure, and a siloxane structure

Resin (XA2): A resin having a phenolic hydroxyl group in the structural units in the resin main chain
Resin (XA3): A resin having a radical polymerizable group

The resin (XA1) in the cured product is preferably a resin having a structure derived from the resin (A1) described above. The resin (XA2) in the cured product is preferably a resin having a structure derived from the resin (A2) described above. The resin (XA3) in the cured product is preferably a resin having a structure derived from the resin (A3) described above. Examples and preferable descriptions concerning the resin (XA1), the resin (XA2), and the resin (XA3) in the cured product are as in the examples and preferable descriptions concerning the resin (A1), the resin (A2), and the resin (A3) described above.

From the viewpoint of improving the migration resistance, the cured product in the electronic component of the present invention preferably contains the resin (A1), more preferably contains the resin (A1) and the resin (A2), and also preferably further contains the resin (A3). From the viewpoint of improving the migration resistance, the cured product in the electronic component of the present invention further preferably contains the resin (A1), the resin (A2), and the resin (A3).

In the resin (A1), the imide structure, the amide structure, the oxazole structure, or the siloxane structure in the structural units in the resin main chain traps metal impurities, ion impurities, or the like that adversely affect electrical insulation property, and thus it is presumed that ion migration and electromigration are suppressed to improve the migration resistance.

The resin (XA1) preferably contains one or more structural units selected from the group consisting of General Formulae (1), (2), (3), (4), (5), (6), (9), and (10) described above. The resin (XA2) preferably contains one or more structural units selected from the group consisting of General Formulae (31), (32), (33), (34), (35), (36), (38), (39), and (40) described above. It is also preferable that some of the phenolic hydroxyl groups contained in these resins react with other resins or compounds to form a cross-linked structure.

<Contents of specific aromatic compound, specific anion, and specific organic acid>

The cured product in the electronic component of the present invention satisfies one or more selected from the group consisting of conditions ($X\alpha$), ($X\beta$), and ($X\gamma$) described below. In addition, the cured product in the electronic component of the present invention preferably satisfies the following condition ($X\alpha$).

($X\alpha$) One or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (X1x) is satisfied:
(X1x) a total content of the sulfonic acids, the phosphate esters, the phosphonic acids, the phosphonate esters, the phosphite esters, the phosphinic acids, the hypophosphite esters, and the carboxylic acids containing a fluorine element in

the cured product is 0.010 to 1,000 ppm by mass.

(Xβ) One or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (X2x) is satisfied:

(X2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the cured product is 0.010 to 1,000 ppm by mass.

(Xγ) One or more selected from the group consisting of benzene, toluene, xylene, and naphthalene is/are contained, and the following condition (X3) is satisfied:

(X3) a total content of the benzene, the toluene, the xylene, and the naphthalene in the cured product is 0.010 to 1,000 ppm by mass.

When the condition (Xβ) is satisfied, the cured product in the electronic component of the present invention preferably further contains a compound containing a specific anion. When the cured product in the electronic component of the present invention contains a compound containing a specific anion, the cured product preferably further contains an ammonium ion, a primary ammonium ion, a secondary ammonium ion, a tertiary ammonium ion, or a quaternary ammonium ion as a cationic species.

The above-described phosphate ester, phosphonic acid, phosphonate ester, phosphite ester, phosphinic acid, and hypophosphite ester are preferably phosphate monoester, phosphate diester, phosphonic acid, phosphonate monoester, phosphite monoester, phosphite diester, phosphonic acid, or hypophosphite monoester.

The specific organic acids described above preferably have one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms.

From the viewpoint of improving the migration resistance, the cured product in the electronic component of the present invention preferably satisfies two or more selected from the group consisting of the condition (Xα), the condition (Xβ), and the condition (Xγ). From the viewpoint of improving the migration resistance, it is more preferable that the cured product in the electronic component of the present invention satisfies the condition (Xα) and further satisfies the condition (β) and/or the condition (γ). From the viewpoint of improving the migration resistance, it is more preferable that the cured product in the electronic component of the present invention satisfies the condition (Xγ) and further satisfies the condition (Xα) and/or the condition (Xβ).

The total content of the specific aromatic compounds in the cured product is preferably 0.030 ppm by mass or more, more preferably 0.050 ppm by mass or more, still more preferably 0.070 ppm by mass or more, and particularly preferably 0.10 ppm by mass or more. On the other hand, the total content of the specific aromatic compounds is preferably 500 ppm by mass or less, more preferably 300 ppm by mass or less, and still more preferably 100 ppm by mass or less. Furthermore, from the viewpoint of improving the migration resistance, the content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The total content of the specific anions in the cured product is preferably 0.030 ppm by mass or more, more preferably 0.050 ppm by mass or more, still more preferably 0.070 ppm by mass or more, and particularly preferably 0.10 ppm by mass or more. On the other hand, the total content of the specific anions is preferably 500 ppm by mass or less, more preferably 300 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The total content of the specific organic acids in the cured product is preferably 0.030 ppm by mass or more, more preferably 0.050 ppm by mass or more, still more preferably 0.070 ppm by mass or more, and particularly preferably 0.10 ppm by mass or more. On the other hand, the total content of the specific organic acids is preferably 500 ppm by mass or less, more preferably 300 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

When the condition (Xα) is satisfied, the cured product in the electronic component of the present invention preferably contains a sulfonic acid and/or a carboxylic acid containing a fluorine element, and more preferably contains a sulfonic acid. The total content ratio of the sulfonic acid and/or the carboxylic acid containing a fluorine element to the total of the specific organic acids is preferably 50% by mass or more, and more preferably 60% by mass or more. On the other hand, the total content ratio of the sulfonic acid and/or the carboxylic acid containing a fluorine element is preferably 100% by mass or less, more preferably 90% by mass or less, and still more preferably 80% by mass or less. In addition, the

content ratios of the sulfonic acids are more preferably the content ratios described above.

When the condition (Xβ) is satisfied, the cured product in the electronic component of the present invention preferably contains one or more selected from the group consisting of a phosphate ion, a phosphite ion, a hypophosphite ion, a formate ion, and a fluoride ion, and more preferably contains one or more selected from the group consisting of a phosphate ion, a phosphite ion, and a hypophosphite ion. The total content ratio of the phosphate ion, the phosphite ion, the hypophosphite ion, the formate ion, and the fluoride ion in the total of the specific anions is preferably 50% by mass or more, and more preferably 60% by mass or more. On the other hand, the total content ratio of the phosphate ion, the phosphite ion, the hypophosphite ion, the formate ion, and the fluoride ion is preferably 100% by mass or less, more preferably 90% by mass or less, and still more preferably 80% by mass or less. In addition, the total content ratios of the phosphate ion, the phosphite ion, and the hypophosphite ion are more preferably the content ratios described above.

When the condition (Xγ) is satisfied, the cured product in the electronic component of the present invention preferably contains one or more selected from the group consisting of benzene, toluene, and xylene, and more preferably contains benzene and/or toluene. The total content ratio of the benzene, the toluene, and the xylene in the total of the specific aromatic compounds is preferably 50% by mass or more, more preferably 60% by mass or more. On the other hand, the total content ratio of the benzene, the toluene, and the xylene is preferably 100% by mass or less, more preferably 90% by mass or less, and still more preferably 80% by mass or less. In addition, the total content ratios of the benzene and the toluene are more preferably the content ratios described above.

From the viewpoint of improving the migration resistance, it is more preferable, in the cured product in the electronic component of the present invention, that the condition (Xβ) is a condition (Xβ2) described below and the condition (Xα) and/or the following condition (Xβ2) are/is satisfied:

(Xβ2) one or more selected from the group consisting of a phosphate ion, a phosphite ion, a hypophosphite ion, a formate ion, and a fluoride ion is/are contained, and the following condition (X2y) is satisfied:

(X2y) a total content of the phosphate ion, the phosphite ion, the hypophosphite ion, the formate ion, and the fluoride ion in the total solid content of the cured product is 0.010 to 1,000 ppm by mass.

Preferred ranges of the total contents of the phosphate ion, the phosphite ion, the hypophosphite ion, the formate ion, and the fluoride ion in the cured product are also the same as the contents of the specific anions described above.

From the viewpoint of improving the migration resistance, in the cured product in the electronic component of the present invention, the sulfonic acid, and the phosphate ester, the phosphonic acid, the phosphonate ester, the phosphite ester, the phosphinic acid, and the hypophosphite ester (hereinafter, referred to as "organic acid containing a phosphorus element") have the following specific substituent a,

the carboxylic acid containing a fluorine element has the following specific substituent b, and

the condition (Xα) is a condition (Xα2) described below, and the following condition (Xα2) and/or the condition (Xβ) are/is preferably satisfied, and the following condition (Xα2) is more preferably satisfied.

(Xα2) One or more selected from the group consisting of sulfonic acids having the following specific substituent a, organic acids containing a phosphorus element having the following specific substituent a, and carboxylic acids containing a fluorine element having the following specific substituent b is/are further contained, and the following condition (X1y) is satisfied:

specific substituent a: one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms;

specific substituent b: one or more selected from the group consisting of a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms.

(X1y) A total content of the sulfonic acid having the specific substituent a, the organic acid containing a phosphorus element having the specific substituent a, and the carboxylic acid containing a fluorine element having the specific substituent b in the cured product is 0.010 to 1,000 ppm by mass.

Preferred ranges of the total contents of the sulfonic acid having the specific substituent a, the organic acid containing a phosphorus element having the specific substituent a, and the carboxylic acid containing a fluorine element having the specific substituent b in the cured product are the same as the contents of the specific organic acids described above.

From the viewpoint of improving the migration resistance, it is preferable, in the cured product in the electronic component of the present invention, that the condition (Xα2) is a condition (Xα3) described below and the condition (Xα3)

is satisfied,

the sulfonic acid preferably contains one or more selected from the group consisting of methanesulfonic acid, cyclohexanesulfonic acid, benzenesulfonic acid, toluenesulfonic acid, xylenesulfonic acid, trifluoromethanesulfonic acid, hexafluorocyclohexanesulfonic acid, hexafluorobenzenesulfonic acid, pentafluorotoluenesulfonic acid, tetrafluoroxylenesulfonic acid, trifluoromethylbenzenesulfonic acid, trifluoromethyltoluenesulfonic acid, and trifluoromethylxylenesulfonic acid, and
the carboxylic acid containing a fluorine element preferably contains, from the viewpoint of improving the migration resistance, one or more selected from the group consisting of trifluoroacetic acid, trifluoropropionic acid, hexafluorocyclohexanecarboxylic acid, hexafluorobenzoic acid, and trifluoromethylbenzoic acid.

(X$\alpha$3) A sulfonic acid and/or a carboxylic acid containing a fluorine element is/are further contained, and the following condition (X1z) is satisfied:
(X1z) a total content of the sulfonic acid and the carboxylic acid containing a fluorine element in the product is 0.010 to 1,000 ppm by mass.
Preferred ranges of the total contents of the sulfonic acid and the carboxylic acid containing a fluorine element in the cured product are also the same as the contents of the specific organic acids described above.

<Content of specific nitrogen-containing compound>

When the cured product in the electronic component of the present invention contains the resin (XA1), from the viewpoint of improving the migration resistance, it is preferable that the cured product in the electronic component of the present invention further contains one or more selected from the group consisting of a cyclic amide compound represented by General Formula (20) above, an amide compound represented by General Formula (21) above, a cyclic urea compound represented by General Formula (22) above, a urea compound represented by General Formula (23) above, an oxazolidone compound represented by General Formula (24) above, and an isoxazolidone compound represented by General Formula (25) above and satisfies the following condition (X4). Examples and preferred descriptions concerning the specific nitrogen-containing compounds are as described above.
(X4) A total content of the cyclic amide compound represented by General Formula (20), the amide compound represented by General Formula (21), the cyclic urea compound represented by General Formula (22), the urea compound represented by General Formula (23), the oxazolidone compound represented by General Formula (24), and the isoxazolidone compound represented by General Formula (25) (hereinafter, referred to as "specific nitrogen-containing compounds") in the cured product is 0.010 to 5.0% by mass.
The total content of the specific nitrogen-containing compounds in the cured product is preferably 0.030% by mass or more, more preferably 0.050% by mass or more, still more preferably 0.070% by mass or more, and particularly preferably 0.10% by mass or more. On the other hand, the total content of the specific nitrogen-containing compounds is preferably 4.0% by mass or less, more preferably 3.5% by mass or less, and still more preferably 3.0% by mass or less. Furthermore, from the viewpoint of improving the migration resistance, the total content thereof is preferably 2.5% by mass or less, more preferably 2.0% by mass or less, still more preferably 1.5% by mass or less, even more preferably 1.0% by mass or less, particularly preferably 0.70% by mass or less, and most preferably 0.50% by mass or less.
Since the specific nitrogen-containing compound traps metal impurities, ion impurities, and the like that adversely affect electrical insulation property due to the nitrogen-containing structure having the unshared electron pairs, it is presumed that ion migration and electromigration are suppressed to improve the migration resistance.

<Content of specific metal element>

When the cured product in the electronic component of the present invention contains one or more selected from the group consisting of the specific nitrogen-containing compounds and satisfies the condition (X4), from the viewpoint of improving the mechanical properties in heating at a low temperature and improving the migration resistance, it is preferable that the photosensitive composition of the present invention further contains one or more selected from the group consisting of a component containing a sodium element, a component containing a potassium element, a component containing a magnesium element, a component containing a calcium element, a component containing an iron element, a component containing a copper element, and a component containing a chromium element and satisfies the following condition (X5) :
(X5) a total content of the sodium element, the potassium element, the magnesium element, the calcium element, the iron element, the copper element, and the chromium element (hereinafter, referred to as "specific metal elements") in the cured product is 0.010 to 500 ppm by mass.
The components containing a specific metal element is preferably a halide, an oxide, a nitride, a hydroxide, a

sulfide, a carbide, an oxynitride, a carboxylate, a phosphate, a carbonate, a sulfate, a nitrate, or a metasilicate of the specific metal elements.

The total content of the specific metal elements in the cured product is preferably 0.030 ppm by mass or more, more preferably 0.050 ppm by mass or more, still more preferably 0.070 ppm by mass or more, and particularly preferably 0.10 ppm by mass or more. On the other hand, the total content of the specific metal elements is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

Since the specific metal element described above traps metal impurities, ion impurities, and the like that adversely affect electrical insulation property due to positive charges of the metal element, it is presumed that ion migration and electromigration are suppressed to improve the migration resistance. In the cured product in the electronic component of the present invention, it is presumed that a metal complex is formed by intentionally containing a small amount of a specific metal element in the presence of a specific nitrogen-containing compound. The formed metal complex efficiently traps metal impurities, ion impurities, and the like that adversely affect electrical insulation property due to positive charges of metal elements and a nitrogen-containing structure, and thus the migration resistance is presumed to be improved.

<Content of chlorine element, bromine element, and sulfur element>

From the viewpoint of improving the migration resistance, it is preferable that the cured product in the electronic component of the present invention further contains one or more selected from the group consisting of a component containing a chlorine element, a component containing a bromine element, and a component containing a sulfur element and satisfies the following condition (X8) and/or condition (X9):

(X8) a total content of the chlorine element and the bromine element in the cured product is 0.010 to 500 ppm by mass; and

(X9) a content of the sulfur element in the cured product is 0.010 to 500 ppm by mass.

The component containing a chlorine element and the component containing a bromine element are preferably an alkyl chloride compound, a cycloalkyl chloride compound, an aryl chloride compound, an alkyl bromide compound, a cycloalkyl bromide compound, or an aryl bromide compound. The component containing a sulfur element is preferably a thiol compound, a sulfide compound, a disulfide compound, a sulfoxide compound, a sulfone compound, a sultone compound, or a thiophene compound.

The total content of the chlorine element and the bromine element in the cured product is preferably 0.030 ppm by mass or more, more preferably 0.050 ppm by mass or more, still more preferably 0.070 ppm by mass or more, and particularly preferably 0.10 ppm by mass or more. On the other hand, the total content of the chlorine element and the bromine element is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

The content of the sulfur element in the cured product is preferably 0.030 ppm by mass or more, more preferably 0.050 ppm by mass or more, still more preferably 0.070 ppm by mass or more, and particularly preferably 0.10 ppm by mass or more. On the other hand, the content of the sulfur element is preferably 300 ppm by mass or less, more preferably 200 ppm by mass or less, and still more preferably 100 ppm by mass or less. Furthermore, from the viewpoint of improving the migration resistance, the total content thereof is preferably 50 ppm by mass or less, more preferably 30 ppm by mass or less, still more preferably 10 ppm by mass or less, even more preferably 5.0 ppm by mass or less, particularly preferably 3.0 ppm by mass or less, and most preferably 1.0 ppm by mass or less.

It is presumed that the chlorine element, the bromine element, and the sulfur element trap metal impurities, ion impurities, and the like that adversely affect electrical insulation property due to unshared electron pairs or a 3d orbital that is an empty atomic orbital and thus ion migration and electromigration are suppressed to improve the migration resistance.

<Content of fluorine element>

From the viewpoint of improving the migration resistance, the cured product in the electronic component of the present invention preferably satisfies the following condition (X1$\alpha$):
(X1$\alpha$) a content of the fluorine element in the cured product is 1,000 ppm by mass or less.

From the viewpoint of the effects of the invention described above, the content of the fluorine element in the cured product is preferably 0 ppm by mass or more, more preferably 0.010 ppm by mass or more, still more preferably 0.030 ppm by mass or more, even more preferably 0.050 ppm by mass or more, particularly preferably 0.070 ppm by mass or more, and most preferably 0.10 ppm by mass or more. On the other hand, from the viewpoint of the effects of the invention described above, the content of the fluorine element is preferably 1,000 ppm by mass or less, more preferably 500 ppm by mass or less, still more preferably 300 ppm by mass or less, and particularly preferably 100 ppm by mass or less. Furthermore, the content of the fluorine element is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less.

When the cured product in the electronic component of the present invention satisfies the condition (X$\alpha$) and the specific organic acid described above contains a fluorine atom in the structure, from the viewpoint of the effects of the invention described above, it is preferable that the condition (X1$\alpha$) is further satisfied. When the cured product in the electronic component of the present invention satisfies the condition (X$\beta$) and the compound containing a specific anion contains a fluoride ion, from the viewpoint of the effects of the invention described above, it is preferable that the condition (X1$\alpha$) is further satisfied.

The content of the fluorine element in the cured product may be 0 ppm by mass. When the content of the fluorine element in the cured product is more than 0 ppm by mass, it is preferable that, in the cured product in the electronic component of the present invention, the binder resin in the cured product has a fluorine atom in the structure, or a component containing a fluorine element is further contained.

The component containing a fluorine element is preferably a phenol compound having a substituent containing an alkyl fluoride group, an alkyl fluoride compound, a cycloalkyl fluoride compound, or an aryl fluoride compound. Note that the components containing a fluorine element are compounds different from the specific organic acids described above and the compounds containing the specific anion described above.

It is considered that the polarization structure and charge balance in the cured product are controlled by intentionally setting the content of the fluorine element to a specific value or less. As a result, ion migration and electromigration caused by metal impurities and ion impurities that adversely affect electrical insulation property is suppressed, and thus the migration resistance is presumed to be improved.

<Method for producing cured product>

The method for producing the cured product of the present invention includes the following steps (1) to (4):

(1) a step of forming, on a substrate, a coating film of the photosensitive composition of the present invention;
(2) a step of irradiating the coating film of the photosensitive composition with chemical active rays through a photomask;
(3) a step of forming a pattern of the photosensitive composition by development with a developer; and
(4) a step of heating the pattern to obtain a cured pattern of the photosensitive composition.

In these steps, each method described in paragraphs [0453] to [0481] of International Publication No. 2019/087985 may be applied. In the step of forming a coating film, it is preferable to form a film by prebaking after coating. In the step of obtaining a cured pattern, it is preferable to heat and thermally cure the pattern.

EXAMPLES

The present invention will be described more concretely hereinafter with reference to examples, reference examples, and comparative example. However, the present invention is not limited to scopes thereof. The names corresponding to the abbreviations of the compounds used in the following description or table are collectively shown in Table 1-1.

[Table 1-1]

| Abbreviation | Corresponding name | Abbreviation | Corresponding name |
|---|---|---|---|
| 6FDA | 4,4'-hexafluoropropane-2,2-diyl-bis(1,2-phthalic anhydride) | MAP | m-aminophenol |
| ABPS | Bis(3-amino-4-hydroxyphenyl)sulfone | MCS | m-cresol |
| APC | Argentum-Palladium-Cuprum (silver-palladium-copper alloy) | MEK | Methyl ethyl ketone |

(continued)

| Abbreviation | Corresponding name | Abbreviation | Corresponding name |
|---|---|---|---|
| BAD | Benzaldehyde | MEK-ST-40 | Silica particle dispersion liquid using methyl ethyl ketone as dispersion solvent (manufactured by Nissan Chemical Corporation) |
| BAH F | 2,2-bis(3-amino-4-hydroxyphenyl)hexafluoropropane | MEK-ST-L | Silica particle dispersion liquid using methyl ethyl ketone as dispersion solvent (manufactured by Nissan Chemical Corporation) |
| BAP | 2,2-bis(3-amino-4-hydroxyphenyl)propane | MeTMS | Methyltrimethoxysilane |
| BAP F | 9,9-bis(3-amino-4-hydroxyphenyl)fluorene | MOI | 2-methacryloxyethyl isocyanate |
| BGPF | 9,9-bis(4-glycidoxyphenyl)fluorene | MOP | 4-methoxyphenol |
| BnMA | Benzyl methacrylate | NA | 5-norbornene-2,3-dicarboxylic anhydride |
| BPFL | 9,9'-bis(4-hydroxyphenyl)fluorene | NC-3000-H | Epoxy resin having a structural unit containing a biphenyl skeleton, a benzene skeleton, and one epoxy group (manufactured by Nippon Kayaku Co., Ltd.) |
| cyEpoTMS | 2-(3,4-epoxycyclohexyl)ethyltrimethoxysilane | | |
| DAE | Bis(4-aminophenyl)ether | NPDL | 1,4-naphthalenediol |
| DHBA | 3,5-dihydroxybenzoic acid | ODB-HBT | Mixture of dicarboxylic acid derivatives obtained by reacting bis(4-carboxyphenyl) ether with 1-hydroxy-1,2,3-benzotriazole |
| DFA | N,N-dimethylformamide dimethyl acetal | | |
| EL | Ethyl lactate | ODPA | Oxydiphthalic dianhydride |
| EtOH | Ethanol | PGMEA | Propylene glycol monomethyl ether acetate |
| GBL | γ-butyrolactone | PHA | Phthalic anhydride |
| GDMA | Glycerol dimethacrylate | PhTMS | Phenyltrimethoxysilane |
| GMA | Glycidyl methacrylate | SAD | Salicylaldehyde |
| HAD | Formaldehyde | SiDA | 1,3-bis(3-aminopropyl)tetramethyldisiloxane |
| HEMA | 2-hydroxyethyl methacrylate | STR | Styrene |
| HPMA | 4-hydroxyphenyl methacrylate | TCDM | Methacrylic acid tricyclo[5.2.1.0$^{2,6}$]decan-8-yl; methylol-tricyclodecane methacrylate |
| HST | 4-hydroxystyrene | | |
| ITO | Indium tin oxide | THPHA | 1,2,3,6-tetrahydrophthalic anhydride |
| KBM-13 | Methyltrimethoxysilane (manufactured by Shin-Etsu Chemical Co., Ltd.) | TMAC | Trimellitic anhydride chloride |
| KBM-503 | 3-methacryloyloxypropyltrimethoxysilane (manufactured by Shin-Etsu Chemical Co., Ltd.) | TMAH | Tetramethylammonium hydroxide |
| MA | Maleic anhydride | TMOS | Tetramethoxysilane |
| MAA | Methacrylic acid | XLN | 2,6-xylenol |

<Synthesis Example of each resin>

As the binder resin (A), the composition of each resin obtained in Synthesis Examples 1 to 25 is collectively shown

in Table 1-2 to Table 1-4. Each resin was synthesized by a known method by appropriately changing a monomer compound to be a monomer and a copolymerization ratio based on a method described in a known document. The copolymerization ratio of the monomers is as shown in Table 1-2 to Table 1-4.

The hydroxy group-containing diamine (HA) having the following structure used in Synthesis Example 8 was synthesized by a known method based on the synthesis method described in Synthesis Example 1 in paragraphs [0374] to [0376] of International Publication No. 2016/056451. The resin obtained in Synthesis Example 5 using a hydroxy group-containing diamine (HA) having the following structure is a polyimide precursor having an amide acid ester structural unit, an amide acid structural unit, and an imide ring-closed structure.

[Chemical Formula 12]

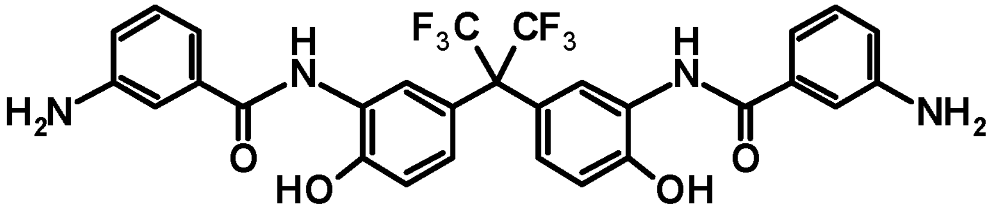

HA

In Synthesis Example 19, a phenol compound having the following structure was synthesized as a condensation reaction product of XLN and SAD instead of the condensation reaction product of XLN and 4-hydroxybenzaldehyde based on the synthesis method described in Synthesis Example 3 and Synthesis Example 5 in paragraphs [0109] to [0122] of International Publication No. 2012/141165, and the obtained phenol compound was used for the condensation reaction with an aldehyde compound.

[Chemical Formula 13]

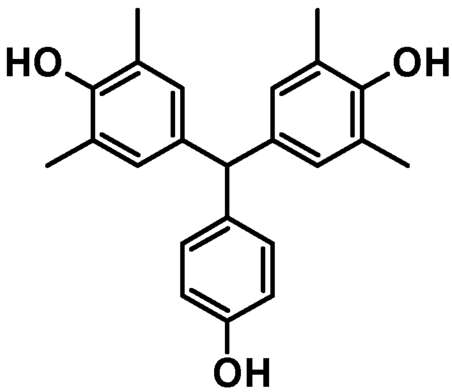

In Synthesis Examples 8 and 11, DFA, which was an esterifying agent, was reacted with the amide acid structural unit in the resin to convert the amide acid structural unit into an amide acid ester structural unit having a methyl group.

In Synthesis Examples 9 and 10, HEMA or GDMA was reacted with ODPA, which was a tetracarboxylic dianhydride, to perform ring-opening addition of all acid anhydride groups of ODPA, and then BAHF, which was a bisaminophenol compound, and EtOH, which was an end-capping agent, were reacted with a carboxy group derived from ODPA.

In Synthesis Example 18, GMA having an epoxy group was reacted with the carboxy group derived from MAA in the resin, and all the epoxy groups of GMA were subjected to ring-opening addition.

In Synthesis Example 24, DHBA having a carboxy group was reacted with an epoxy group derived from GMA in the resin, and all the epoxy groups of GMA were subjected to ring-opening addition.

In Synthesis Example 25, GMA having an epoxy group was reacted with the phenolic hydroxyl group derived from HPMA in the resin, and all the epoxy groups of GMA were subjected to ring-opening addition.

[Table 1-2]

| | Polymer | Monomer [molar ratio] | | | | | | Residues having fluorine atoms in all monomer residues [mol%] | Weight-average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | Amine derivative | | | End-capping agent | Radical polymerizable group-containing compound esterification agent | | | | |
| Synthesis Example 1 | polyimide; (PI-1) | ODPA (100) | BAHF (85) | - | SiDA (5) | MAP (20) | - | 40.5 | 27,000 | Acid equivalent: 330 Phenol equivalent: 330 | - |
| Synthesis Example 2 | polyimide; (PI-2) | ODPA (100) | BAPF (85) | - | SiDA (5) | MAP (20) | - | 0.0 | 25,000 | Acid equivalent: 340 Phenol equivalent: 340 | - |
| Synthesis Example 3 | polyimide; (PI-3) | ODPA (90) | BAHF (95) | - | SiDA (5) | MA (20) | - | 45.2 | 29,000 | Acid equivalent: 330 Phenol equivalent: 330 | - |
| Synthesis Example 4 | polyimide; (PI-4) | ODPA (100) | BAHF (85) | - | SiDA (5) | MAP (20) | MOI (50) | 40.5 | 30,000 | Acid equivalent: 500 Phenol equivalent: 500 | 1,400 |

(continued)

| | Polymer | Monomer [molar ratio] | | | | | | Residues having fluorine atoms in all monomer residues [mol%] | Weight-average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | Amine derivative | | | End-capping agent | Radical polymerizable group-containing compound esterification agent | | | | |
| Synthesis Example 5 | polyimide; (PI-5) | ODPA (80) | BAP (50) | DAE (45) | SiDA (5) | MA (40) | - | 0.0 | 26,000 | Acid equivalent: 490 Phenol equivalent: 490 | - |
| Synthesis Example 6 | polyimide; (PI-6) | ODPA (80) | ABPS (50) | DAE (45) | SiDA (5) | MA (40) | - | 0.0 | 28,000 | Acid equivalent: 510 Phenol equivalent: 510 | - |
| Synthesis Example 7 | polyimide; (PI-7) | ODPA (80) | BAPF (50) | DAE (45) | SiDA (5) | MA (40) | - | 0.0 | 26,000 | Acid equivalent: 560 Phenol equivalent: 560 | - |
| Synthesis Example 8 | polyimide precursor; (PIP-1) | 6FDA (100) | HA (55) | BAHF (10) | SiDA (5) | MAP (60) | DFA (200) | 71.7 | 20,000 | Acid equivalent: 380 Phenol equivalent: 470 Carboxylic acid equivalent: 1,800 | - |

(continued)

| | Polymer | Monomer [molar ratio] | | | | | | Residues having fluorine atoms in all monomer residues [mol%] | Weight-average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | Amine derivative | | | End-capping agent | Radical polymerizable group-containing compound esterification agent | | | | |
| Synthesis Example 9 | polyimide precursor; (PIP-2) | ODPA (100) | BAHF (90) | - | - | EtOH (20) | HEMA (200) | 47.4 | 20,000 | Acid equivalent: 510 Phenol equivalent: 510 | 460 |
| Synthesis Example 10 | polyimide precursor; (PIP-3) | ODPA (100) | BAHF (90) | - | - | EtOH (20) | GDMA (200) | 47.4 | 20,000 | Acid equivalent: 620 Phenol equivalent: 620 | 280 |
| Synthesis Example 11 | polyimide precursor; (PIP-4) | ODPA (80) | BAP (50) | DAE (45) | SiDA (5) | MA (40) | DFA (200) | 0.0 | 18,000 | Acid equivalent: 280 Phenol equivalent: 530 Carboxylic acid equivalent: 600 | - |

(continued)

| | Polymer | Monomer [molar ratio] | | | | | | Residues having fluorine atoms in all monomer residues [mol%] | Weight-average molecular weight | Acid equivalent Phenol equivalent Carboxylic acid equivalent [g/mol] | Double bond equivalent [g/mol] |
|---|---|---|---|---|---|---|---|---|---|---|---|
| | | Carboxylic acid derivative | Amine derivative | | | End-capping agent | Radical polymerizable group-containing compound esterification agent | | | | |
| Synthesis Example 12 | polybenzoxazole; (PB-1) | ODB-HBT (80) | BAHF (95) | - | SiDA (5) | NA (40) | - | 43.2 | 27,000 | Acid equivalent: 460 Phenol equivalent: 670 Carboxylic acid equivalent: 1,420 | - |
| Synthesis Example 13 | polybenzoxazole precursor; (PBP-1) | ODB-HBT (80) | BAH F (100) | - | - | NA (40) | - | 45.5 | 22,000 | Acid equivalent: 260 Phenol equivalent: 310 Carboxylic acid equivalent: 1,530 | - |
| Synthesis Example 14 | polyamideimide; and (PAI-1) | TMAC (80) | BAH F (100) | - | - | NA (40) | - | 45.5 | 25,000 | Acid equivalent: 280 Phenol equivalent: 280 | - |

[Table 1-3]

| | Polymer | Monomer [mol%] | | | | Weight-average molecular weight | Acid equivalent (= silanol equivalent) [g/mol] | Double bond equivalent [g/mol] |
|---|---|---|---|---|---|---|---|---|
| | | Trifunctional organosilane | | | Tetrafunctional organosilane | | | |
| Synthesis Example 15 | Polysiloxane (PS-1) | MeTMS (30) | PhTMS (50) | cyEpoTMS (10) | TMOS (10) | 4,500 | 360 | - |
| | Polymer | Monomer [molar ratio] | | | | Weight-average molecular weight | Acid equivalent (= carboxylic acid equivalent) [g/mol] | Double bond equivalent [g/mol] |
| | | Polyfunctional epoxy compound | Polyfunctional carboxylic dianhydride | Carboxylic anhydride | Radical polymerizable group-containing carboxylic acid compound | | | |
| Synthesis Example 16 | Polycyclic side chain-containing resin (CR-1) | BGPF (100) | ODPA (90) | PHA (20) | MAA (200) | 4,700 | 470 | 470 |
| | Polymer | Monomer [molar ratio] | | | | Weight-average molecular weight | Acid equivalent (= carboxylic acid equivalent) [g/mol] | Double bond equivalent [g/mol] |
| | | Polyfunctional epoxy compound | | Carboxylic anhydride | Radical polymerizable group-containing carboxylic acid compound | | | |
| Synthesis Example 17 | Acid-modified epoxy resin (AE-1) | NC-3000-H (Epoxy equivalent: 290 g/mol) (Epoxy group standard: 0.2 mol) (Epoxy group standard molar ratio: 100) | | THPHA (0.18 mol) (molar ratio: 90) | MAA (0.20 mol) (molar ratio: 100) | 4,500 | 570 | 510 |

(continued)

| | Polymer | Monomer [molar ratio] | | | | Weight-average molecular weight | Acid equivalent (= carboxylic acid equivalent) [g/mol] | Double bond equivalent [g/mol] |
|---|---|---|---|---|---|---|---|---|
| | | Acidic copolymerization component | Aromatic copolymerization component | Alicyclic copolymerization component | Radical polymerizable group-containing epoxy compound | | | |
| Synthesis Example 18 | Acrylic resin (AC-1) | MAA (50) | BnMA (45) | TCDM (5) | GMA (20) | 15,000 | 540 | 810 |

[Table 1-4]

| | Polymer | Monomer [molar ratio] | | | | | | Weight-average molecular weight | Acid equivalent (= phenol equivalent) [g/mol] | Double bond equivalent [g/mol] |
|---|---|---|---|---|---|---|---|---|---|---|
| | | Phenol compound | | | Aldehyde compound bisalkoxymethyl compound | | | | | |
| Synthesis Example 19 | Phenol resin (PR-1) | XLN (200) | - | - | SAD (100) | BAD (25) | HAD (75) | 4,000 | 130 | - |
| Synthesis Example 20 | Phenol resin (PR-2) | MCS (30) | NPDL (70) | - | - | BAD (75) | HAD (25) | 4,500 | 130 | - |
| Synthesis Example 21 | Phenol resin (PR-3) | MCS (70) | BPFL (30) | - | - | BAD (75) | HAD (25) | 6,000 | 190 | - |
| Synthesis Example 22 | Phenol resin (PR-4) | MCS (100) | - | - | - | - | HAD (100) | 3,000 | 120 | - |
| | Polymer | Monomer [molar ratio] | | | | | | Weight-average molecular weight | Acid equivalent (=phenol equivalent) [g/mol] | Double bond equivalent [g/mol] |
| | | Hydroxystyrene copolymerization component | | | Styrene copolymerization component | | | | | |
| Synthesis Example 23 | Polyhydroxystyrene (PHS-1) | HST (80) | | | STR (20) | | | 9,500 | 150 | - |
| | Polymer | Monomer [molar ratio] | | | | | | Weight-average molecular weight | Acid equivalent (= phenol equivalent) [g/mol] | Double bond equivalent [g/mol] |
| | | Copolymerization component having epoxy group | Copolymerization component having phenolic hydroxyl group | Aromatic copolymerization component | Alicyclic copolymerization component | Carboxy group-containing phenol compound | Compound having unsaturated double bond group | | | |
| Synthesis Example 24 | Phenol group-modified acrylic resin (PAC-1) | GMA (30) | - | STR (50) | TCDM (20) | DHBA (30) | - | 13,000 | 310 | - |

(continued)

| | Polymer | Monomer [molar ratio] | | | | | | Weight-average molecular weight | Acid equivalent (= phenol equivalent) [g/mol] | Double bond equivalent [g/mol] |
|---|---|---|---|---|---|---|---|---|---|---|
| | | Copolymerization component having epoxy group | Copolymerization component having phenolic hydroxyl group | Aromatic copolymerization component | Alicyclic copolymerization component | Carboxy group-containing phenol compound | Compound having unsaturated double bond group | | | |
| Synthesis Example 25 | Phenol group-modified acrylic resin (PAC-2) | - | HPMA (75) | BnMA (25) | - | - | GMA (15) | 8,000 | 330 | 1,330 |

The structural units and structures of the resins obtained in Synthesis Examples and the resins used in Examples, Reference Examples, and Comparative Examples are collectively shown in Table 2-1.

[Table 2-1]

| Binder resin (A) | Structural unit and structure of binder resin (A) |
|---|---|
| Polyimide (PI-1) | Structural unit represented by General Formula (1); residues having fluorine atoms; phenol group at resin end |
| Polyimide (PI-2) | Structural unit represented by General Formula (1); phenol group at resin end; content of fluorine element in structure of resin = 0% by mass |
| Polyimide (PI-3) | Structural unit represented by General Formula (1); residues with fluorine atoms; maleimide group at resin end |
| Polyimide (PI-4) | Structural unit represented by General Formula (1); residues having fluorine atoms; phenol group at resin end;<br>Radical polymerizable group: methacryloyl group (2-methacryloyloxyethyl isocyanate residue) |
| Polyimide (PI-5) | Structural unit represented by General Formula (1); maleimide group at resin end; content of fluorine element in structure of resin = 0% by mass |
| Polyimide (PI-6) | Structural unit represented by General Formula (1); maleimide group at resin end; content of fluorine element in structure of resin = 0% by mass |
| Polyimide (PI-7) | Structural unit represented by General Formula (1); maleimide group at resin end; content of fluorine element in structure of resin = 0% by mass |
| Polyimide precursor (PIP-1) | Structural unit represented by General Formula (2); residues having fluorine atoms; phenol group at resin end;<br>Content ratio of amide acid ester structural unit is 65 mol%, content ratio of amide acid structural unit is 25 mol%, and content ratio of imide ring-closed structural unit is 10 mol% |
| Polyimide precursor (PIP-2) | Structural unit represented by General Formula (2); residues having fluorine atoms; ethyl group at resin end;<br>Radical polymerizable group: methacryloyl group (2-hydroxyethyl methacrylate residue)<br>Content ratio of amide acid ester structural unit is 65 mol%, content ratio of amide acid structural unit is 25 mol%, and content ratio of imide ring-closed structural unit is 10 mol% |
| Polyimide precursor (PIP-3) | Structural unit represented by General Formula (2); residues having fluorine atoms; ethyl group at resin end;<br>Radical polymerizable group: methacryloyl group (glycerol dimethacrylate residue)<br>Content ratio of amide acid ester structural unit is 65 mol%, content ratio of amide acid structural unit is 25 mol%, and content ratio of imide ring-closed structural unit is 10 mol% |
| Polyimide precursor (PIP-4) | Structural unit represented by General Formula (2); maleimide group at resin erd;<br>Content ratio of amide acid ester structural unit is 65 mol%, content ratio of amide acid structural unit is 25 mol%, and content ratio of imide ring-closed structural unit is 10 mol%<br>Content of fluorine element in structure of resin = 0% by mass |
| Polybenzoxazole (PB-1) | Structural unit represented by General Formula (3); residues having fluorine atoms; nadiimide group at resin end |
| Polybenzoxazole precursor (PBP-1) | Structural unit represented by General Formula (4); residues having fluorine atoms; nadiimide group at resin end |

(continued)

| Binder resin (A) | Structural unit and structure of binder resin (A) |
|---|---|
| Polyamideimide (PAI-1) | Structural unit represented by General Formula (5); residues having fluorine atoms; nadiimide group at resin end |
| Polysiloxane (PS-1) | Trifunctional organosilane unit represented by General Formula (9); tetrafunctional organosilane unit represented by General Formula (10) |
| Polycyclic side chain-containing resin (CR-1) | Main chain having cardo-based resin structure including fluorene structure; radical polymerizable group: methacryloyl group (methacrylic acid residue) |
| Acid-modified epoxy resin (AE-1) | Main chain having epoxy methacrylate resin structure including biphenyl structure; radical polymerizable group: methacryloyl group (methacrylic acid residue) |
| Acrylic resin (AC-1) | Main chain including acrylic resin structure; radical polymerizable group: methacryloyl group (glycidyl methacrylate residue) |
| Phenol resin (PR-1) | Structural unit represented by General Formula (32) |
| Phenol resin (PR-2) | Structural unit represented by General Formula (35); condensed polycyclic structure: naphthalene structure |
| Phenol resin (PR-3) | Structural unit represented by General Formula (40); condensed polycyclic structure: fluorene structure |
| Phenol resin (PR-4) | Structural unit represented by General Formula (36) |
| Polyhydroxystyrene (PHS-1) | Main chain including polyhydroxystyrene structure |

A list and description of the colorant (D) and the dispersant (E) used in Examples, Reference Examples, and Comparative Examples are collectively shown in Table 2-2.

Note that (A.R.52-B.B.7) is a dye obtained by mixing and stirring at A.R.52/B.B.7 = 1/1 (molar ratio), filtering the precipitated salt, washing it with water three times, and then drying it.

[Table 2-2]

| Colorant (D) Dispersant (E) | Description of colorant (D) and description of dispersant (E) |
|---|---|
| Bk-S0100CF | Mixture of compounds having two benzofuran-2-(3H)-one structures or two benzofuran-3(2H)-one structures; "IRGAPHOR" (registered trademark) BLACK S0100CF (manufactured by BASF; benzofuranone-based black pigment having a primary particle size of 40 to 80 nm) |
| Bk-FK4280 | Compound having 3,4,9,10-perylene tetracarboxylic acid bisbenzimidazole structure; "LUMOGEN" (registered trademark) BLACK FK4280 (manufactured by BASF); perylene-based black pigment having a primary particle size of 50 to 100 nm) |
| Bk-A1103 | Compound having azomethine structure and carbazole structure; "CHROMOFINE" (registered trademark) BLACK A1103 (manufactured by Dainichiseika Color & Chemicals Mfg. Co., Ltd.; azomethine-based black pigment having a primary particle size of 50 to 100 nm) |
| P.R.179 | C.I. Pigment Red 179 (perylene-based red pigment) |
| P.Y.192 | C.I. Pigment Yellow 192 (imidazolone-based yellow pigment) |
| P.B.60 | C.I. Pigment Blue 60 (indanthrone-based blue pigment) |
| Bk-CBF1 | Benzofuranone-based black pigment having covering layer (average coverage ratio with respect to pigment: 97.5%)<br>Silica covering layer: silica (10.0 parts by mass in terms of $SiO_2$ with respect to 100 parts by mass of pigment)<br>Metal oxide covering layer: alumina (2.0 parts by mass in terms of $Al_3O_3$ with respect to 100 parts by mass of pigment) |

(continued)

| Colorant (D) Dispersant (E) | Description of colorant (D) and description of dispersant (E) |
|---|---|
| Bk-CPR1 | Perylene-based black pigment having covering layer (average coverage ratio with respect to pigment: 84.5%)<br>Silica covering layer: silica + silica (3.0 + 7.0 parts by mass in terms of $SiO_2$ with respect to 100 parts by mass of pigment)<br>*Two silica covering layers |
| ADP | Polyalkylene amine-based-polyoxyalkylene ether-based dispersant having tertiary amino group (amine value: 20 mgKOH/g (solid content concentration: 100% by mass)) |
| A.R.52 | C.I. Acid Red 52 (xanthene-based red dye) |
| B.B.7 | C.I. Basic Blue 7 (triarylmethane-based blue dye) |
| S.R.18 | C.I. Solvent Red 18 (azo-based red dye) |
| D.Y.201 | C.I. Disperse Yellow 201 (methine-based yellow dye) |

<Colorants>

- Bk-CBF1 is a benzofuranone-based black pigment having a covering layer described in paragraphs [0503] to [0505] and Covering Example 1 of International Publication No. 2019/087985.
- Bk-CPR1 is a perylene-based black pigment having a covering layer obtained by the synthesis method described in paragraphs [0186] to [0188] and paragraph [0191] and Example 18 of International Publication No. 2018/038083.

<Preparation Examples of pigment dispersion liquids>

As the pigment dispersion liquid, the compositions of the dispersion liquids obtained in Preparation Examples Bk-1 to Bk-6 are collectively shown in Table 2-3. In Preparation Examples Bk-1 to Bk-6, each pigment dispersion liquid was prepared by the following method.

Preparation Examples Bk-1 to Bk-6 Preparation of pigment dispersion liquids (Bk-1) to (Bk-6)

35.0 g of ADP (pigment dispersant 1 described in paragraphs [0138] to [0141] and Synthesis Example 2 of JP 2020-070352 A), which is a polyalkylene amine-based-polyoxyalkylene ether-based dispersant as a dispersant and 765.0 g of PGMEA as a solvent were weighed, mixed, and stirred for 10 minutes to be diffused. Then, 100.0 g of a black pigment described in Table 2-3 as a colorant was weighed, mixed, and stirred for 30 minutes to obtain a preliminarily stirred liquid. The preliminary stirred liquid was fed to a vertical bead mill having a vessel filled with a grinding medium consisting of the composite oxide of 0.40 mmφ, which is a ceramic bead as a grinding medium in which a pure content of a composite oxide of a zirconium element and a hafnium element ($ZrO_2$-$HfO_2$) is 90% by mass or more (zirconia ($ZrO_2$)/hafnium oxide ($HfO_2$) /yttrium oxide ($Y_2O_3$)/aluminum oxide ($Al_2O_3$) = 93.3/1.5/4.9/0.3 (mass ratio)), and a first wet media dispersion treatment was performed at a peripheral speed of 8 m/s for 3 hours by a circulation method. Furthermore, the liquid was fed to a vertical bead mill having a vessel filled with a grinding medium consisting of the composite oxide of 0.05 mmφ as a grinding medium (zirconia ($ZrO_2$)/hafnium oxide ($HfO_2$)/yttrium oxide ($Y_2O_3$)/aluminum oxide ($Al_2O_3$) = 93.3/1.5/4.9/0.3 (mass ratio)), and a second wet media dispersion treatment was performed at a peripheral speed of 9 m/s by a circulation method so that the average primary particle size of the pigment became the value shown in Table 2-3. Thereafter, filtration was performed with a filter of 0.80 μmφ to obtain pigment dispersion liquids (Bk-1) to (Bk-6) having a solid content concentration of 15% by mass and satisfying colorant/dispersant = 100/35 (mass ratio). The average primary particle sizes of the pigment in the obtained pigment dispersion liquids are shown in Table 2-3.

[Table 2-3]

| | Pigment dispersion liquid | Composition [parts by mass] | | | | Solvent | Average primary particle size in pigment dispersion liquid [nm] | Average primary particle size in cured film [nm] |
|---|---|---|---|---|---|---|---|---|
| | | Colorant (D) | | | Dispersant (E) | | | |
| Preparation Example Bk-1 | Pigment dispersion liquid (Bk-1) | Bk-S0100CF (100) | - | - | ADP (35) | PGMEA | 80 | 60 |
| Preparation Example Bk-2 | Pigment dispersion liquid (Bk-2) | Bk-FK4280 (100) | - | - | | | 100 | 80 |
| Preparation Example Bk-3 | Pigment dispersion liquid (Bk-3) | Bk-A1103 (100) | - | - | | | 100 | 80 |
| Preparation Example Bk-4 | Pigment dispersion liquid (Bk-4) | P.R.179 (30) | P.Y.192 (30) | P.B.60 (40) | | | 100 | 80 |
| Preparation Example Bk-5 | Pigment dispersion liquid (Bk-5) | Bk-CBF1 (100) | - | - | | | 60 | 60 |
| Preparation Example Bk-6 | Pigment dispersion liquid (Bk-6) | Bk-CPR1 (100) | - | - | | | 80 | 80 |

<Synthesis Example of silica particle dispersion liquid>

A list and description of silica particles as inorganic particles used in Examples, Reference Examples, and Comparative Examples are collectively shown in Table 2-4.

Synthesis Example 26 Synthesis of silica particle (SP-1) dispersion liquid

In a three-necked flask, 104.5 g of MEK as a solvent, 142.5 g of MEK-ST-40 as a silica particle dispersion liquid containing a sodium element, and 0.01 g of MOP as a polymerization terminator were weighed and added, mixed, and stirred for 10 minutes, and then the liquid temperature was raised to 50°C. Then, a solution of 3.0 g of KBM-503 dissolved in 50.0 g of MEK as a surface modifier was added dropwise over 10 minutes. After completion of the dropwise addition, the mixture was stirred at 50°C for 2 hours to dehydrate and condense the surface modifier. After the reaction, the reaction solution was cooled to room temperature to obtain a dispersion liquid of silica particles (SP-1). The obtained silica particles (SP-1) have a surface-modifying group containing a methacryloyl group as a radical polymerizable group.

Note that (MSiP-1) as the dispersion liquid of silica particles (SP-2) was used by synthesizing silica particles having a surface-modifying group containing a methylsilyl group in the same manner as in Synthesis Example 20 using MEK-ST-40 as a silica particle dispersion liquid containing a sodium element and KBM-13 as a surface modifier, without using MOP as a polymerization terminator. In addition, (MSiP-2) as the dispersion liquid of silica particles (SP-3) was used by synthesizing silica particles having a surface-modifying group containing a methylsilyl group in the same manner as in Synthesis Example 20 using MEK-ST-L as a silica particle dispersion liquid containing a sodium element and KBM-13 as a surface modifier, without using MOP as a polymerization terminator.

[Table 2-4]

| Inorganic-particle silica particles | Silica particle dispersion liquid | Physical property values of silica particles | | | | |
|---|---|---|---|---|---|---|
| | | Distribution range of primary particle size [nm] | Average primary particle size [nm] | Aspect ratio range | Average aspect ratio | Sodium element content |
| SP-1 | Synthesis Example 20 | 10-16 | 12 | 1.0-1.1 | 1.1 | 100 ppm by mass |
| SP-2 | MSiP-1 | 10-15 | 12 | 1.0-1.1 | 1.1 | 100 ppm by mass |
| SP-3 | MSiP-2 | 20-60 | 40 | 1.0-1.2 | 1.2 | 100 ppm by mass |

<Evaluation methods in Examples, Reference Examples, and Comparative Examples>

Evaluation methods in Examples, Reference Examples, and Comparative Examples are described below. A glass substrate in which APC (silver/palladium/copper = 98.07/0.87/1.06 (mass ratio)) had been formed into a film of 100 nm by sputtering on a glass sheet and, furthermore, as an upper layer on the APC layer, ITO was formed into a film of 10 nm by sputtering (manufactured by GEOMATEC Co., Ltd., hereinafter "ITO/Ag substrate") was subjected to a UV-$O_3$ washing process for 100 seconds by using a table-top Photo Surface Processor (PL16-110; manufactured by SEN LIGHTS Corporation) before the glass substrate was used. A TEMPAX glass substrate (manufactured by AGC TECHNO GLASS CO., LTD.), a polyethylene terephthalate (hereinafter, referred to as "PET") film, a polypropylene (hereinafter, referred to as "PP") film, and an alumina substrate were used without being pretreated. Other substrates were subjected to a dehydration baking treatment using a hot plate (HP-1SA; manufactured by AS ONE Corporation) for heating at 130°C for 2 minutes. In film thickness measurement, with the use of a surface roughness and contour measuring instrument (SURFCOM 1400D; manufactured by TOKYO SEIMITSU CO., LTD.), under the conditions of the measurement magnification of 10,000 times, the measurement length of 1.0 mm, and the measurement speed of 0.30 mm/s, the film thickness was measured.

(1) Weight-average molecular weight of resin

Regarding the above polyimides (PI-1) to (PI-7), polyimide precursors (PIP-1) to (PIP-4), polybenzoxazole (PB-1), a polybenzoxazole precursor (PBP-1), and polyamideimide (PAI-1), each resin was dissolved in N-methyl-2-pyrrolidone to prepare 0.10% by mass of a N-methyl-2-pyrrolidone solution. Using a GPC analyzer (Waters 2690; manufactured by Waters Corporation), the weight-average molecular weight in terms of polystyrene was measured and then obtained under the following measurement conditions.

<GPC measurement conditions>

Detector: Waters 996
System controller: Waters 2690
Column oven: Waters HTR-B
Thermo controller: Waters TCM
Column: TOSOH Guard Column
Column: TOSOH TSK-GEL $\alpha$-4000
Column: TOSOH TSK-GEL $\alpha$-2500
Fluidized bed: N-methyl-2-pyrrolidone in which lithium chloride and phosphoric acid are each dissolved at 0.050 mol/L
Development speed: 0.40 mL/min.

Regarding other resins, with the use of a GPC analyzer (HLC-8220; manufactured by Tosoh Corporation), and with the use of tetrahydrofuran or N-methyl-2-pyrrolidone as a fluidized bed, the weight-average molecular weight in terms of polystyrene was measured and then obtained by a method at around normal temperature, based on "JIS K7252-3 (2008)".

(2) Average primary particle size of pigment in pigment dispersion liquid

D50 (median diameter) in the pigment dispersion liquid was measured using a dynamic light scattering particle size distribution measuring apparatus (SZ-100; manufactured by HORIBA, Ltd.) with a laser wavelength of 532 nm, PGMEA as a diluent solvent, a dilution ratio of 250 times (weight ratio), a solvent viscosity of 1.25, a solvent refractive index of 1.40, a measurement temperature of 25°C, a measurement mode of scattered light, and operating conditions of polydispersion and broad. The number of measurements was two, and the average value was taken as the average primary particle size of the pigment in the pigment dispersion liquid.

(3) Average primary particle size of pigment in cured film

A cured film of a composition was prepared by the method described in Example 1 below. The cross section of the cured film was imaged and analyzed using a transmission electron microscope, and the primary particle size of the pigment was measured. The average value obtained by measuring 30 primary particles of the pigment was obtained as the average primary particle size of the pigment in the cured film.

(4) Contents of specific aromatic compound, specific organic acid, specific nitrogen-containing compound, specific carboxylic acid, and specific oxime compound in composition or cured film

The contents of the specific aromatic compounds, the specific organic acids, the specific nitrogen-containing compounds, the specific carboxylic acids, or the specific oxime compounds in the composition or the cured film were measured by gas chromatography mass spectrometry using a calibration curve by a standard substance and liquid chromatography mass spectrometry. Note that the content of the composition in the total solid content was calculated from the obtained measured value and the following formula:

(Content in total solid content of composition) = (content in composition) $\times$ 100/(solid content concentration --> of composition [% by mass])

(5) Content of specific anion in composition or cured film

The content of the specific anion in the composition or the cured film was measured by ion chromatography under the following measurement conditions. The composition or the cured film was added to a 10 mmol/L potassium hydroxide aqueous solution, and the mixture was shaken for 2 hours to extract ionic components. The extract liquid was filtered under the following conditions, and then cation components and anion components were analyzed by ion chromatography. When the ion content is not described, it indicates that the ion is not detected. Note that the content of the composition in the total solid content was calculated from the obtained measured value and the following formula:

(Content in total solid content of composition) = (content in composition) $\times$ 100/(solid content concentration of composition [% by mass])

<Filtration treatment conditions>

Membrane filter: 0.22 $\mu$m$\varphi$, PVDF (manufactured by Merck Millipore)
Solid-phase extraction cartridge: InertSep Slim-J PLS-3 (manufactured by GL Sciences Inc.)
Cation exchange cartridge: OnGuard II H (manufactured by Thermo Fisher Scientific Inc.)
<Ion chromatography analysis conditions>
Device: ICS-5000$^+$ (manufactured by Thermo Fisher Scientific Inc.)
Separating column: 2 mm$\varphi$ $\times$ 250 mm, IonPac AS11-HC-4$\mu$m
Eluent: potassium hydroxide/gradient
Detector: electrical conductivity detector
Sample injection volume: 100 $\mu$L

(6) Content of specific metal element in composition or cured film

The content of a specific metal element in the composition or the cured film was measured by inductively coupled plasma mass spectrometry using a calibration curve by a standard substance and inductively coupled plasma emission

spectroscopy. Note that the content of the composition in the total solid content was calculated from the obtained measured value and the following formula:

(Content in total solid content of composition) = (content in composition) × 100/(solid content concentration of composition [% by mass])

(7) Contents of fluorine element, chlorine element, bromine element, and sulfur element in composition or cured film

The contents of the fluorine element, the chlorine element, the bromine element, and the sulfur element in the composition or the cured film were measured by combustion ion chromatography under the following measurement conditions. The composition or the cured film was burned and decomposed in a combustion tube of an analyzer, the generated gas was absorbed into an absorbent, and a part of the absorbent was analyzed by ion chromatography. When the element content is not described, it indicates that the element is not detected. Note that the content of the composition in the total solid content was calculated from the obtained measured value and the following formula:

(Content in total solid content of composition) = (content in composition) × 100/(solid content concentration of composition [% by mass])

<Combustion/absorption conditions>

System: AQF-2100H and GA-210 (manufactured by Mitsubishi Chemical Corporation)
Temperature of electric furnace: 900°C at the inlet and 1,000°C at the outlet
Gas: $Ar/O_2$ 200 mL/min, $O_2$ 400 mL/min
Absorbent: $H_2O_2$ 0.1% by mass
Volume of absorbent: 5 mL

<Ion chromatography/anion analysis conditions>

System: ICS1600 (manufactured by DIONEX)
Mobile phase: 2.7 mmol/L $Na_2CO_3$, 0.3 mmol/L $NaHCO_3$
Flow rate: 1.50 mL/min
Detector: electrical conductivity detector
Injection amount: 100 μL.

(8) Water content in composition

The water content in the composition was measured using a Karl Fischer moisture meter (MKS-520; manufactured by Kyoto Electronics Manufacturing Co., Ltd.) and a Karl Fischer reagent as a titration reagent according to "JIS K0113(2005)" by a volumetric titraction method.

(9) Sensitivity

A developed film of a composition was prepared by the method described in Example 1 below. FPD/LSI inspection microscope (OPTIPHOT-300; manufactured by Nikon Corporation) was used to observe a resolution pattern of the developed film prepared. As an index of the sensitivity, an exposure energy (value of i-ray illuminance meter) at which a space pattern corresponding to an opening can be formed with a dimension width of 18 μm in a line-and-space pattern of 20 μm was defined as sensitivity. It has been determined as follows that A+, A, B+, B, C+, and C with the sensitivity of 90 $mJ/cm^2$ or less are regarded as pass, A+, A, B+, and B with the sensitivity of 60 $mJ/cm^2$ or less are regarded as favorable, and A+ and A with the sensitivity of 40 $mJ/cm^2$ or less are regarded as excellent.

A+: Sensitivity is 30 $mJ/cm^2$ or less.
A: Sensitivity is more than 30 $mJ/cm^2$ and 40 $mJ/cm^2$ or less.
B+: Sensitivity is more than 40 $mJ/cm^2$ and 50 $mJ/cm^2$ or less.
B: Sensitivity is more than 50 $mJ/cm^2$ and 60 $mJ/cm^2$ or less.

C+: Sensitivity is more than 60 $mJ/cm^2$ and 75 $mJ/cm^2$ or less.
C: Sensitivity is more than 75 $mJ/cm^2$ and 90 $mJ/cm^2$ or less.
D: Sensitivity is more than 90 $mJ/cm^2$ and 150 $mJ/cm^2$ or less.
E: Sensitivity is more than 150 $mJ/cm^2$.

(10) Development residue

A developed film of a composition was prepared by the method described in Example 1 below. FPD/LSI inspection microscope (OPTIPHOT-300; manufactured by Nikon Corporation) was used to observe a resolution pattern of the developed film prepared. As an index of the development residue, the presence or absence of a residue of a pattern corresponding to an opening was observed in a 20 μm line-and-space pattern. It has been determined as follows that A+, A, B+, B, C+, and C where the residue existing area is 20% or less are regarded as pass, A+, A, B+, and B where the residue existing area is 10% or less are regarded as favorable, and A+ and A where the residue existing area is 3% or less are regarded as excellent.

A+: No residue exits.
A: The residue existing area is 3% or less.
B+: The residue existing area is more than 3% and 6% or less.
B: The residue existing area is more than 6% and 10% or less.
C+: The residue existing area is more than 10% and 15% or less.
C: The residue existing area is more than 15% and 20% or less.
D: The residue existing area is more than 20% and 50% or less.
E: The residue existing area is more than 50% and 100% or less.

(11) Light-shielding property (optical density value (hereinafter, referred to as "OD value"))

A cured film of the composition was prepared on a TEMPAX glass substrate (manufactured by AGC TECHNO GLASS CO., LTD.) by the method described in Example 1 below. Using a transmission densitometer (X-Rite 361T(V); manufactured by X-Rite company), the prepared cured film was subjected to measurement of incident light intensity ($I_0$) and of transmitted light intensity (I) at three points in the plane. As an index of the light-shielding property, the OD value per film thickness of 1 μm was calculated by the following formula, and the average value of the OD values at three points in the plane was calculated.

$$\text{OD value} = \log_{10}(I_0/I).$$

(12) Mechanical properties (elongation at break)

A cured film of a composition having a film thickness of about 5 μm was prepared on a $SiO_2$/Si wafer having a diameter of 6 inches by the method described in Example 1 below. The cured film was peeled off from the $SiO_2$/Si wafer using dilute hydrofluoric acid. The peeled cured film was cut into a strip shape having a width of 1.5 cm × a length of 9.0 cm. Using Tensilon RTM-100 (manufactured by ORIENTEC CORPORATION), a tensile test was conducted at a tensile rate of 50 mm/min at a room temperature of 23.0°C and a humidity of 45.0% RH, and the elongation at break was measured. 10 strips were measured per sample. As an index of the mechanical properties, an average value of the top five points was calculated from the obtained results. It has been determined as follows that A+, A, B+, B, C+, and C where the elongation at break is 5.0% or more are regarded as pass, A+, A, B+, and B where the elongation at break is 10% or more are regarded as favorable, and A+ and A where the elongation at break is 20% or more are regarded as excellent.

A+: The elongation at break is 30% or more.
A: The elongation at break is 20% or more and less than 30%.
B+: The elongation at break is 15% or more and less than 20%.
B: The elongation at break is 10% or more and less than 15%.
C+: The elongation at break is 7.5% or more and less than 10%.
C: The elongation at break is 5.0% or more and less than 7.5%.
D: The elongation at break is 1.0% or more and less than 5.0%.
E: The elongation at break is less than 1.0% or unmeasurable.

(13) Migration resistance (insulation reliability)

A cured film of the composition with a film thickness of about 1.5 μm was prepared on a migration evaluation substrate (WALTS-TEG ME0102JY; manufactured by WALTS Co., Ltd.) using the method described in Example 1 below. Next, in the line-and-space pattern of the copper wiring of the comb teeth, a conductive wire was soldered to a portion of a measurement terminal having a line of 15 μm and a space of 10 μm to prepare an evaluation element. The prepared evaluation element was evaluated for insulation reliability under high temperature and high humidity using an insulation deterioration characteristic evaluation system (ETAC SIR13; manufactured by Kusumoto Chemicals, Ltd.). The evaluation element was placed in a high temperature and high humidity bath in which the test conditions were set to a temperature of 85°C and a humidity of 85% RH, a voltage of 5.0 V was applied, and the temporal change of the resistance value was measured at intervals of 5 minutes. When the resistance value reached $1.0 \times 10^6$ Ω or less, insulation failure was determined, and the test time at that time was measured as an index of migration resistance. It has been determined as follows that A+, A, B+, B, C+, and C where the test time is 200 hours or more are regarded as pass, A+, A, B+, and B where the test time is 400 hours or more are regarded as favorable, and A+ and A where the test time is 800 hours or more are regarded as excellent.

A+: The test time is 1,000 hours or more.
A: The test time is 800 hours or more and less than 1,000 hours.
B+: The test time is 600 hours or more and less than 800 hours.
B: The test time is 400 hours or more and less than 600 hours.
C+: The test time is 300 hours or more and less than 400 hours.
C: The test time is 200 hours or more and less than 300 hours.
D: The test time is 50 hours or more and less than 200 hours.
E: The test time is less than 50 hours or unmeasurable.

<Compounds used in Examples, Reference Examples, and Comparative Examples>

The structures of (b-1) to (b-9), (c-1) to (c-9), (f-1) to (f-3), (i-1), (j-1), (k-1), and (NQD-1) are shown below as compounds used in Examples, Reference Examples, and Comparative Examples.

Note that (b-1) and (b-2) correspond to the compound (B-1), and (b-3) and (b-4) correspond to the compound (B-2). (b-5) corresponds to the compound (B-3), and the minimum number of atoms in the structure (I-b3) is 4. (b-6), (b-7), (b-8), and (b-9) correspond to the compound (B-4), and the minimum number of atoms in the structure (I-b4) is 13 for (b-6), 23 for (b-7), 31 for (b-8), and 17 for (b-9).

(i-1) is a dissolution accelerator and has a hydrophobic structure (a phenyl group having 6 carbon atoms to which two ethylene groups having 2 carbon atoms and having a phenyl group having 6 carbon atoms are bonded), a hydrophilic structure (12 oxyethylene groups having 2 carbon atoms), and a hydrophilic group (hydroxy group bonded to an oxyethylene group).
(j-1) is a fluorenone compound of a sensitizer.
(k-1) is an organosilane compound of a silane coupling agent, which is an adhesion promoter, and has an epoxy group.

[Chemical Formula 14]

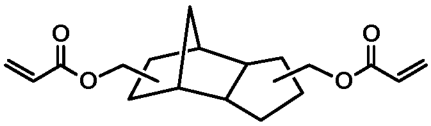

(b-1)

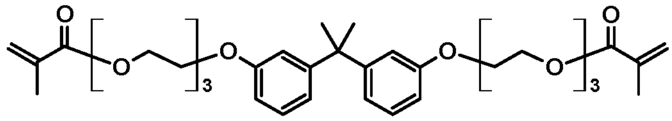

(b-3)

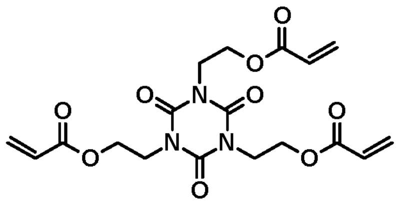

(b-2)

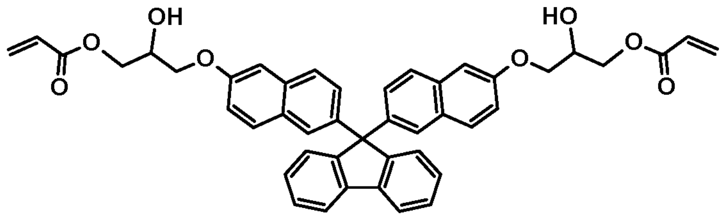

(b-4)

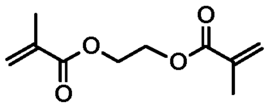

(b-5)

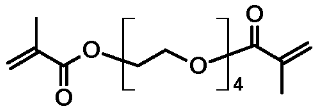

(b-6)

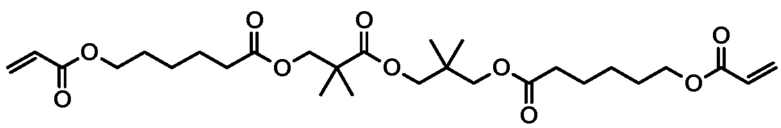

(b-7)

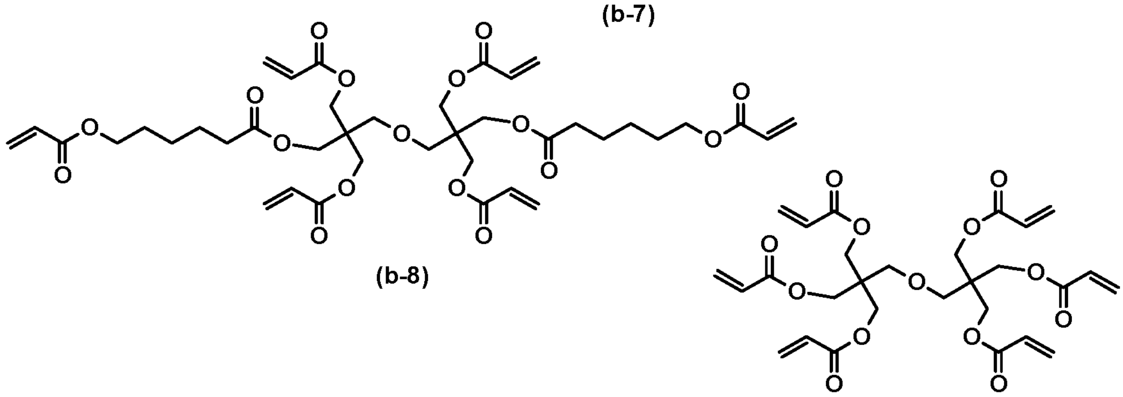

(b-8)

(b-9)

[Chemical Formula 15]

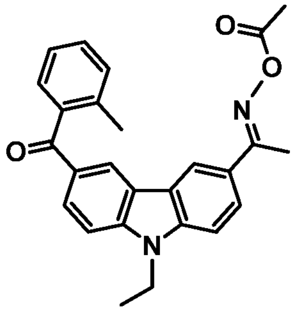

(c-1)

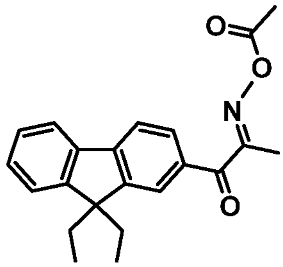

(c-2)

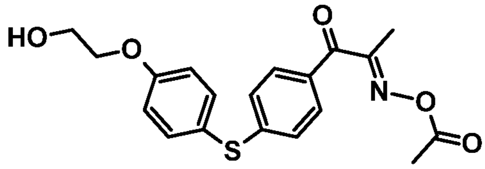

(c-3)

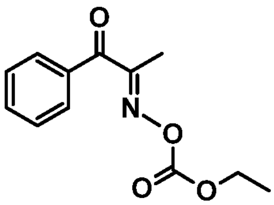

(c-4)

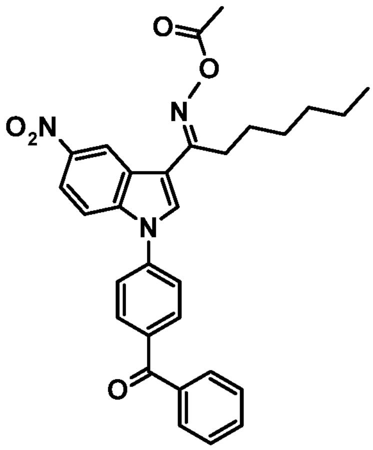

(c-5)

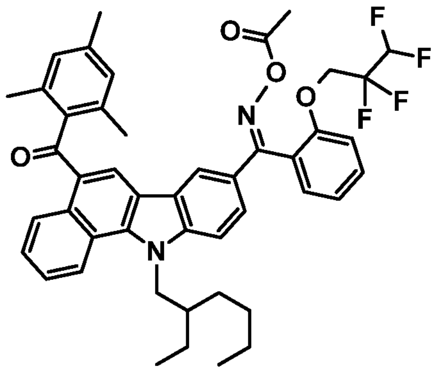

(c-6)

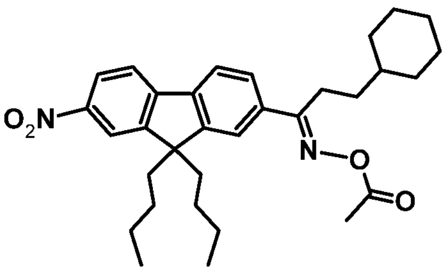

(c-7)

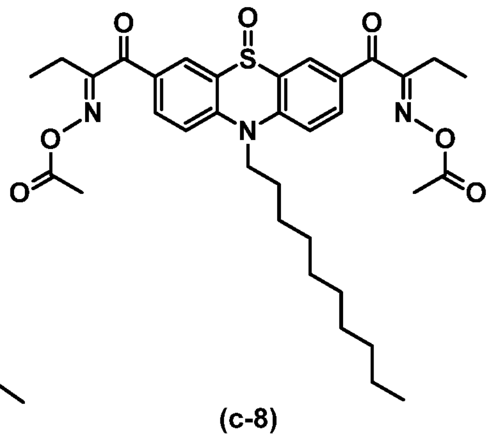

(c-8)

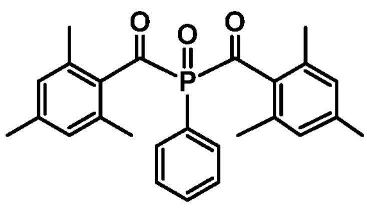

(c-9)

[Chemical Formula 16]

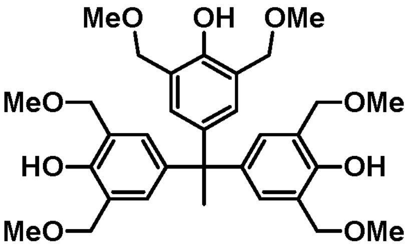

(f-1)

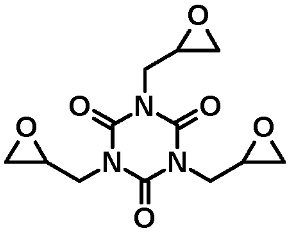

(f-2)

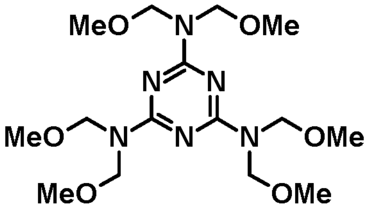

(f-3)

[Chemical Formula 17]

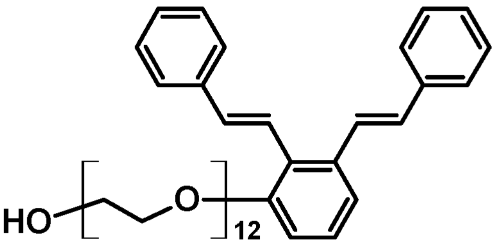

(i-1)

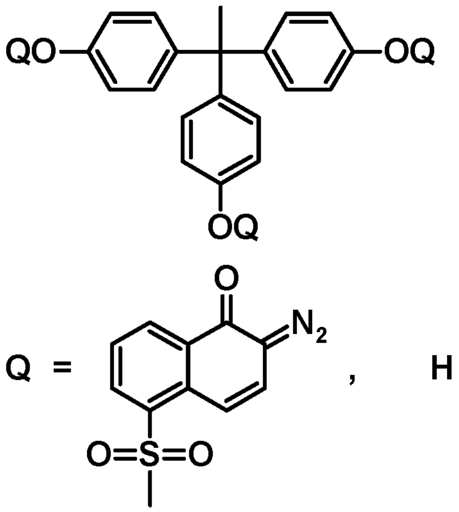

Q = , H

1.7 : 1.3

(NQD-1)

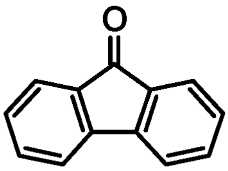

(j-1)

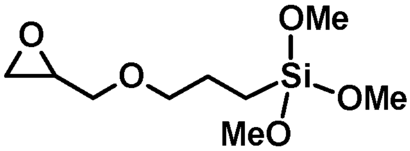

(k-1)

The specific aromatic compounds, the compounds containing a specific anion, the specific organic acids, the specific nitrogen-containing compounds, the compounds containing a specific metal element, the specific carboxylic acids, the specific oxime compounds, the compounds containing a fluorine element, a chlorine element, a bromine element, or a sulfur element (hereinafter, referred to as "compounds containing specific elements") used in Examples, Reference Examples, and Comparative Examples, and compounds corresponding thereto are collectively shown in Table 2-5.

[Table 2-5]

| Abbreviation | Compound containing specific anion | Abbreviation | Specific organic acid | Abbreviation | Compound containing specific element |
|---|---|---|---|---|---|
| (Cl-I-1) | Ammonium chloride (butyltriethyl) | (SA-1) | Methanesulfonic acid | (Cl-1) | Dodecyl chloride |
| (Br-I-1) | Ammonium bromide (butyltriethyl) | (SA-2) | Toluenesulfonic acid | (Cl-2) | Benzyl chloride |
| (S-I-1) | Bis(butyltriethylammonium)sulfate | (SA-3) | Trifluoromethanesulfonic acid | (Br-1) | Dodecyl bromide |
| (S-I-2) | Bis(butyltriethylammonium)sulfite | (SA-4) | Trifluoromethylbenzenesulfonic acid | (Br-2) | Benzyl bromide |
| (N-I-1) | Ammonium nitrate (butyltriethyl) | (SA-5) | Xylenesulfonic acid | (Sc-1) | Dodecanethiol |
| (N-I-2) | Ammonium nitrite (butyltriethyl) | (PA-1) | Dodecylphosphonic acid | (Sc-2) | Benzylthiol |
| (P-I-1) | Tris(butyltriethylammonium)phosphate | (PA-2) | Benzylphosphonic acid | (Fc-1) | Dodecyl fluoride |
| (P-I-2) | Tris(butyltriethylammonium)phosphite | (PA-3) | Dodecylphosphinic acid | | |
| (P-I-3) | Bis(butyltriethylammonium)hypophosphi te | (FA-1) | Trifluoroacetic acid | | |
| (CA-I-1) | Anmonium formate (butyltriethyl) | (FA-2) | Pentafluorobenzoic acid | | |
| (F-I-1) | Anmonium fluoride (butyltriethyl) | (FA-3) | Trifluoromethylbenzoic acid | | |
| Abbreviation | Specific aromatic compound | Abbreviation | Specific nitrogen-containing compound | Abbreviation | Compound containing specific metal element |
| (Ar-1) | Benzene | (Nc-1) | N-methyl-2-pyrrolidone | (Mt-1) | Sodium dodecanoate |
| (Ar-2) | Toluene | (Nc-2) | N,N'-dimethylisobutyramide | (Mt-2) | Potassium dodecanoate |
| (Ar-3) | Xylene | (Nc-3) | N,N'-dimethyl-3-methoxypropionamide | (Mt-3) | Magnesium dodecanoate |
| (Ar-4) | Naphthalene | (Nc-4) | N,N'-dimethyl-3-butoxypropionamide | (Mt-4) | Calcium dodecanoate |
| | | (Nc-5) | 1,3-dimethyl-2-imidazolidinone | (Mt-5) | Tris(dodecanoic acid)iron (III) |
| | | (Nc-6) | 1,1,3,3-tetramethylurea | (Mt-6) | Bis(dodecanoic acid)copper (II) |
| | | (Nc-7) | N-methyl-2-oxazolidone | (Mt-7) | Tris(dodecanoic acid)chromium (III) |
| | | (Nc-8) | N-methyl-3-isoxazolidone | | |
| Abbreviation | Specific carboxylic acid | Abbreviation | Specific oxime compound | | |
| (Cbx-1) | Acetic acid | (Oxm-1) | 1-(fluorene-2-yl)ethanone-1-oxime | | |
| (Cbx-2) | Propionic acid | (Oxm-2) | 1-(carbazole-3-yl)ethanone-1-oxime | | |

(continued)

| Abbreviation | Specific carboxylic acid | Abbreviation | Specific oxime compound | | |
|---|---|---|---|---|---|
| (Cbx-3) | Benzoic acid | (Oxm-3) | 1-[4-(phenylthio)phenyl]ethanone-1-oxime | | |
| (Cbx-4) | Trimethylbenzoic acid | (Oxm-4) | 1-phenylethanone-1-oxime | | |

<Preparation 1 of photosensitive composition>

Compositions 1 to 157 were prepared with the compositions described in Tables 3-1 to 3-12. In Tables 3-1 to 3-12, the numerical values in parentheses represent parts by mass of the solid content of each component. When the composition contained a pigment, first, a preparation liquid containing no pigment dispersion liquid was prepared, and then the pigment dispersion liquid and the preparation liquid were mixed to prepare a composition. Using PGMEA/EL/GBL = 50/40/10 (mass ratio) as a solvent, the composition was prepared so that the solid content concentration was 20% by mass. The solution of the obtained composition was filtered through a 0.45 μmφ filter and used.

The additional amounts of the specific aromatic compounds and water were adjusted so that the contents in the composition were the compositions described in Tables 3-1 to 3-12.

The addition amounts of the compounds containing a specific anion, the compounds containing a specific metal element, and the compounds containing a specific element were prepared so that the contents of the specific anions, the contents of the specific organic acids and the specific metal elements, and the contents of the fluorine element, the chlorine element, the bromine element, and the sulfur element in the total solid content of the composition were the compositions shown in Tables 3-1 to 3-12.

The addition amounts of the specific organic acids, the specific nitrogen-containing compounds, the specific carboxylic acids, and the specific oxime compounds were prepared so that the contents in the total solid content of the composition were the compositions shown in Tables 3-1 to 3-12.

[Table 3-1]

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | compound containing specific ion and elerent | Specific compound | Content of aromatic compound in composition | Content in total solid content of composition | Content of water in composition | |
| Example 1 | 1 | PI-1(45) PIP-3(15) | f-1(5) | Ar-2 | - | SA-2 | Ar-2 (3 ppm by mass) | SA-2 (3 ppm by mass) S element (0.56 ppm by mass) | Water (1.0% by mass) | PGMEA/EL//GBL =50 /40/10 |
| Example 2 | 2 | | | Ar-1 | - | | Ar-1 (3 ppm by mass) | | | |
| Example 3 | 3 | | | Ar-3 | - | | Ar-3 (3 ppm by mass) | | | |
| Example 4 | 4 | | | Ar-4 | - | | Ar-4 (3 ppm by mass) | | | |
| Example 5 | 5 | | | Ar-2 | - | | Ar-2 (0.50 ppm by mass) | | | |
| Example 6 | 6 | | | | - | | Ar-2 (1 ppm by mass) | | | |
| Example 7 | 7 | | | | - | | Ar-2 (40 ppm by nass) | | | |
| Example 8 | 8 | | | Ar-2 | Cl-I-1 | - | Ar-2 (3 ppm by mass) | Chloride ion (3 ppm by mass) Cl element (3 ppm by mass) | | |
| Example 9 | 9 | | | | Br-I-1 | - | | Bromide ion (3 ppm by mass) Br element (3 ppm by mass) | | |
| Example 10 | 10 | | | | S-I-1 | - | | Sulfate ion (3 ppm by mass) | | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | compound containing specific ion and elerent | Specific compound | Content of aromatic compound in composition | Content in total solid content of composition | Content of water in composition | |
| | | | | | | | | S element (1 ppm by mass) | | |
| Example 11 | 11 | b-1(15) | f-3(5) | | S-I-2 | - | | Sulfite ion (3 ppm by mass) S element (1.2 ppm by mass) | | |
| Example 12 | 12 | b-3 (25) | j-1 (1) | | N-I-1 | - | | Nitrate ion (3 ppm by mass) | | |
| Example 13 | 13 | | | | N-I-2 | - | | Nitrite ion (3 ppm by mass) | | |
| Example 14 | 14 | c-1 (10) | k-1 (3) | | P-I-1 | - | | Phosphate ion (3 ppm by mass) | | |
| Example 15 | 15 | | | | P-I-2 | - | | Phosphite ion (3 ppm by mass) | | |
| Example 16 | 16 | | | | P-I-3 | - | | Hypophosphite ion (3 ppm by mass) | | |
| Example 17 | 17 | | | | P-I-1 | - | | Phosphate ion (0.50 ppm by mass) | | |
| Example 18 | 18 | | | | | - | | Phosphate ion (1 ppm by mass) | | |
| Example 19 | 19 | | | | | - | | Phosphate ion (40 ppm by mass) | | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | compound containing specific ion and elerent | Specific compound | Content of aromatic compound in composition | Content in total solid content of composition | Content of water in composition | |
| Example 20 | 20 | | | | CA-I-1 | - | | Fomate ion (3 ppm by mass) | | |
| Example 21 | 21 | | | | F-I-1 | - | | Fluoride ion (3 ppm by mass)<br>F element (1.2 ppm by mass) | | |
| Example 22 | 22 | | | | P-I-1 | SA-2 | | S4-2 (1 ppm by mass)<br>S element (0.19 ppm by mass)<br>Phosphate ion (1 ppm by mass) | | |

[Table 3-2]

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compound containing specific ion and element | Specific compound | Content of aromatic compound in composition | Content in total solid content of composition | Content of water in composition | |
| Example 1 | 1 | PI-1 (45) | | Ar-2 | - | SA-2 | Ar-2 (3 ppm by mass) | SA-2 (3 ppm by mass) S element (0.56 ppm by mass) | Water (1.0% by mass) | PGMEA/EL /GBL = 50 /40/10 |
| Example 23 | 23 | | | | - | SA-1 | | SA-1 (3 ppm by mass) S element (1 ppm by mass) | | |
| Example 24 | 24 | | | | - | SA-3 | | SA-3 (3 ppm by mass) S element (0.64 ppm by mass) | | |
| Example 25 | 25 | | | | - | SA-4 | | SA-4 (3 ppm by mass) S element (0.43 ppm by mass ) | | |
| Example 26 | 26 | | | | - | SA-5 | | SA-5 (3 ppm by mass) S element (0.52 ppm by mass) | | |
| Example 27 | 27 | PIP-3 (15) | f-1 (5) | | - | SA-2 | | SA-2 (0.50 ppm by mass) S element (0.09 ppm by mass) | | |
| Example 28 | 28 | b-1 (15) | f-3 (5) | | - | | | SA-2 (1 ppm by mass) S element (0.19 ppm by mass) | | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compound containing specific ion and element | Specific compound | Content of aromatic compound in composition | Content in total solid content of composition | Content of water in composition | |
| Example 29 | 29 | b-3 (25) c-1 (10) | j-1 (1) k-1 (3) | | - | | | SA-2 (40 ppm by mass) S element (7.5 ppm by mass) | | |
| Example 30 | 30 | | | | - | PA-1 | | PA-1 (3 ppm by mass) | | |
| Example 31 | 31 | | | | - | PA-2 | | PA-2 (3 ppm by mass) | | |
| Example 32 | 32 | | | | - | PA-3 | | PA-3 (3 ppm by mass) | | |
| Example 33 | 33 | | | | - | PA-1 | | PA-1 (0.50 ppm by mass) | | |
| Example 34 | 34 | | | | - | | | PA-1 (1 ppm by mass) | | |
| Example 35 | 35 | | | | - | | | PA-1 (40 ppm by mass) | | |
| Example 36 | 36 | | | | - | FA-1 | | FA-1 (3 ppm by mass) | | |
| Example 37 | 37 | | | | - | FA-2 | | FA-2 (3 ppm by mass) | | |
| Example 38 | 38 | | | | - | FA-3 | | FA-3 (3 ppm by mass) | | |
| Example 39 | 39 | | | | - | FA-1 | | FA-1 (0.5 ppm by mass) | | |
| Example 40 | 40 | | | | - | | | FA-1 (1 ppm by mass) | | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compound containing specific ion and element | Specific compound | Content of aromatic compound in composition | Content in total solid content of composition | Content of water in composition | |
| Example 41 | 41 | | | | - | | | FA-1 (40 ppm by mass) | | |

[Table 3-3]

| | Composition | Composition [parts by mass] | | | | | | | | Solvent |
|---|---|---|---|---|---|---|---|---|---|---|
| | | Binder resin (A) Compound (B) Photosensitizer (C) | Cross-linkirg agent (F) Sensitizer Adhesion promoter | Specific aromatic compound | Compound containing secific ion and element | Specific compound | Content in composition | Content in total solid content of composition | | |
| Example 1 | 1 | | | | - | | | | - | |
| Example 42 | 42 | | | | Cl-1 | | | | Cl element (3 ppm by mass) | |
| Example 43 | 43 | | | | Cl-2 | | | | Cl element (3 ppm by mass) | |
| Example 44 | 44 | | | | Br-1 | | | | Br element (3 ppm by mass) | |
| Example 45 | 45 | | | Ar-2 | Br-2 | SA-2 | | SA-2 (3 ppm by mass) S elerent (0.56 ppm by mass) | (3 ppm by mass) | PGMEA/EL/GEL = 50/40/10 |
| Example 46 | 46 | PI-1(45) | | | | | Ar-2 (3 ppm by mass) | | Cl element (0.50 ppm by mass) | |
| Example 47 | 47 | PIP-3(15) | f-1 (5) | | Cl-1 | | | | Cl element (1 ppm by mass) | |
| Example 48 | 48 | b-1(15) | f-3 (5) | | | | Water(1.0% by mass) | | Cl element (40 ppm by mass) | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linkirg agent (F) Sensitizer Adhesion promoter | Specific aromatic compound | Compound containing secific ion and element | Specific compound | Content in composition | Content in total solid content of composition | | |
| Example 49 | 49 | b-3(25) | j-1 (1) | | Sc-1 | | | | S element (3 ppm by mass) | |
| Example 50 | 50 | c-1(10) | k-1 (3) | | Sc-2 | | | | S element (3 ppm by mass) | |
| Example 51 | 51 | | | | Sc-1 | | | | S element (0.50 ppm by mass) | |
| Example 52 | 52 | | | | | | | | S element (1 ppm by mass) | |
| Example 53 | 53 | | | | | | | | S element (40 ppm by mass) | |
| Example 54 | 54 | | | | - | | Ar-2 (3 ppm by mass) Water (0.10% by mass) | | - | |
| Example 55 | 55 | | | | - | | Ar-2 (3 ppm by mass) Water (0.50% by mass) | | | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linkirg agent (F) Sensitizer Adhesion promoter | Specific aromatic compound | Compound containing secific ion and element | Specific compound | Content in composition | Content in total solid content of composition | | |
| Example 56 | 56 | | | | - | | Ar-2 (3 ppm by = )<br>Water (1.5% by mass ) | | | |

[Table 3-4]

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compoud containing secific ion and element | Specific compound | Content in composition | Content in total solid content of composition | | |
| Example 1 | 1 | | | | - | SA-2 | | | - | |
| Example 57 | 57 | | | | - | SA-2 Nc-1 | | | Nc-1 (1.0% by mass) | |
| Example 58 | 58 | | | | - | SA-2 Nc-2 | | | Nc-2 (1.0% by mass) | |
| Example 59 | 59 | | | | - | SA-2 Nc-3 | | | Nc-3 (1.0% by mass) | |
| Example 60 | 60 | | | | - | SA-2 Nc-4 | | | Nc-4 (1.0% by mass) | |
| Example 61 | 61 | | | Ar-2 | - | SA-2 Nc-5 | | | Nc-5 (1.0% by mass) | PGMEA/EL/GEL = 50/40/10 |
| Example 62 | 62 | | | | - | SA-2 Nc-6 | | | Nc-6 (1.0% by mass) | |
| Example 63 | 63 | | | | - | SA-2 Nc-7 | | | Nc-7 (1.0% by mass) | |
| Example 64 | 64 | | | | - | SA-2 Nc-8 | | | Nc-8 (1.0% by mass) | |
| Example 65 | 65 | | | | - | | | | Nc-3 (0.10% by mass) | |
| Example 66 | 66 | | | | - | SA-2 Nc-3 | | | Nc-3 (0.50% by mass) | |
| Example 67 | 67 | PI-1(45) (15) | | | - | | | | Nc-3 (2.0% by mass) | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compoud containing secific ion and element | Specific compound | Content in composition | Content in total solid content of composition | | |
| Example 68 | 68 | PIP-3 15)<br>b-1 (25)<br>b-3<br>c-1(10) | f-1 (5) | | Mt-1 | SA-2 Nc-3 | Ar-2 (3 ppm by mass)<br>Water (1.0% by mass) | SA-2 (3 ppm by nass)<br>S ele-ment (0.56 ppm by nass) | Nc-3 (1.0% by mass) Na element (3 ppm by mass) | |
| Example 69 | 69 | | f-3 (5) | | Mt-2 | | | | Nc-3 (1.0% by mass) K element (3 ppm by mass) | |
| Example 70 | 70 | | j-1 (1) | | Mt-3 | | | | Nc-3 (1.0% by mass) Mg element (3 ppm by mass) | |
| Example 71 | 71 | | k-1 (3) | | Mt-4 | | | | Nc-3 (1.0% by mass) Ca element (3 ppm by mass) | |
| Example 72 | 72 | | | | Mt-5 | | | | Nc-3 (1.0% by mass) Fe element (3 ppm by mass) | |
| Example 73 | 73 | | | | Mt-6 | | | | Nc-3 (1.0% by mass) | |

(continued)

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compoud containing secific ion and element | Specific compound | Content in composition | Content in total solid content of composition | | |
| | | | | | | | | | Cu element (3 ppm by mass) | |
| Example 74 | 74 | | | | Mt-7 | | | | Nc-3 (1.0% by mass) Cr element (3 ppm by mass) | |
| Example 75 | 75 | | | | Mt-1 | SA-2 Nc-3 | | | Nc-3 (0.10% by mass) Na element (0.50 ppm by mass) | |
| Example 76 | 76 | | | | | | | | Nc-3 (0.50% by mass) Na element (1 ppm by mass) | |
| Example 77 | 77 | | | | | | | | Nc-3 (2.0% by mass) Na element (40 ppm by mass) | |

[Table 3-5]

| | Composition | Composition [parts by mass] | | | | | | | | Solvent |
|---|---|---|---|---|---|---|---|---|---|---|
| | | Birder resin (A) Compound (B) Photosensitizer (C) | Cross-linking agent (F) Sensitizer Adhesion praroter | Specific aromatic compound | compound containing specific ion and element | secific compound | Content in composition | Content in total solid content of composition | | |
| Example 1 | 1 | PI-1(45) PIP-3 (15) | f-1(5) | Ar-2 | - | SA-2 | (3 ppm by mass) Ar-2 (3 ppm by mass) | SA-2 (3 ppm by mass) S element (0.56 ppm by mass) | - | PGMEA/EL/GEL = 50/40/10 |
| Example 78 | 78 | | | | - | SA-2 Cbx-1 | | | Cbx-1 (3 ppm by mass) | |
| Example 79 | 79 | | | | - | SA-2 Cbx-2 | | | Cbx-2 (3 ppm by mass) | |
| Example 80 | 80 | | | | - | SA-2 Cbx-3 | | | Cbx-3 (3 ppm by mass) | |
| Example 81 | 81 | | | | - | SA-2 Cbx-4 | | | Cbx-4 (3 ppm by mass) | |
| Example 82 | 82 | | | | - | SA-2 Cbx-1 | | | Cbx-1 (0.50 ppm by mass) | |
| Example 83 | 83 | | | | - | | | | Cbx-1 (1 ppm by mass) | |
| Example 84 | 84 | | | | - | | | | Cbx-1 (40 ppm by mass) | |
| Example 85 | 85 | | | | - | SA-2 Cbx-1 | | | Cbx-1 (3 ppm by mass) | |

(continued)

| | Composition | Composition [parts by mass] | | | | | | | | Solvent |
|---|---|---|---|---|---|---|---|---|---|---|
| | | Birder resin (A) Compound (B) Photosensitizer (C) | Cross-linking agent (F) Sensitizer Adhesion praroter | Specific aromatic compound | compound containing specific ion and element | secific compound | Content in composition | Content in total solid content of composition | | |
| | | b-1 (15) b-3(25) c-1(10) | f-3(5) j-1 (1) k-1 (3) | | | Cbx-1 | Water (1.0% by mass) | | Oxm-1 (3 ppm by mass) | |
| Example 86 | 86 | | | | - | SA-2 Cbx-1 Oxm-2 | | | Cbx-1 (3 ppm by mass) Oxm-2 (3 ppm by mass) | |
| Example 87 | 87 | | | | - | SA-2 Cbx-1 Oxm-3 | | SA-2 (3 ppm by mass) S element (0.96 ppm by mass) | Cbx-1 (3 ppm by mass) Oxm-3 (3 ppm by mass) | |
| Example 88 | 88 | | | | - | SA-2 Cbx-1 Oxm-4 | | SA-2 (3 ppm by mass) | Cbx-1 (3 ppm by mass) Oxm-4 (3 ppm by nass) | |
| Example 89 | 89 | | | | - | | | | Cbx-1 (0.50 ppm by mass) Oxm-1 (0.50 ppm by mass) | |

(continued)

| | Composition | Composition [parts by mass] | | | | | | | | Solvent |
|---|---|---|---|---|---|---|---|---|---|---|
| | | Birder resin (A) Compound (B) Photosensitizer (C) | Cross-linking agent (F) Sensitizer Adhesion praroter | Specific aromatic compound | compound containing specific ion and element | secific compound | Content in composition | Content in total solid content of composition | | |
| Example 90 | 90 | | | | - | SA-2 Cbx-1 Oxm-1 | | S element (0.56 ppm by mass) | Cbx-1 (1 ppm by mass) Oxm-1 (1 ppm by nass) | |
| Example 91 | 91 | | | | - | | | | Cbx-1 (40 ppm by mass) Oxm-1 (40 ppm by mass) | |

[Table 3-6]

| | Composition | Composition [parts by mass] | | | | | | | | Solvent |
|---|---|---|---|---|---|---|---|---|---|---|
| | | Binder resin (A) | | | | Compound (B) Photosensitizer (C) | Cross-linking agent (F) Sensitizer Adhesion promoter | Content in composition | Content in total solid content of composition | |
| | | Resin (A1) | | Resin (A2) | Resin (A3) | | | | | |
| Example 1 | 1 | PI-1 (45) | PIP-3 (15) | - | - | b-1(15) b-3(25) c-1(10) | f-1 (5) f-3 (5) j-1 (1) k-1 (3) | Ar-2 (3 ppm by mass) Water (1.0% by mass) | SA-2 (3 ppm by mass) S element (0.56 ppm by mass) | PGMEA/EL /GBL = 50/ 40/10 |
| Example 92 | 92 | PI-2 (45) | | - | - | | | | | |
| Example 93 | 93 | PI-3 (45) | | - | - | | | | | |
| Example 94 | 94 | PI-1 (45) | PI-4 (15) | - | - | | | | | |
| Example 95 | 95 | | PIP-2 (15) | - | - | | | | | |
| Example 96 | 96 | PIP-1 (45) | PIP-2 (15) | - | - | | | | | |
| Example 97 | 97 | | PIP-3 (15) | - | - | | | | | |
| Example 98 | 98 | PB-1 (45) | PIP-3 (15) | - | - | | | | | |
| Example 99 | 99 | PBP-1 (45) | | - | - | | | | | |
| Example 100 | 100 | PAI-1 (45) | | - | - | | | | | |
| Example 101 | 101 | PI-1 (30) PS-1 (15) | PIP-3 (15) | - | - | | | | | |

[Table 3-7]

| | Composition | Composition [parts by mass] | | | | | | | | Solvent |
|---|---|---|---|---|---|---|---|---|---|---|
| | | Binder resin (A) | | | | Compound (B) Photosensitizer (C) | Cross-linking agent (F) Sensitizer Adhesion promoter | Content in composition | Content in total solid content of composition | |
| | | Resin (A1) | | Resin (A2) | Resin (A3) | | | | | |
| Example 1 | 1 | PI-1 (45) | PIP-3 (15) | - | - | b-1(15)<br>b-3(25)<br>c-1(10) | f-1 (5)<br>f-3 (5)<br>j-1 (1)<br>k-1 (3) | Ar-2 (3 ppm by mass)<br>Water (1.0% by mass) | SA-2 (3 ppm by mass)<br>S element (0.56 ppm by mass) | PGMEA/GEL = 50/40/10 |
| Example 102 | 102 | PI-1 (35) | PIP-3 (10) | ER-1 (15) | - | | | | | |
| Example 103 | 103 | | | ER-2 (15) | - | | | | | |
| Example 104 | 104 | | | ER-3 (15) | - | | | | | |
| Example 105 | 105 | | | ER-4 (15) | - | | | | | |
| Example 106 | 106 | | | PHS-1 (15) | - | | | | | |
| Example 107 | 107 | | | PAC-1 (15) | - | | | | | |
| Example 108 | 108 | | | PAC-2 (15) | - | | | | | |
| Example 109 | 109 | | | - | CR-1 (15) | | | | | |
| Example 110 | 110 | | | - | PE-1 (15) | | | | | |
| Example 111 | 111 | | | - | AC-1 (15) | | | | | |
| Example 112 | 112 | PI-1 (30) | PIP-3 (10) | ER-1 (10) | CR-1 (10) | | | | | |

[Table 3-8]

| | Composition | Composition [parts by mass] | | | | | | | | | Solvent |
|---|---|---|---|---|---|---|---|---|---|---|---|
| | | Binder resin (A) | Compound (B) | | | | Photosensitizer (C) | Cross-linking agent (F) Sensitizer Adhesion promoter | Content in composition | Content in total solid content of composition | |
| | | | (B1) Compound | (B2) Compound | (B3) Compound | (B4) Compound | | | | | |
| Example 1 | 1 | | b-1 (15) | b-3 | - | - | | | | | |
| Example 113 | 113 | PI-1 (45) | b-2 (15) | (25) | - | - | c-1 (10) | | | SA-2 (3 ppm by mass) | |
| Example 114 | 114 | PIP-3 (15) | b-1 (15) | b-3 (20) b-4 (5) | - | - | | | Ar-2(3 ppm by mass) | S element (0.56 ppm by mass) | |
| Example 115 | 115 | | - | - | | b-6 (25) | | f-1(5) | | | |
| Example 116 | 116 | PIP-1 (45) | - | - | b-5 | b-7 (25) | | f-3(5) | | | |
| Example 117 | 117 | PIP-3 (15) | - | - | (15) | b-8 (25) | | j-1(1) | | | PGMEA/EL /GBL = 50/ 40/10 |
| Example 118 | 118 | | - | - | | b-9 (25) | | k-1(3) | | SA-2 (3 ppm by mass) | |
| Example 119 | 119 | | b-2 | - | | b-9 (15) | c-3 (10) | | | S element (6,927 ppm by mass) | |
| Example 120 | 120 | PI-1 | (25) | - | - | b-8 (15) | | | Water(1.0% by mass) | | |
| Example 121 | 121 | (45) PIP-3 | - | b-3 | | b-9 (15) | | | | | |
| Example 122 | 122 | (15) | - | (25) | - | b-8 (15) | | | | | |
| Example 123 | 123 | | b-2 (20) | b-4 (5) | - | b-8 (15) | | | | | |

[Table 3-9]

| | Composition | Composition [parts by mass] | | | | | | | | | | Solvent |
|---|---|---|---|---|---|---|---|---|---|---|---|---|
| | | Birder resin (A) Sensitizer Adhesion promoter | Compound (B) | | | | Photosensitizer (C) | Cross-linking agent (F) | Inorganic particles (G) | Content in composition | Content in total solid content of composition | |
| | | | (B1) Compound | (B2) Compound | (B3) Compound | (B4) Compound | | | | | | |
| Example 1 | 1 | | | | - | - | c-1 (10) | | - | | SA-2 (3 ppm by mass) S element (0.56 ppm by mass) | |
| Example 124 | 124 | | | | - | - | c-6 (10) | f-1 (5) | - | | | |
| Example 125 | 125 | PI-1(45) | | | - | - | c-7 (10) | f-3 (5) | - | | | |
| Example 126 | 126 | PIP-3(15) | b-1 (15) | b-3 (25) | - | - | c-8 (10) | | - | | SA-2 (3 ppm by mass) S element (4,056 ppm by mass) | |
| Example 127 | 127 | j-1 (1) | | | - | - | c-1 (10) | f-1 (5) | - | Ar-2 (3 ppm by mass) Water (1.0% by mass) | | PGMEA /EL /GBL =50/ 40/10 |
| Example 128 | 128 | | | | - | - | | f-2(5) | SP-1 (20) | | SA-2 (3 ppm by mass) S element (0.56 ppm by mass) | |
| Example 129 | 129 | k-1(3) | | | - | - | c-6 (10) | f-1(5) | SP-2 (20) | | | |
| Example 130 | 130 | | | | - | - | | f-3(5) | SP-3 (20) | | | |
| Example 115 | 115 | (45) PIP-1 | - | - | b-5 (15) | b-6 (25) | c-3 (10) | | - | | SA-2 (3 ppm by mass) S element (6,927 ppm by mass) | |

(continued)

| | Composition | Composition [parts by mass] | | | | | | | | | | Solvent |
|---|---|---|---|---|---|---|---|---|---|---|---|---|
| | | Birder resin (A) Sensitizer Adhesion promoter | Compound (B) | | | | Photosensitizer (C) | Cross-linking agent (F) | Inorganic particles (G) | Content in composition | Content in total solid content of composition | |
| | | | (B1) Compound | (B2) Compound | (B3) Compound | (B4) Compound | | | | | | |
| Example 131 | 131 | PIP-3(15) j-1(1) k-1(3) | - | - | | | c-2 (10) | f-1(5) f-3(5) | - | | | |
| Example 132 | 132 | | - | - | | | c-4 (10) | | - | | SA-2 (3 ppm by mass) S elerent (0.56 ppm by mass) | |
| Example 133 | 133 | | - | - | | | c-5 (10) | | - | | | |
| Example 134 | 134 | | - | - | | | c-9 (10) | | - | | | |
| Example 119 | 119 | PI-1 (45) | b-2 (25) | - | - | b-9 (15) | c-3 (10) | f-1 (5) | - | | SA-2 (3 ppm by mass) S element (6,927 ppm by mass) | |
| Example 135 | 135 | PIP-3 (15) j-1 (1) k-1 (3) | | - | - | | c-7 (10) | f-3 (5) | - | | SA-2 (3 ppm by mass) S element (0.56 ppm by mass) | |

[Table 3-10]

| | Composition | Composition [parts by mass] | | | | | | | | | Solvent |
|---|---|---|---|---|---|---|---|---|---|---|---|
| | | Binder resin (A) Compound (B) | Cross-linking agent (F) Sensitizer Adhesion promoter | Photosensitizer (C) Dissolution accelerator | Pigment dispersion liquid | Contents of pigment dispersion liquid: Colorant (D) | Contents of pigment dispersion liquid: Dispersant (E) | Colorant not derived from pigment dispersion liquid | Content in composition | Content in total solid content of composition | |
| Example 123 | 123 | | | c-3 (10) | - | - | - | - | | SA-2 (3 ppm by mass)<br>S elerent (6,927 ppm by mass) | |
| Example 136 | 136 | | | | Bk-1 | Bk-S0100CF (21.2) | | - | | | |
| Example 137 | 137 | | | | Bk-2 | Bk-FK4280 (21.2) | ADP (7.4) | - | | | |
| Example 138 | 138 | PI-1 (45) | f-1(5) | c-6(10) | Bk-3 | Bk-A1103 (21.2) | | - | | | |
| Example 139 | 139 | PIP-3 (15)<br>b-2 (20)<br>b-4 (5) | f-3(5)<br>j-1(1)<br>k-1(3) | i-1(2) | Bk-4 | P.R.179 (10.0)<br>P.Y.192 (10.0)<br>P.B.60 (13.3) | ADP (11.7) | - | Ar-2 (3 ppm by mass) Water (1.0% by mass) | SA-2(3 ppm by mass)<br>S element(0.56 ppm by mass) | PGMEA/EL/GEL = 50/ 40/10 |
| Example 140 | 140 | b-8 (15) | | | Bk-5 | Bk-CBF1 (21.2) | ADP (7.4) | - | | | |
| Example 141 | 141 | | | | Bk-6 | Ek-CER1 (21.2) | | | | | |
| Example 142 | 142 | | | | - | - | - | A.R.52-B.B.7 (16.7)<br>S.R.18 (6.7)<br>D.Y.201 (10.0) | | | |
| Example 143 | 143 | PI-1(45) | f-1(5) | | | | | A.R.52-B.B.7(16.7) | | SA-2 (3 ppm by mass) | |

(continued)

| | Composition | Composition [parts by mass] | | | | | | | | | Solvent |
|---|---|---|---|---|---|---|---|---|---|---|---|
| | | Binder resin (A) Compound (B) | Cross-linking agent (F) Sensitizer Adhesion promoter | Photosensitizer (C) Dissolution accelerator | Pigment dispersion liquid | Contents of pigment dispersion liquid | | Colorant not derived from pigment dispersion liquid | Content in composition | Content in total solid content of composition | |
| | | | | | | Colorant (D) | Dispersant (E) | | | | |
| | | | | | | | | | | S element (3,757 ppm by mass) | |
| Example 144 | 144 | PIP-1 (30) ER-1 (25) | f-3 (5) k-1 (3) | NQD-1 (20) i-1(5) | - | - | - | S.R.18(6.7) D.Y.201(10.0) | | SA-2 (3 ppm by mass) S element (3,026 ppm by mass) | |

[Table 3-11]

| | Composition | Composition [parts by mass] | | | | | | | | Solvent |
|---|---|---|---|---|---|---|---|---|---|---|
| | | Birder resin (A) | Compund (B) Photosensitizer (C) Cross-linking agent (F) Sensitizer Adhesion promoter | Specific aromatic compound | Compound contining specific ion and element | Specific compound | Content in composition | Content in total solid content of composition | | |
| Example 145 | 145 | PI-5(45) | | | - | | | SA-2 (3 ppm by mass)<br>S element (0.56 ppm by mass) | - | |
| Example 146 | 146 | PI-P-4(15) | b-1(15)<br>b-3(25) | | | | | SA-2 (3 by mass)ppm<br>S element (0.56 ppm by mass)<br>Phosphate ion (3 ppm by mass) | - | |
| Example 147 | 147 | PI-6 (45)<br>PI-P-4(15) | c-1 (10)<br>f-1<br>(5) | Ar-2 | P-I-1 | SA-2 | Ar-2 (3 ppm by mass)<br>Water (1.0% by mass) | SA-2 (3 ppm by mass)<br>S element(11,613 ppm by mass)<br>Phosphate ion (3 ppm by mass) | - | PGMEA/EL /GBL = 50 /40/10 |
| Example 148 | 148 | PI-7 (45)<br>PIP-4 (15) | f-3(5)<br>j-1(1) | | | | | | - | |
| Example 149 | 149 | PI-5 (45) | k-1(3) | | P-I-1 | | | SA-2(3 ppm by mass) | F element (0.50 ppm by mass) | |
| Example 150 | 150 | | | | | | | S element(0.56 ppm by mass) | F element (1 ppm by mass) | |

(continued)

| | Composition | Composition [parts by mass] | | | | | | | | Solvent |
|---|---|---|---|---|---|---|---|---|---|---|
| | | Birder resin (A) | Compund (B) Photosensitizer (C) Cross-linking agent (F) Sensitizer Adhesion promoter | Specific aromatic compound | Compound contining specific ion and element | Specific compound | Content in composition | Content in total solid content of composition | | |
| Example 151 | 151 | PIP-4 (15) | | | Fc-1 | | | Phosphate ion(3 ppm by mass) | F elerent (3 ppm by mass) | |
| Example 152 | 152 | | | | | | | | F element (40 ppm by mass) | |

[Table 3-12]

| | Composition | Composition [parts by mass] | | | | | | | | Solvent |
|---|---|---|---|---|---|---|---|---|---|---|
| | | Binder resin (A) Compound (B) Photosensitizer (C) | Cross-linking agent (F) Sensitizer Adhesion promoter | Specific aromatic compound | Compound containing specific ion and element | Specific compound | Content of aromatic compound in composition | Content in total solid content of composition | Content of water in composition | |
| Comparative Example 1 | 153 | PI-1 (45) PIP-3 (15) b-1 (15) b-3 (25) c-1 (10) | f-1 (5) f-3 (5) j-1 (1) k-1 (3) | - | - | - | - | - | - | PGMEA/EL/GEL = 50/ 40/10 |
| Comparative Example 2 | 154 | | | - | - | - | - | - | Water (1.0% by mass) | |
| Comparative Example 3 | 155 | | | Ar-2 | - | - | Ar-2 (1,500 ppm by mass) | - | | |
| Comparative Example 4 | 156 | | | - | - | SA-2 | | SA-2 (1,500 ppm by mass) S element (279 ppm by mass) | | |
| Comparative Example 5 | 157 | | | - | P-I-1 | - | - | Phosphate ion (1,500 ppm by mass) | | |

<Example 1>

The composition 1 was applied onto an ITO/Ag substrate with the use of a spin coater (MS-A100; manufactured by Mikasa Co., Ltd.), and then prebaked at 120°C for 120 seconds with the use of a buzzer hot plate (HPD-3000BZN; manufactured by AS ONE Corporation) to prepare a prebaked film of about 1.8 μm in film thickness. The prebaked film prepared was subjected to spray development with a 2.38% by mass TMAH aqueous solution or cyclopentanone with the use of a small-size development device (AD-1200; manufactured by TAKIZAWA SANGYO K.K.) for photolithography, and the time at which the prebaked film (unexposed portion) was completely dissolved (Breaking Point; hereinafter, referred to as "BP") was measured.

In the same manner, a prebaked film was prepared, and the prepared prebaked film was subjected to exposure for patterning with the i-ray (wavelength: 365 nm), h-ray (wavelength: 405 nm), and g-ray (wavelength 436 nm) of an ultra-high pressure mercury lamp through a gray scale mask (MDRM MODEL 4000-5-FS; Opto-Line International, Inc.) for sensitivity measurement with the use of a double-sided alignment single-sided exposure apparatus (Mask Aligner PEM-6M; manufactured by Union Optical Co., Ltd.). After the exposure, the film was subjected to development with a 2.38% by mass TMAH aqueous solution with the use of a small-size development device (AD-1200; manufactured by TAKIZAWA SANGYO K.K.) for photolithography, and rinsed with water for 30 seconds to prepare a developed film. The development time was set to 1.3 times the measured BP. When a pattern was failed to be formed after development with a 2.38% by mass TMAH aqueous solution, an exposed film was prepared in the same manner as in the above method, and after the exposure, the film was subjected to development with cyclopentanone with the use of a small-size development device (AD-1200; (manufactured by TAKIZAWA SANGYO K.K.) for photolithography, and rinsed with water for 30 seconds to prepare a developed film. The development time was set to 1.3 times the measured BP. The developed pattern was observed, and an optimum exposure energy (value of i-ray illuminance meter) at which a space pattern corresponding to an opening could be formed with a dimension width of 18 μm in a line-and-space pattern of 20 μm was obtained. After the development with the optimum exposure energy, with the use of a high-temperature inert gas oven (INH-9CD-S; manufactured by Koyo Thermo Systems Co., Ltd.), the pattern after development was subjected to thermal curing at 220°C for 60 minutes to prepare a cured film of about 1.2 μm in film thickness. As thermal curing conditions, the temperature was raised to 220°C at a temperature raising rate of 3.5°C/min in a nitrogen atmosphere having an oxygen concentration of 20 ppm by mass or less, heat treatment was performed at 220°C for 60 minutes, and then the temperature was cooled to 50°C.

The cured film was analyzed by a method such as nuclear magnetic resonance spectroscopy, infrared spectroscopy, or time-of-flight secondary ion mass spectrometry, and the structural unit of the resin contained in the cured film were analyzed. It was confirmed that the cured film of the composition 1 prepared by the above-described method contained the following resin. That is, the cured film of the composition 1 contains a resin having a structure derived from the resin contained in the composition 1.

Resin (XA1): A resin having a structural unit represented by General Formula (1); a resin having a structural unit represented by General Formula (2)

<Examples 2 to 152 and Comparative Examples 1 to 5>

The same operation and evaluation as in Example 1 were performed using each composition shown in Tables 3-1 to 3-12. Evaluation results thereof are collectively shown in Tables 4-1 to 4-12. In order to facilitate comparison, the composition and evaluation results of Example 1 are described in Tables 3-2 to 3-8 and Tables 4-2 to 4-8, respectively. In addition, in Tables 3-9 and 4-9, the composition and evaluation results of Example 1, Example 115, and Example 119 are described. In addition, in Tables 3-10 and 4-10, the composition and evaluation results of Example 123 are described. In Examples 1 to 144 and Comparative Examples 1 to 5, the content of the fluorine element in the total solid content of the composition and the content of the fluorine element in the cured product were more than 1,000 ppm by mass. In Examples 145 to 148, the content of the fluorine element in the total solid content of the composition and the content of the fluorine element in the cured product were 0 ppm by mass. In Examples 149 to 152, the content of the fluorine element in the total solid content of the composition is as shown in Table 3-11, and the content of the fluorine element in the cured product is as shown in Table 4-11.

As thermal curing conditions in Example 142, the temperature was raised to 200°C at a temperature raising rate of 3.5°C/min in a nitrogen atmosphere having an oxygen concentration of 20 ppm by mass or less, heat treatment was performed at 200°C for 60 minutes, and then the temperature was cooled to 50°C. When a composition having positive-type photosensitivity was used in each of Examples described above, a photomask in which a light-transmitting portion and a light-shielding portion were inverted was used as the photomask. The development time was set to 60 seconds, 90 seconds, or 120 seconds, and using a gray scale mask for sensitivity measurement (MDRM MODEL 4000-5-FS; manufactured by Opto-Line International), the optimum exposure energy (i-ray illuminance meter value) at which a space pattern corresponding to an opening could be formed with a dimension width of 20 μm in a 20 μm line-and-space

pattern was obtained. From these results, the optimum development time (60 seconds, 90 seconds, or 120 seconds) and the optimum exposure energy at the development time were determined. After exposure with the optimum exposure energy, the pattern after development at the optimum development time was thermally cured at 200°C for 60 minutes. As thermal curing conditions, the temperature was raised to 200°C at a temperature raising rate of 3.5°C/min in a nitrogen atmosphere having an oxygen concentration of 20 ppm by mass or less, heat treatment was performed at 200°C for 60 minutes, and then the temperature was cooled to 50°C.

[Table 4-1]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) | A | A | - | A | B+ |
| Example 2 | 2 | Ar-2 (15 ppm by mass) | | A | A | - | A | B+ |
| Example 3 | 3 | Ar-2 (15 ppm by mass) | | A | A | - | A | B+ |
| Example 4 | 4 | Ar-2 (15 ppm by mass) | | A | A | - | A | B+ |
| Example 5 | 5 | Ar-2 (2.5 ppm by mass) | S element (0.56 ppm by mass) | A | A+ | - | A+ | B+ |
| Example 6 | 6 | Ar-2 (5 ppm by mass) | | A | A+ | - | A+ | B+ |
| Example 7 | 7 | Ar-2 (200 ppm by mass) | | A | A | - | A | B |
| Example 8 | 8 | Ar-2 (15 ppm by mass) | Chloride ion (3 ppm by mass) Cl element (3 ppm by mass) | A | B+ | - | A | B+ |
| Example 9 | 9 | | Bromide ion (3 ppm by mass) Br element (3 ppm by mass) | A | B+ | - | A | B+ |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 10 | 10 | | Sulfate ion (3 ppm by mass) S element (1 ppm by mass) | A | B+ | - | A | B+ |
| Example 11 | 11 | | Sulfite ion (3 ppm by mass) S element (1.2 ppm by mass) | A | B+ | - | A | B+ |
| Example 12 | 12 | | Nitrate ion (3 ppm by mass) | A | B+ | - | A | B+ |
| Example 13 | 13 | | Nitrite ion (3 ppm by mass) | A | B+ | - | A | B+ |
| Example 14 | 14 | | Phosphate ion (3 ppm by mass) | A | A | - | A | B+ |
| Example 15 | 15 | | Phosphite ion (3 ppm by mass) | A | A | - | A | B+ |
| Example 16 | 16 | | Hypophosphite ion (3 ppm by mass) | A | A | - | A | B+ |
| Example 17 | 17 | | Phosphate ion (0.50 ppm by mass) | A | A+ | - | A | A |
| Example 18 | 18 | | Phosphate ion (1 ppm by mass) | A | A+ | - | A | A |
| Example 19 | 19 | | Phosphate ion (40 ppm by mass) | A | A | - | B+ | B+ |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 20 | 20 | | Formate ion (3 ppm by mass) | A | A | - | A | B+ |
| Example 21 | 21 | | Fluoride ion (3 ppm by mass)<br>F element (1.2 ppm by mass) | A | A | - | A | B+ |
| Example 22 | 22 | | SA-2 (1 ppm by mass)<br>S element (0.19 ppm by mass)<br>Phosphate ion (1 ppm by mass) | A | A+ | - | A+ | A+ |

[Table 4-2]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) S element (0.56 ppm by mass) | A | A | - | A | B+ |
| Example 23 | 23 | | SA-1 (3 ppm by mass) S element (1 ppm by mass) | A | A | - | A | B+ |
| Example 24 | 24 | | SA-3 (3 ppm by mass) S element (0.64 ppm by mass) | A | A | - | A | B+ |
| Example 25 | 25 | | SA-4 (3 ppm by mass) S element (0.43 ppm by mass) | A | A | - | A | B+ |
| Example 26 | 26 | | SA-5 (3 ppm by mass) S element (0.52 ppm by mass) | A | A | - | A | B+ |
| Example 27 | 27 | | SA-2 (0.50 ppm by mass) | A | A | - | A+ | A |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| | | | S element (0.09 ppm by mass) | | | | | |
| Example 28 | 28 | | SA-2 (1 ppm by mass) S element (0.19 ppm by mass) | A | A | - | A+ | A |
| Example 29 | 29 | | SA-2 (40 ppm by mass) S element (7.5 ppm by mass) | A | B+ | - | A | B+ |
| Example 30 | 30 | | PA-1 (3 ppm by mass) | A | A | - | A | B+ |
| Example 31 | 31 | | PA-2 (3 ppm by mass) | A | A | - | A | B+ |
| Example 32 | 32 | | PA-3 (3 ppm by mass) | A | A | - | A | B+ |
| Example 33 | 33 | | PA-1 (0.50 ppm by mass) | A | A+ | - | A | A+ |
| Example 34 | 34 | | PA-1 (1 ppm by mass) | A | A+ | - | A | A+ |
| Example 35 | 35 | | PA-1 (40 ppm by mass) | A | A | - | B+ | B+ |
| Example 36 | 36 | | FA-1 (3 ppm by mass) | A | A | - | A | B+ |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 37 | 37 | | FA-2 (3 ppm by mass) | A | A | - | A | B+ |
| Example 38 | 38 | | FA-3 (3 ppm by mass) | A | A | - | A | B+ |
| Example 39 | 39 | | FA-1 (0.5 ppm by mass) | A | A | - | A+ | A |
| Example 40 | 40 | | FA-1 (1 ppm by mass) | A | A | - | A+ | A |
| Example 41 | 41 | | FA-1 (40 ppm by mass) | A | B+ | - | A | B+ |

[Table 4-3]

| | Composition | Composition of cured film | | | Photosensitive property | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| Example 1 | 1 | Ar-2 (15 ppm by mass) | SA-2 (3 ppm by mass) | - | A | A | - | A | B+ |
| Example 42 | 42 | | | Cl element (3 ppm by mass) | A | A | - | A | A+ |
| Example 43 | 43 | | | Cl element (3 ppm by mass) | A | A | - | A | A+ |
| Example 44 | 44 | | | Br element (3 ppm by mass) | A | A | - | A | A+ |
| Example 45 | 45 | | | Br element (3 ppm by mass) | A | A | - | A | A+ |
| Example 46 | 46 | | | Cl element (0.50 ppm by mass) | A | A | - | A+ | A+ |
| Example 47 | 47 | | | Cl element (1 ppm by mass) | A | A | - | A+ | A+ |
| Example 48 | 48 | | | Cl element (40 ppm by mass) | A | A | - | A | A |
| Example 49 | 49 | | S element (0.56 ppm by mass) | S element (3 ppm by mass) | A | A | - | A | A+ |
| Example 50 | 50 | | | S element (3 ppm by mass) | A | A | - | A | A+ |
| Example 51 | 51 | | | S element (0.50 ppm by mass) | A | A | - | A+ | A+ |
| Example 52 | 52 | | | S element (1 ppm by mass) | A | A | - | A+ | A+ |
| Example 53 | 53 | | | S element (40 ppm by mass) | A | A | - | A | A |

(continued)

| | Composition | Composition of cured film | | | Photosensitive property | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| Example 54 | 54 | | | - | A | A | - | A | A+ |
| Example 55 | 55 | | | - | A | A | - | A | A |
| Example 56 | 56 | | | - | A | A | - | A | B |

[Table 4-4]

| | Composition | Composition of cured film | | | Photosensitive roperty | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| Example 1 | 1 | Ar-2 (15 ppm by mass) | SA-2 (3 ppm by mass) | - | A | A | - | A | B+ |
| Example 57 | 57 | | | Nc-1 (1.0% by mass) | A | A | - | A | A+ |
| Example 58 | 58 | | | Nc-2 (1.0% by mass) | A | A | - | A | A+ |
| Example 59 | 59 | | | Nc-3 (1.0% by mass) | A | A | - | A | A+ |
| Example 60 | 60 | | | Nc-4 (1.0% by mass) | A | A | - | A | A+ |
| Example 61 | 61 | | | Nc-5 (1.0% by mass) | A | A | - | A | A+ |
| Example 62 | 62 | | | Nc-6 (1.0% by mass) | A | A | - | A | A+ |
| Example 63 | 63 | | | Nc-7 (1.0% by mass) | A | A | - | A | A+ |
| Example 64 | 64 | | | Nc-8 (1.0% by mass) | A | A | - | A | A+ |
| Example 65 | 65 | | | Nc-3 (0.10% by mass) | A | A+ | - | A | A+ |
| Example 66 | 66 | | | Nc-3 (0.50% by mass) | A | A+ | - | A | A+ |
| Example 67 | 67 | | | Nc-3 (2.0% by mass) | A | A | - | A | A |
| Example 68 | 68 | | | Nc-3 (1.0% by mass) | A | A | - | A+ | A+ |

(continued)

| | Composition | Composition of cured film | | | Photosensitive roperty | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| | | | S element (0.56 ppm by mass) | Na element (3 ppm by mass) | | | | | |
| Example 69 | 69 | | | Nc-3 (1.0% by mass) K element (3 ppm by mass) | A | A | - | A+ | A+ |
| Example 70 | 70 | | | Nc-3 (1.0% by mass) Mg element (3 ppm by mass) | A | A | - | A+ | A+ |
| Example 71 | 71 | | | Nc-3 (1.0% by mass) Ca element (3 ppm by mass) | A | A | - | A+ | A+ |
| Example 72 | 72 | | | Nc-3 (1.0% by mass) Fe element (3 ppm by mass) | A | A | - | A+ | A+ |
| Example 73 | 73 | | | Nc-3 (1.0% by mass) Cu element (3 ppm by mass) | A | A | - | A+ | A+ |
| Example 74 | 74 | | | Nc-3 (1.0% by mass) Cr element (3 ppm by mass) | A | A | - | A+ | A+ |
| Example 75 | 75 | | | Nc-3 (0.10% by mass) Na element (0.50 ppm by mass) | A | A+ | - | A+ | A+ |
| Example 76 | 76 | | | Nc-3 (0.50% by mass) Na element (1 ppm by mass) | A | A+ | - | A+ | A+ |

(continued)

| | Composition | Composition of cured film | | | Photosensitive roperty | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| Example 77 | 77 | | | Nc-3 (2.0% by mass)<br>Na element (40 ppm by mass) | A | A | - | A | A+ |

[Table 4-5]

| | Composition | Composition of cured film | | | Photosensitive property | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| Example 1 | 1 | | | - | A | A | - | A | B+ |
| Example 78 | 78 | | | Cbx-1 (3 ppm by mass) | A | A | - | A | A+ |
| Example 79 | 79 | | SA-2 (3 ppm by mass) | Cbx-2 (3 ppm by mass) | A | A | - | A | A+ |
| Example 80 | 80 | | | Cbx-3 (3 ppm by mass) | A | A | - | A | A+ |
| Example 81 | 81 | | | Cbx-4 (3 ppm by mass) | A | A | - | A | A+ |
| Example 82 | 82 | | | Cbx-1 (0.50 ppm by mass) | A | A+ | - | A | A+ |
| Example 83 | 83 | Ar-2 (15 ppm by mass) | | Cbx-1 (1 ppm by mass) | A | A+ | - | A | A+ |
| Example 84 | 84 | | | Cbx-1 (40 ppm by mass) | A | A | - | A | A |
| Example 85 | 85 | | S element (0.56 ppm by mass) | Cbx-1 (3 ppm by mass) Oxm-1 (3 ppm by mass) | A+ | A | - | A | A+ |
| Example 86 | 86 | | | Cbx-1 (3 ppm by mass) Oxm-2 (3 ppm by mass) | A+ | A | - | A | A+ |
| Example 87 | 87 | | SA-2 (3 ppm by mass) | Cbx-1 (3 ppm by mass) | A+ | A | - | A | A+ |

(continued)

| | Composition | Composition of cured film | | | Photosensitive property | | Cured film characteristics /electrical characteristics | | |
|---|---|---|---|---|---|---|---|---|---|
| | | Content of aromatic compound in cured film | Content in cured film | | Sensitivity | Development residue | Light-shielding property OD value | Mechanical physical properties | Migration resistance |
| | | | S element (0.96 ppm by mass) | Oxm-3 (3 ppm by mass) | | | | | |
| Example 88 | 88 | | SA-2 (3 ppm by mass) | Cbx-1 (3 ppm by mass) Oxm-4 (3 ppm by mass) | A+ | A | - | A | A+ |
| Example 89 | 89 | | | Cbx-1 (0.50 ppm by mass) Oxm-1 (0.50 ppm by mass) | A+ | A+ | - | A | A+ |
| Example 90 | 90 | | S element (0.56 ppm by mass) | Cbx-1 (1 ppm by mass) Oxm-1 (1 ppm by mass) | A+ | A+ | - | A | A+ |
| Example 91 | 91 | | | Cbx-1 (40 ppm by mass) Oxm-1 (40 ppm by mass) | A | A | - | A | A+ |

[Table 4-6]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) | A | A | - | A | B+ |
| Example 92 | 92 | | | B+ | B+ | - | A | B+ |
| Example 93 | 93 | | | A+ | B+ | - | A+ | B+ |
| Example 94 | 94 | | | B+ | B+ | - | A | B+ |
| Example 95 | 95 | | | B+ | A | - | A | B+ |
| Example 96 | 96 | | | A | B+ | - | A | B+ |
| Example 97 | 97 | | | A+ | B+ | - | A | B+ |
| Example 98 | 98 | | S element (0.56 ppm by mass) | A | B+ | - | A | B+ |
| Example 99 | 99 | | | A+ | B+ | - | A | B+ |
| Example 100 | 100 | | | A | B+ | - | A | B+ |
| Example 101 | 101 | | | A+ | B+ | - | A | B+ |

[Table 4-7]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) S element (0.56 ppm by mass) | A | A | - | A | B+ |
| Example 102 | 102 | | | A | A+ | - | A+ | B+ |
| Example 103 | 103 | | | A | A+ | - | A+ | B+ |
| Example 104 | 104 | | | A | A+ | - | A+ | B+ |
| Example 105 | 105 | | | A | A+ | - | A | B+ |
| Example 106 | 106 | | | B+ | A+ | - | A | B+ |
| Example 107 | 107 | | | A | A+ | - | A | B+ |
| Example 108 | 108 | | | A | A+ | - | A | B+ |
| Example 109 | 109 | | | A+ | A | - | A+ | B+ |
| Example 110 | 110 | | | A+ | A | - | A+ | B+ |
| Example 111 | 111 | | | A+ | A | - | A | B+ |
| Example 112 | 112 | | | A+ | A+ | - | A+ | B+ |

[Table 4-8]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) | A | A | - | A | B+ |
| Example 113 | 113 | | | A | A | - | A | A |
| Example 114 | 114 | | S element (0.56 ppm by mass) | A | A | - | A+ | B+ |
| Example 115 | 115 | | SA-2 (3 ppm by mass) S element (6,927 ppm by mass) | A | B+ | - | A | A |
| Example 116 | 116 | | | A+ | B+ | - | A | A |
| Example 117 | 117 | | | A+ | A | - | A+ | B+ |
| Example 118 | 118 | | | A | B+ | - | A | B+ |
| Example 119 | 119 | | | A | A | - | B+ | A |
| Example 120 | 120 | | | A+ | A | - | A | A |
| Example 121 | 121 | | | A | A | - | A | B+ |
| Example 122 | 122 | | | A+ | A | - | A+ | B+ |
| Example 123 | 123 | | | A+ | A | - | A+ | A |

[Table 4-9]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 1 | 1 | Ar-2 (15 ppm by mass) | SA-2 (3 ppm by mass) | A | A | - | A | B+ |
| Example 124 | 124 | | | A+ | A | - | A+ | B+ |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 125 | 125 | | S element (0.56 ppm by mass) | A+ | A | - | A+ | B+ |
| Example 126 | 126 | | SA-2 (3 ppm by mass) S element (4,056 ppm by mass) | A+ | A | - | A+ | B+ |
| Example 127 | 127 | | SA-2 (3 ppm by mass) S element (0.56 ppm by mass) | A | A | - | A | B+ |
| Example 128 | 128 | | | A+ | A | - | A+ | A+ |
| Example 129 | 129 | | | A+ | A | - | A+ | A |
| Example 130 | 130 | | | A+ | A | - | A+ | A |
| Example 115 | 115 | | SA-2 (3 ppm by mass) S element (6,927 ppm by mass) | A | B+ | - | A | A |
| Example 131 | 131 | | SA-2 (3 ppm by mass) S element (0.56 ppm by mass) | A | B+ | - | A+ | A |
| Example 132 | 132 | | | A | B+ | - | A | A |
| Example 133 | 133 | | | A | B+ | - | A+ | A |
| Example 134 | 134 | | | B+ | B+ | - | A | B+ |
| Example 119 | 119 | | SA-2 (3 ppm by mass) | A | A | - | B+ | A |

(continued)

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| | | | S element (6,927 ppm by mass) | | | | | |
| Example 135 | 135 | | SA-2 (3 ppm by mass) S element (0.56 ppm by mass) | A+ | A | - | A | A |

[Table 4-10]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Example 123 | 123 | Ar-2 (15 ppm by mass) | SA-2 (3 ppm by mass) *S* element (6,927 ppm by mass) | A+ | A | - | A+ | A |
| Example 136 | 136 | | SA-2 (3 ppm by mass) *S* element (0.56 ppm by mass) | A | B+ | 0.6 | A | B+ |
| Example 137 | 137 | | | B+ | B+ | 0.5 | B+ | B+ |
| Example 138 | 138 | | | B+ | B+ | 0.6 | B+ | B+ |
| Example 139 | 139 | | | B | B | 0.6 | B | B |
| Example 140 | 140 | | | A | A | 0.6 | A | A |
| Example 141 | 141 | | | B+ | A | 0.5 | B+ | A |
| Example 142 | 142 | | | B | B+ | 0.6 | A | B+ |
| Example 143 | 143 | | SA-2 (3 ppm by mass) *S* element (3,757 ppm by mass) | B | A | - | A+ | A |
| Example 144 | 144 | | SA-2 (3 ppm by mass) *S* element (3,026 ppm by mass) | C | B | 0.6 | A | B+ |

[Table 4-11]

| | Composition | Composition of cured film | | | Photosensitive property | | Cured film characteristics /electrical characteristics | | |
|---|---|---|---|---|---|---|---|---|---|
| | | Content of aromatic compound in cured film | Content in cured film | Content in cured film | Sensitivity | Development residue | Light-shielding property OD value | Mechanical physical properties | Migration resistance |
| Example 145 | 145 | Ar-2 (15 ppm by mass) | SA-2 (3 ppm by mass)<br>S element (0.56 ppm by mass) | - | A | A | - | A | B+ |
| Example 146 | 146 | | SA-2 (3 ppm by mass)<br>S element (0.56 ppm by mass)<br>Phosphate ion (3 ppm by mass) | - | A | A | - | A+ | A |
| Example 147 | 147 | | SA-2 (3 ppm by mass)<br>S element (11,613 ppm by mass)<br>Phosphate ion (3 ppm by mass) | - | A | A | - | A+ | A |
| Example 148 | 148 | | SA-2 (3 ppm by mass) | - | A | A | - | A+ | B+ |
| Example 149 | 149 | | S element (0.56 ppm by mass)<br>Phosphate ion (3 ppm by mass) | F element (0.50 ppm by mass) | A+ | A+ | - | A+ | A+ |
| Example 150 | 150 | | | F element (1 ppm by mass) | A+ | A+ | - | A+ | A+ |
| Example 151 | 151 | | | F element (3 ppm by mass) | A | A+ | - | A+ | A+ |
| Example 152 | 152 | | | F element (40 ppm by mass) | A | A+ | - | A+ | A |

[Table 4-12]

| | Composition | Composition of cured film | | Photosensitive property | | Cured film characteristics /electrical characteristics | | |
|---|---|---|---|---|---|---|---|---|
| | | Content of aromatic compound in cured film | Content in cured film | Sensitivity | Development residue | Light-shielding property OD value | Mechanical physical properties | Migration resistance |
| Comparative Example 1 | 153 | - | - | A | D | - | D | D |
| Comparative Example 2 | 154 | - | - | A | D | - | D | D |
| Comparative Example 3 | 155 | Ar-2 (7,500 ppm by mass) | - | A | C+ | - | C | D |
| Comparative Example 4 | 156 | - | SA-2 (1,500 ppm by mass)<br>*S* element (279 ppm by mass) | A | D | - | C | C |
| Comparative Example 5 | 157 | - | Phosphate ion (1,500 ppm by mass) | A | C+ | - | D | C |

Comparative Examples 1 and 2 do not contain the specific aromatic compound, the compound containing a specific anion, and the specific organic acid. Therefore, development residues, mechanical properties, and migration resistance are poor.

In Comparative Example 3, the content of the specific aromatic compound is more than 1,000 ppm by mass. In Comparative Example 4, the content of the specific organic acid is more than 1,000 ppm by mass. In Comparative Example 5, the content of the specific anion is more than 1,000 ppm by mass. In Comparative Example 3, Comparative Example 4, and Comparative Example 5, none of the condition (1x), the condition (2x), and the condition (3) is satisfied. Therefore, any of the characteristics of development residues, mechanical properties, and migration resistance is poor.

<Comparative Example 6>

In Comparative Example 3, a composition 155 was prepared in which the content of the specific aromatic compound in the composition was 1,500 ppm by mass. The obtained composition 155 was stored at 25°C for one week. After storage, as a result of forming a film of the composition on the substrate in the same manner as in Example 1, a large amount of foreign matters was generated, and the storage stability of the composition was poor.

<Comparative Example 7>

In Comparative Example 4, a composition 156 was prepared in which the content of the specific organic acid in the total solid content of the composition was 1,500 ppm by mass. The obtained composition 156 was stored at 25°C for one week. After storage, as a result of forming a film of the composition on the substrate in the same manner as in Example 1, a large amount of foreign matters was generated, and the storage stability of the composition was poor.

<Comparative Example 8>

In Comparative Example 5, a composition 157 was prepared in which the content of the specific anion in the total solid content of the composition was 1,500 ppm by mass. The obtained composition 157 was stored at 25°C for one week. After storage, as a result of forming a film of the composition on the substrate in the same manner as in Example 1, a large amount of foreign matters was generated, and the storage stability of the composition was poor.

<Example 153>

In Example 1, the composition 1 was prepared in which the content of the specific aromatic compound in the composition was 3 ppm by mass and the content of the specific organic acid in the total solid content of the composition was 3 ppm by mass. The obtained composition 1 was similarly stored at 25°C for one week. After storage, as a result of forming a film of the composition on the substrate in the same manner as in Example 1, foreign matters were not generated, and the storage stability of the composition was favorable.

<Example 154>

In Example 14, a composition 14 was prepared in which the content of the specific aromatic compound in the composition was 3 ppm by mass and the content of the specific anion in the total solid content of the composition was 3 ppm by mass. The obtained composition 14 was similarly stored at 25°C for one week. After storage, as a result of forming a film of the composition on the substrate in the same manner as in Example 1, foreign matters were not generated, and the storage stability of the composition was favorable.

<Preparation 2 of photosensitive composition>

A composition 158 was prepared so that the composition had a solid content concentration of 60% by mass, using GBL as a solvent, with the same solid content composition as that of the composition 1 described in Table 3-1. Similarly, a composition 159 was prepared so that the composition had a solid content concentration of 60% by mass, using GBL as a solvent, with the same solid content composition as that of a composition 22. The solution of the obtained composition was filtered through a 1.0 μmφ filter and used.

<Example 155>

A composition 158 was applied onto a PET film having a thickness of 50 μm using a comma roll coater, and then dried at 120°C for 8 minutes. Then, a PP film having a thickness of 30 μm was laminated as a protective film to obtain a

photosensitive composition film having the photosensitive composition coating of the composition 158, a PET film as a support, and a PP film as a protective film. The PP film as a protective film was peeled off from the obtained photosensitive composition film, and then the peeled surface was laminated on an alumina substrate of 5 cm × 5 cm using a vacuum diaphragm type laminator (MVLP-500/600; manufactured by MEIKI CO., LTD.) under the conditions of an upper and lower hot plate temperature of 80°C, a vacuuming time of 20 seconds, a vacuum press time of 30 seconds, and a bonding pressure of 0.5 MPa to form a photosensitive composition coating on the alumina substrate. Thereafter, the PET film as a support film was peeled off, a photomask having patterns with via sizes of 20 μmφ and 10 μmφ and patterns with line widths/space widths of 40 μm/20 μm and 20 μm/10 μm was set in an exposure apparatus, and patterning exposure was performed with an exposure energy of 200 mJ/cm$^2$, 300 mJ/cm$^2$, 400 mJ/cm$^2$, and 500 mJ/cm$^2$ (value of i-ray illuminance meter) using an ultra-high pressure mercury lamp equipped with an i-ray band pass filter under the condition of an exposure gap of 100 μm between the photomask and the photosensitive composition coating. After the exposure, development was performed by dip development using a 2.38% by mass TMAH aqueous solution or cyclopentanone, and rinsing was performed with isopropyl alcohol or water for 30 seconds to prepare a developed film in which the photosensitive composition coating was patterned. The development time was twice as long as the time when the unexposed portion was completely dissolved. The developed pattern was thermally cured in the same manner as in Example 1 to prepare a cured film of a photosensitive composition. Evaluation was performed in the same manner as in Example 1. In Example 155, the content of the fluorine element in the total solid content of the composition and the content of the fluorine element in the cured product were more than 1,000 ppm by mass. The sensitivity and development residue of the photosensitive composition film were evaluated by the method described later. Regarding the evaluation results using the photosensitive composition film having the photosensitive composition coating of the composition 158, the sensitivity was A, the development residue was A, the mechanical properties were A, and the migration resistance was B+.

The sensitivity of the photosensitive composition film was evaluated by the following method. A developed film obtained by patterning a photosensitive composition coating was prepared by the method described in Example 155. FPD/LSI inspection microscope (OPTIPHOT-300; manufactured by Nikon Corporation) was used to observe a resolution pattern of the developed film prepared. As an index of the sensitivity, an exposure energy (value of i-ray illuminance meter) at which a space pattern corresponding to an opening can be formed with a dimension width of 20 μm in a pattern of a line width/space width of 40 μm/20 μm was defined as sensitivity. It has been determined as follows that A+, A, B+, B, C+, and C with the sensitivity of 900 mJ/cm$^2$ or less are regarded as pass, A+, A, B+, and B with the sensitivity of 600 mJ/cm$^2$ or less are regarded as favorable, and A+ and A with the sensitivity of 400 mJ/cm$^2$ or less are regarded as excellent.

A+: The sensitivity is 300 mJ/cm$^2$ or less.
A: The sensitivity is more than 300 mJ/cm$^2$ and 400 mJ/cm$^2$ or less.
B+: The sensitivity is more than 400 mJ/cm$^2$ and 500 mJ/cm$^2$ or less.
B: The sensitivity is more than 500 mJ/cm$^2$ and 600 mJ/cm$^2$ or less.
C+: The sensitivity is more than 600 mJ/cm$^2$ and 750 mJ/cm$^2$ or less.
C: The sensitivity is more than 750 mJ/cm$^2$ and 900 mJ/cm$^2$ or less.
D: The sensitivity is more than 900 mJ/cm$^2$ and 1,500 mJ/cm$^2$ or less.
E: The sensitivity is more than 1,500 mJ/cm$^2$.

The development residue of the photosensitive composition film was evaluated by the following method. A developed film obtained by patterning a photosensitive composition coating was prepared by the method described in Example 155. FPD/LSI inspection microscope (OPTIPHOT-300; manufactured by Nikon Corporation) was used to observe a resolution pattern of the developed film prepared. As an index of the development residue, the presence or absence of a residue of a pattern corresponding to an opening was observed in a pattern of line widths/space widths of 40 μm/20 μm. It has been determined as follows that A+, A, B+, B, C+, and C where the residue existing area is 20% or less are regarded as pass, A+, A, B+, and B where the residue existing area is 10% or less are regarded as favorable, and A+ and A where the residue existing area is 3% or less are regarded as excellent.

A+: No residue exits.
A: The residue existing area is 3% or less.
B+: The residue existing area is more than 3% and 6% or less.
B: The residue existing area is more than 6% and 10% or less.
C+: The residue existing area is more than 10% and 15% or less.
C: The residue existing area is more than 15% and 20% or less.
D: The residue existing area is more than 20% and 50% or less.
E: The residue existing area is more than 50% and 100% or less.

<Example 156>

The same operation and evaluation as in Example 155 were performed using a composition 159. In Example 156, the content of the fluorine element in the total solid content of the composition and the content of the fluorine element in the cured product were more than 1,000 ppm by mass. Regarding the evaluation results using the photosensitive composition film having the photosensitive composition coating of the composition 159, the sensitivity was A, the development residue was A+, the mechanical properties were A+, and the migration resistance was A+.

DESCRIPTION OF REFERENCE SIGNS

1: Si wafer
2: Al pad
3: Passivation layer
4: Insulation layer
5: Metal layer
6: Metal wiring
7: Insulation layer
8: Barrier metal layer
9: Scribe line
10: Solder bump

## Claims

**1.** A photosensitive composition satisfying the following condition (α), and comprising a binder resin (A) and a photosensitizer (C) and further comprising a radical polymerizable compound (B) and/or a cross-linking agent (F), wherein
the binder resin (A) contains the following resin (A1) and/or resin (A2):

resin (A1): a resin that contains, in structural units in a resin main chain, one or more selected from the group consisting of an imide structure, an amide structure, an oxazole structure, and a siloxane structure;
resin (A2): a resin having a phenolic hydroxyl group in the structural units in the resin main chain; and
(α) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (1x) is satisfied:
(1x) a total content of the sulfonic acids, the phosphate esters, the phosphonic acids, the phosphonate esters, the phosphite esters, the phosphinic acids, the hypophosphite esters, and the carboxylic acids containing a fluorine element in the total solid content of the photosensitive composition is 0.010 to 1,000 ppm by mass.

**2.** The photosensitive composition according to claim 1, wherein

the sulfonic acids, and the phosphate esters, the phosphonic acids, the phosphonate esters, the phosphite esters, the phosphinic acids, and the hypophosphite esters (hereinafter, referred to as "organic acids containing a phosphorus element") have the following specific substituent a,
the carboxylic acids containing a fluorine element have the following specific substituent b, and
the condition (α) is the following condition (α2), and the following condition (α2) is satisfied:
(α2) one or more selected from the group consisting of the sulfonic acids having the following specific substituent a, the organic acids containing a phosphorus element having the following specific substituent a, and the carboxylic acids containing a fluorine element having the following specific substituent b is/are further contained, and the following condition (1y) is satisfied:

specific substituent a: one or more selected from the group consisting of a 1 to 2 valent aliphatic group having 1 to 18 carbon atoms, a 1 to 2 valent alicyclic group having 4 to 18 carbon atoms, a 1 to 2 valent aromatic group having 6 to 15 carbon atoms, a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms;

specific substituent b: one or more selected from the group consisting of a 1 to 2 valent fluorine-containing aliphatic group having 1 to 18 carbon atoms, a 1 to 2 valent fluorine-containing alicyclic group having 4 to 18 carbon atoms, and a 1 to 2 valent fluorine-containing aromatic group having 6 to 15 carbon atoms; and
(1y) a total content of the sulfonic acid having the specific substituent a, the organic acid containing a phosphorus element having the specific substituent a, and the carboxylic acid containing a fluorine element having the specific substituent b in the total solid content of the photosensitive composition is 0.010 to 1,000 ppm by mass.

**3.** The photosensitive composition according to claim 2, wherein

the condition ($\alpha$2) is the following condition ($\alpha$3) and the condition ($\alpha$3) is satisfied,
the sulfonic acid contains one or more selected from the group consisting of methanesulfonic acid, cyclohexanesulfonic acid, benzenesulfonic acid, toluenesulfonic acid, xylenesulfonic acid, trifluoromethanesulfonic acid, hexafluorocyclohexanesulfonic acid, hexafluorobenzenesulfonic acid, pentafluorotoluenesulfonic acid, tetrafluoroxylenesulfonic acid, trifluoromethylbenzenesulfonic acid, trifluoromethyltoluenesulfonic acid, and trifluoromethylxylenesulfonic acid, and
the carboxylic acid containing a fluorine element contains one or more selected from the group consisting of trifluoroacetic acid, trifluoropropionic acid, hexafluorocyclohexanecarboxylic acid, hexafluorobenzoic acid, and trifluoromethylbenzoic acid:
($\alpha$3) a sulfonic acid and/or a carboxylic acid containing a fluorine element is/are further contained, and the following condition (1z) is satisfied:
(1z) a total content of the sulfonic acid and the carboxylic acid containing a fluorine element in the total solid content of the photosensitive composition is 0.010 to 1,000 ppm by mass.

**4.** The photosensitive composition according to claim 1, further satisfying the following condition ($\beta$):
($\beta$) one or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (2x) is satisfied:
(2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the total solid content of the photosensitive composition is 0.010 to 1,000 ppm by mass.

**5.** The photosensitive composition according to claim 1, further satisfying the following condition ($\gamma$):
($\gamma$) one or more selected from the group consisting of benzene, toluene, xylene, and naphthalene is/are contained, and the following condition (3) is satisfied:
(3) a total content of the benzene, the toluene, the xylene, and the naphthalene in the photosensitive composition is 0.010 to 1,000 ppm by mass.

**6.** The photosensitive composition according to any one of claims 1 to 5, wherein

the binder resin (A) contains the resin (A1), and
the resin (A1) contains one or more selected from the group consisting of the following resin (A1-1), resin (A1-2), resin (A1-3), resin (A1-4), resin (A1-5), and resin (A1-6), and a copolymer consisting of two or more of the following resin (A1-1), resin (A1-2), resin (A1-3), resin (A1-4), resin (A1-5), and resin (A1-6):

resin (Al-1): polyimide;
resin (A1-2): polyimide precursor;
resin (A1-3): polybenzoxazole;
resin (A1-4): polybenzoxazole precursor;
resin (A1-5): polyamideimide; and
resin (A1-6): polyamideimide precursor.

**7.** The photosensitive composition according to claim 6, further comprising one or more selected from the group consisting of a cyclic amide compound represented by General Formula (20), an amide compound represented by General Formula (21), a cyclic urea compound represented by General Formula (22), a urea compound represented by General Formula (23), an oxazolidone compound represented by General Formula (24), and an isoxazolidone compound represented by General Formula (25), and satisfying the following condition (4):

(4) a total content of the cyclic amide compound represented by General Formula (20), the amide compound represented by General Formula (21), the cyclic urea compound represented by General Formula (22), the urea compound represented by General Formula (23), the oxazolidone compound represented by General Formula (24), and the isoxazolidone compound represented by General Formula (25) in the total solid content of the photosensitive composition is 0.010 to 5.0% by mass,

[Chemical Formula 1]

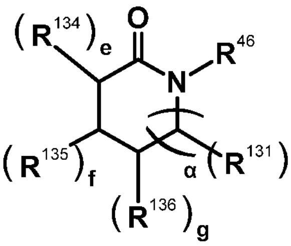
(20)
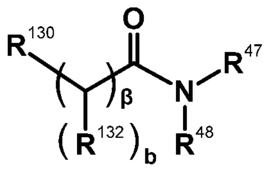
(21)
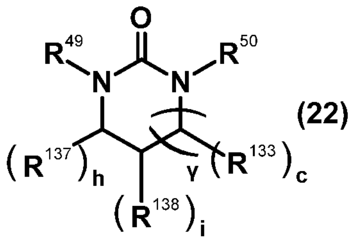
(22)

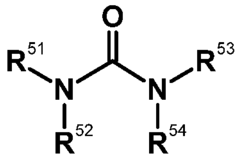
(23)
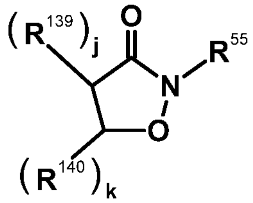
(24)
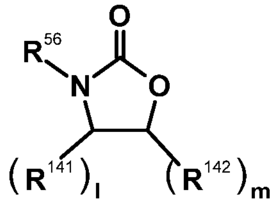
(25)

in General Formulae (20) to (25), $R^{46}$ to $R^{56}$ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms, $R^{130}$ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms, $R^{131}$ to $R^{142}$ each independently represent an alkyl group having 1 to 6 carbon atoms, $\alpha$, $\beta$, and $\gamma$ each independently represent an integer of 0 to 6, a, b, c, e, f, g, h, i, j, k, 1, and m each independently represent an integer of 0 to 2, in a case where $\alpha$ is 0, a is 0, in a case where $\beta$ is 0, b is 0, and, in a case where $\gamma$ is 0, c is 0.

**8.** The photosensitive composition according to claim 7, further comprising: one or more selected from the group consisting of a component containing a sodium element, a component containing a potassium element, a component containing a magnesium element, a component containing a calcium element, a component containing an iron element, a component containing a copper element, and a component containing a chromium element, and satisfying the following condition (5):
(5) a total content of the sodium element, the potassium element, the magnesium element, the calcium element, the iron element, the copper element, and the chromium element in the total solid content of the photosensitive composition is 0.010 to 500 ppm by mass.

**9.** The photosensitive composition according to claim 1, wherein the photosensitizer (C) contains a photo-polymerization initiator (C1), and the photo-polymerization initiator (C1) contains an oxime ester-based compound (C1-1) and/or a phosphine oxide-based compound (C1-2).

**10.** The photosensitive composition according to claim 9, further comprising one or more selected from the group consisting of acetic acid, propionic acid, cyclopentanecarboxylic acid, cyclohexanecarboxylic acid, benzoic acid, methylbenzoic acid, and trimethylbenzoic acid and satisfying the following condition (6), and/or
further comprising an aldoxime compound and/or a ketoxime compound and satisfying the following condition (7):

(6) a total content of the acetic acid, the propionic acid, the cyclopentanecarboxylic acid, the cyclohexanecarboxylic acid, the benzoic acid, the methylbenzoic acid, and the trimethylbenzoic acid in the total solid content of the photosensitive composition is 0.010 to 500 ppm by mass; and
(7) a total content of the aldoxime compound and the ketoxime compound in the total solid content of the photosensitive composition is 0.010 to 500 ppm by mass.

**11.** The photosensitive composition according to claim 10, further comprising one or more selected from the group consisting of a component containing a chlorine element, a component containing a bromine element, and a component containing a sulfur element and satisfying the following condition (8) and/or condition (9), and/or further comprising water and satisfying the following condition (10):

(8) a total content of the chlorine element and the bromine element in the total solid content of the photosensitive composition is 0.010 to 500 ppm by mass;
(9) a content of the sulfur element in the total solid content of the photosensitive composition is 0.010 to 500 ppm by mass; and
(10) a content of the water in the photosensitive composition is 0.010 to 3.0% by mass.

**12.** The photosensitive composition according to any one of claims 1 to 5 and 9 to 11, further satisfying the following condition (1$\alpha$):
(1$\alpha$) a content of the fluorine element in the total solid content of the photosensitive composition is 1,000 ppm by mass or less.

**13.** The photosensitive composition according to any one of claims 1 to 5 and 9 to 11, further satisfying at least one of the following conditions ($\delta$), ($\varepsilon$), and ($\zeta$):

($\delta$) the radical polymerizable compound (B) contains the following first polymerizable compound (B1) and second polymerizable compound (B2);
($\varepsilon$) the radical polymerizable compound (B) contains the following third polymerizable compound (B3) and fourth polymerizable compound (B4);
($\zeta$) the radical polymerizable compound (B) contains the following first polymerizable compound (B1) or second polymerizable compound (B2), and further contains the following third polymerizable compound (B3) or fourth polymerizable compound (B4):
first polymerizable compound (B1): a compound having the following structure (I-b1) and further having at least two radical polymerizable groups:

structure (I-b1): a structure including an alicyclic structure and/or a structure including a heteroalicyclic structure;
second polymerizable compound (B2): a compound having the following structure (I-b2) and structure (II-b2) and further having at least two radical polymerizable groups:

structure (I-b2): a structure including an aromatic structure;
structure (II-b2): a structure including an aliphatic structure;
third polymerizable compound (B3): a compound having at least two (meth)acryloyl groups and further having the following structure (I-b3):

structure (I-b3): a structure that has at least two (meth)acryloyl groups linked with a minimum number of atoms of 4 to 10 and includes an aliphatic structure; and
fourth polymerizable compound (B4): a compound having at least two (meth)acryloyl groups and further having the following structure (I-b4):
structure (I-b4): a structure that has at least two (meth)acryloyl groups linked with a minimum number of atoms of 11 to 45 and includes an aliphatic structure.

**14.** The photosensitive composition according to any one of claims 1 to 5 and 9 to 11, further comprising inorganic particles (G),
the inorganic particles (G) containing one or more selected from the group consisting of silica particles, alumina particles, titania particles, vanadium oxide particles, chromium oxide particles, ferric oxide particles, cobalt oxide particles, copper oxide particles, zinc oxide particles, zirconium oxide particles, niobium oxide particles, tin oxide particles, and cerium oxide particles.

**15.** A photosensitive composition satisfying one or more selected from the group consisting of the following conditions ($\alpha$), ($\beta$), and ($\gamma$), and comprising a binder resin (A) and a photosensitizer (C) and further comprising a radical polymerizable compound (B) and/or a cross-linking agent (F), wherein
the binder resin (A) contains the following resin (A1) and/or resin (A2):

resin (A1): a resin that contains, in structural units in a resin main chain, one or more selected from the group consisting of an imide structure, an amide structure, an oxazole structure, and a siloxane structure;
resin (A2): a resin having a phenolic hydroxyl group in the structural units in the resin main chain; and
($\alpha$) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (1x) is satisfied:

(1x) a total content of the sulfonic acids, the phosphate esters, the phosphonic acids, the phosphonate esters, the phosphite esters, the phosphinic acids, the hypophosphite esters, and the carboxylic acids containing a fluorine element in the total solid content of the photosensitive composition is 0.010 to 1,000 ppm by mass;
($\beta$) one or more selected from the group consisting of a chloride ion, a bromide ion, a sulfate ion, a sulfite ion, a nitrate ion, a nitrite ion, a phosphate ion, a phosphite ion, a hypophosphite ion, a formate ion, and a fluoride ion is/are contained, and the following condition (2x) is satisfied:

(2x) a total content of the chloride ion, the bromide ion, the sulfate ion, the sulfite ion, the nitrate ion, the nitrite ion, the phosphate ion, the phosphite ion, the hypophosphite ion, the formate ion, and the fluoride ion in the total solid content of the photosensitive composition is 0.010 to 1,000 ppm by mass; and
($\gamma$) one or more selected from the group consisting of benzene, toluene, xylene, and naphthalene is/are contained, and the following condition (3) is satisfied:
(3) a total content of the benzene, the toluene, the xylene, and the naphthalene in the photosensitive composition is 0.010 to 1,000 ppm by mass.

**16.** A photosensitive composition film comprising a photosensitive composition coating and a support on which the photosensitive composition according to any one of claims 1 to 5, 9 to 11, and 15 is formed.

**17.** A cured product obtained by curing the photosensitive composition according to any one of claims 1 to 5, 9 to 11, and 15.

**18.** An electronic component comprising the cured product according to claim 17.

**19.** A method for producing a cured product, comprising:

(1) a step of forming a coating film of the photosensitive composition according to any one of claims 1 to 5, 9 to 11, and 15 on a substrate;
(2) a step of irradiating the coating film of the photosensitive composition with a chemical active ray via a photomask;
(3) a step of performing development with a developer so that a pattern of the photosensitive composition is formed; and
(4) a step of heating the pattern so that a cured pattern of the photosensitive composition is obtained.

**20.** An electronic component comprising a cured product, wherein

the cured product contains the following resin (XA1) and/or resin (XA2) and
satisfies the following condition (X$\alpha$):

resin (XA1): a resin that contains, in structural units in a resin main chain, one or more selected from the group consisting of an imide structure, an amide structure, an oxazole structure, and a siloxane structure;
resin (XA2): a resin having a phenolic hydroxyl group in the structural units in the resin main chain; and
(X$\alpha$) one or more selected from the group consisting of sulfonic acids, phosphate esters, phosphonic acids, phosphonate esters, phosphite esters, phosphinic acids, hypophosphite esters, and carboxylic acids containing a fluorine element is/are further contained, and the following condition (X1x) is satisfied:
(X1x) a total content of the sulfonic acids, the phosphate esters, the phosphonic acids, the phosphonate esters, the phosphite esters, the phosphinic acids, the hypophosphite esters, and the carboxylic acids containing a fluorine element in the cured product is 0.010 to 1,000 ppm by mass.

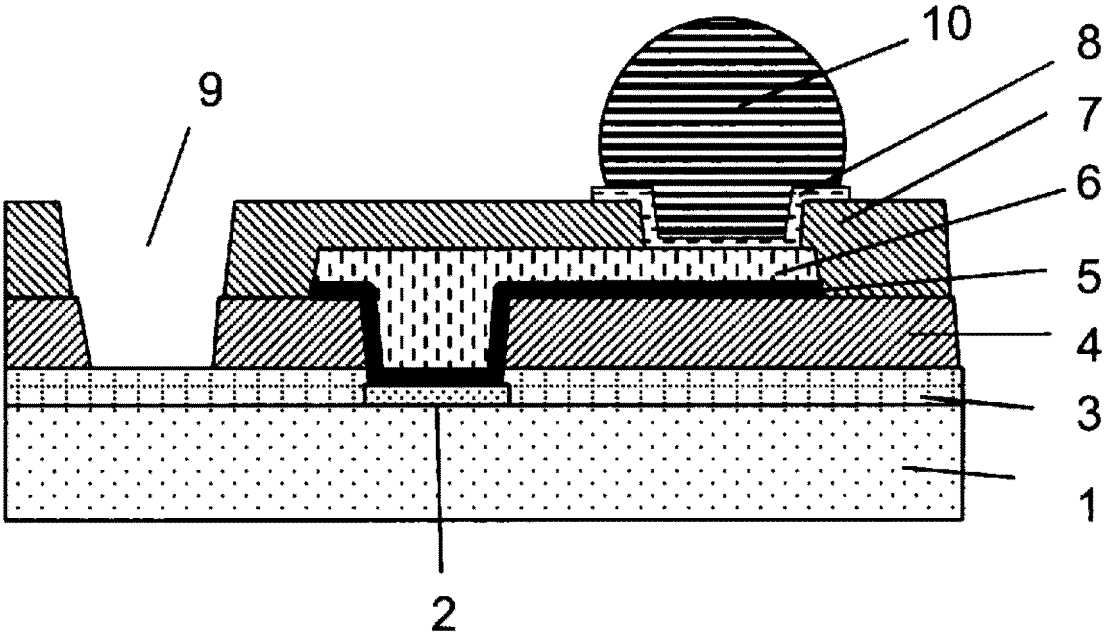


Figure 1

**INTERNATIONAL SEARCH REPORT**

International application No. **PCT/JP2023/033519**

**A. CLASSIFICATION OF SUBJECT MATTER**

***G03F 7/004***(2006.01)i; ***G03F 7/023***(2006.01)i; ***G03F 7/027***(2006.01)i; ***G03F 7/037***(2006.01)i; ***G03F 7/20***(2006.01)i; ***H01L 21/312***(2006.01)i

FI: G03F7/004 501; G03F7/027 514; G03F7/037 501; G03F7/027 511; G03F7/023; G03F7/027 502; G03F7/037; G03F7/20 501; G03F7/20 521; H01L21/312 D

According to International Patent Classification (IPC) or to both national classification and IPC

**B. FIELDS SEARCHED**

Minimum documentation searched (classification system followed by classification symbols)

G03F7/004; G03F7/023; G03F7/027; G03F7/037; G03F7/20; H01L21/312

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2018-036329 A (TORAY IND., INC.) 08 March 2018 (2018-03-08) paragraphs [0086], [0087], [0097], [0099], examples 1-26 | 1-20 |
| X | JP 2022-115907 A (NIPPON KAYAKU KK) 09 August 2022 (2022-08-09) paragraph [0079], examples 1-5 | 1-6, 9-13, 15-20 |
| A | | 7-8, 14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 November 2023** | **21 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/033519**

| Patent document cited in search report | Publication date (day/month/year) | Patent family member(s) | Publication date (day/month/year) |
|---|---|---|---|
| JP 2018-036329 A | 08 March 2018 | (Family: none) | |
| JP 2022-115907 A | 09 August 2022 | US 2022/0179310 A1<br>paragraph [0060], examples 1-5<br>KR 10-2021-0134696 A<br>CN 113677741 A<br>TW 202104374 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012208360 A
- JP 2007016214 A
- WO 2019087985 A
- WO 2016056451 A
- WO 2012141165 A
- WO 2018038083 A
- JP 2020070352 A